(19) Europäisches Patentamt
European Patent Office
Office européen des brevets

(11) EP 2 735 903 B1

(12) **EUROPEAN PATENT SPECIFICATION**

(45) Date of publication and mention of the grant of the patent:
**27.02.2019 Bulletin 2019/09**

(21) Application number: **12193855.9**

(22) Date of filing: **22.11.2012**

(51) Int Cl.:
***G03F 7/035*** (2006.01) ***G03F 7/038*** (2006.01)
***C08G 83/00*** (2006.01) ***C08F 291/00*** (2006.01)
***C09D 201/00*** (2006.01) ***C08L 101/00*** (2006.01)

(54) **Negative working lithographic printing plate precursors comprising a hyperbranched binder material**

Negativ arbeitende Lithografiedruckplattenvorläufer mit hochverzweigtem Bindemittelmaterial

Précurseurs de plaque d'impression lithographique au travail négative comprenant une matière liante hyper-ramifié

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.05.2014 Bulletin 2014/22**

(73) Proprietor: **Eastman Kodak Company**
**Rochester, NY 14650-2201 (US)**

(72) Inventors:
- **Werner, Saija**
  **37197 Hattorf (DE)**
- **Baumann, Harald**
  **37250 Osterode (DE)**
- **Pietsch, Detlef**
  **37534 Badenhausen (DE)**
- **Draber, Axel**
  **37250 Osterode (DE)**

(74) Representative: **Vossius & Partner**
**Patentanwälte Rechtsanwälte mbB**
**Siebertstrasse 3**
**81675 München (DE)**

(56) References cited:
**EP-A2- 1 969 426**
**JP-A- 2004 094 048**
**JP-A- 2005 134 893**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 735 903 B1

## Description

The present invention relates to negative working lithographic printing plate precursors comprising a negative working coating comprising a highly branched binder; the invention also relates to a method for imaging such precursors, a method for preparing said highly branched binder and imaged elements obtained from said elements.

Lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. When the printing ink is first transferred to an intermediate material, referred to as blanket, which then in turn transfers the printing ink onto the surface of the material on which the image is to be formed this is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic.

The plates can be imagewise exposed through a film with clear and opaque areas or digitally without a film e.g. by lasers.

Sometimes water-soluble polymers are used as temporary coatings (also called "overcoat") on lithographic printing plate precursors having an oxygen-sensitive coating like a photopolymerizable coating. The water-soluble polymers have the function of protecting the coating from atmospheric oxygen during storage, exposure and in particular during the time between exposure and further processing (development). During that time period the temporary coating has to exhibit a sufficient adhesion to the light-sensitive substrate so that safe handling (manufacture, packing, transport, exposure etc.) is guaranteed without tearing of the layers. Prior to the development the overcoat can be removed, preferably by washing with water or the overcoat is dissolved within the developer together with the non-image parts.

Usually, a substrate, in particular an aluminum substrate with aluminum oxide layer, is provided with a hydrophilic protective layer (also referred to as "interlayer") before the radiation-sensitive coating is applied. This hydrophilic layer improves the water acceptance of the (non-printing) background areas of a lithographic printing plate and improves the repulsion of the printing ink in these areas. A suitable hydrophilic protective layer also ensures that during developing the soluble portions of the radiation-sensitive layer are removed easily and residue-free from the substrate so that clean background areas are obtained during printing. Without such a residue-free removal, what is referred to as toning would occur during printing, i.e. the background areas would accept printing ink.

WO 00/77070 A2 describes hyperbranched polyester polyols modified with (meth)acrylic acid; the hyperbranched polyester polyols show a certain viscosity and are said to be useful as binders for radiation-curable inks. With respect to printing plate precursors, viscous products are not usable as binder material, because of too high stickiness resulting in face roller contamination of manufacturing machines. Furthermore, plates having the hyperbranched polyester in the top layer are not suited for storage in stacks because of unacceptable high adhesion to interleaf paper used to separate and protect the plates during storage and transportation.

A process for the preparation of dendritic polyester acrylate oligomers is described in WO 00/64975 A1. The obtained dendritic oligomers are viscous or low viscous (i.e. liquid) polyesters, and thus are not suitable as binder material in printing plate precursors.

Dendritic polyesters are also disclosed in US 5,418,301. The disclosed polyesters have low reactivity resulting in low photospeed and because of the low viscosity they are not suitable as binder for lithographic plates.

EP 2 441 783 A1 relates to a polymerizable composition comprising a polymerizable compound, a polymerization initiator and a high molecular weight polymer with polymer chains branched from an isocyanuric acid skeleton as a branch point. The polymers exemplified in this document have molecular weights well above 30000 and contain a high amount of spacer units.

The claimed polymers do not have sufficient solubility in both coating solvent and developer and too low photospeed because of low content of reactive groups.

EP 1 522 557 A1 discloses polymerizable compositions comprising a dendrimer having at least two polymerizable groups within a molecule, an initiator and an alkali-soluble polymer as binder material. The dendrimers are viscous liquids that are not suitable as binder for lithographic plates as explained above. Furthermore, it was found that shelflife and printing durability are not sufficient.

US 4,228,232 discloses photopolymerizable compositions comprising as an essential component an organic film forming polymer with a molecular weight which is most preferably at least 15000. In addition the composition comprises an ethylenically unsaturated monomer as well as an ethylenically unsaturated oligomer. The surface tackiness

of the photopolymerizable layer is too high and solubility in developer as well as printing durability are not sufficient.

US 6,187,897 B1 describes liquid vinyl-group containing dendrimers and curable compositions like inks and coatings containing them. The dendrimers are viscous liquids that are not suitable for lithographic plates as explained above. Furthermore, the synthesis of dendrimers requires very complex synthetic procedures.

US 7,153,632 B1 discloses radiation-sensitive compositions comprising a radically polymerizable component derived from the reaction of a multifunctional isocyanate compound with one or more urea urethane or urethane (meth)acrylates comprising carboxy groups. Without additional binder polymer the photopolymer layer is too tacky and with additional binder the printing durability is not sufficient.

JP 2001 117229 A discloses negative working planographic printing plate precursors wherein the photosensitive layer contains a branched alkali-soluble urethane binder with at least one ethylenically unsaturated polymerizable endgroup. All the binders exemplified in said application have high molecular weights of 80000 and more; the binders also contain a high amount of spacer units. The high molar weights and the low number of end groups of the binders described therein result in low solubility in the developer as well as low printing durability.

JP 2005 134893 A discloses a polymerizable composition comprising a dendrimer having a polymerizable group. It is the object of the present invention to provide negative working lithographic printing plate precursors which contain binders which can be produced in a simple way at low costs; furthermore, the precursors should show high photo speed, good shelf life and high print run length. It is also desired that the plates have a good start-up performance if developed on press or a high developer capacity for off-press development (in this case developability by a gum-developer in a one-step processing would be further advantageous).

This object is surprisingly achieved by a negative working lithographic printing plate precursor comprising:

(a) a substrate,

(b) negative working radiation sensitive coating comprising:

(i) 10 to 90 wt% based on the dry coating weight of a branched binder material;

(ii) at least one radical forming component selected from photoinitiators and sensitizer/coinitiator systems which absorbs wavelength in the range of 300 to 1200 nm and is capable of initiating a radical polymerization ; and

(iii) at least one compound having at least two free radically polymerizable groups per molecule and a $Tg < 30°C$;

(c) and optionally an overcoat acting as oxygen barrier;

characterized in that the branched binder material comprises radically polymerizable groups, has a number average molecular weight in the range of 500 to 15000, and a $Tg > 30°C$,

and consists of structural moieties connected to each other by urethane and/or urea linkages, said structural moieties being derived from $n_{EG}$ moles of end group precursors represented by formula (I), $n_{BU}$ moles of branching unit precursors represented by formula (II), and optionally $n_{SU}$ moles of spacer unit precursors represented by formula (III)

$$L^1X^1 \qquad (I)$$

$$L^2(X^2)_n \qquad (II)$$

$$L^3(X^3)_2 \qquad (III)$$

wherein each of $X^1$, $X^2$ and $X^3$ is independently an isocyanate group, or the same or different isocyanate reactive group selected from the group consisting of -OH and -NHR, with R being H, $C_{1-20}$alkyl or $C_{5-20}$aryl, each of $L^1$, $L^2$ and $L^3$ is independently an optionally substituted aliphatic, aromatic, heterocyclic or heteroaromatic moiety (preferably with a maximum number of carbon atoms of 250) with a valence of 1, n and 2, respectively, wherein n is an integer equal to or larger than 3; and wherein $L^1$, $L^2$ and $L^3$ do not contain urethane and urea linkages; and wherein the molar quantities $n_{EG}$, $n_{BU}$, and $n_{SU}$ are satisfying the following conditions,

$n_{EG} > n_{BU} > 0$ and $0 \leq n_{SU} < (n_{EG}+n_{Bu})$

*DEFINITIONS*

Unless the context indicates otherwise, the various components described herein such as "polymeric binder", "initiator", "free radically polymerizable component", "radiation absorbing compound", and similar terms also refer to mixtures of such components. Thus, the use of the articles "a", "an", and "the" is not necessarily meant to refer to only a single component.

Moreover, unless otherwise indicated, percentages refer to percents by total dry weight, for example, weight

% based on total solids of either an imageable layer or radiation-sensitive composition. Unless otherwise indicated, the percentages can be the same for either the dry imageable layer or the total solids of radiation-sensitive composition.

The term "polymer" refers to high and low molecular weight polymers including oligomers, homopolymers, and copolymers, which are defined for this invention to have a molecular weight of at least 500.

The term "copolymer" refers to polymers that are derived from two or more different monomers.

The following definitions of the general terms used in the present description apply irrespective of whether the terms in question appear alone or in combination.

As used herein, the term "alkyl", alone or in combination with other groups, denotes a saturated, i.e. aliphatic, hydrocarbon group including a straight or branched carbon chain. The alkyl group can optionally comprise one or more substituents (preferably 0 or 1 substituent) selected for example from halogen atoms (fluorine, chlorine, bromine, iodine), CN, $NO_2$, $NR^a$, $COOR^a$, $SR^a$, $OR^a$ ($R^a$ independently represents a hydrogen atom or an alkyl group), $Si(R^Z)_3$ (wherein each $R^Z$ is $C_{1-10}$ alkyl or $C_{1-10}$ alkoxy). The above definition also applies to the alkyl unit of an aralkyl group and an alkoxy group.

The term "alkoxy", alone or in combination with other groups, denotes a group -O-R' wherein R' is alkyl as defined above.

The term "aromatic" means the presence of an electron sextet in a ring, according to Hückel's rule.

The term "aliphatic" refers to acyclic and cyclic groups which are saturated or unsaturated, but not aromatic.

Unless defined otherwise, the term "aryl group" or "aromatic group" as used in the present invention refers to an aromatic carbocyclic group with one or more fused rings, which preferably comprises 6 to 14 carbon atoms. The aryl group can optionally comprise one or more substituents (preferably 0 to 3) selected for example from halogen atoms, alkyl groups, CN, $NO_2$, $NR^a$, $COOR^a$, $SO_3H$, $OR^a$, $SR^a$ (wherein each $R^a$ is independently selected from hydrogen and alkyl), $Si(R^Z)_3$ (wherein each $R^Z$ is $C_{1-10}$ alkyl or $C_{1-10}$ alkoxy). The above definition also applies to the aryl unit of an aralkyl group. Examples include phenyl, tolyl, xylyl, 2- or 4-alkylphenyl, such as 2-methylphenyl, 4-ethylphenyl and 4-t-butylphenyl, 2-or 4-alkoxyphenyl, such as 2-methoxyphenyl, 4-methoxyphenyl, 4-dialkylaminophenyl, naphthyl and 4-alkylnaphthyl. Preferred examples are a phenyl group and a naphthyl group which can optionally be substituted. The above definition also applies to arylene groups (i. e. divalent aromatic groups); examples thereof are 1,4-phenylene, 3-methyl-1,4-phenylene, 2-methoxy-1, 4-phenylene, 1,3-phenylene, 4- cyano-1,3-phenylene, 1,4-naphthylene, 1,5-naphthylene, 4-dimethylamino-1,5-naphthylene and 9,10-phenanthrenylene (especially preferred are 1,4-phenylene and 1, 3-phenylene), and polyvalent aromatic groups.

Unless defined otherwise, the term "heterocyclic group" as used in the present invention refers to a saturated or unsaturated (non-aromatic) cyclic group, wherein one or more C atoms in the ring are replaced with heteroatoms selected from O, S, Se, Te and N, preferably O, S and N; preferably, one or two C atoms are replaced. Preferably, the heterocyclic group is a 5-or 6-membered ring. The heterocyclic group can optionally comprise one or more substituents (bonded to a C atom and/or to an N atom). Preferably, the heterocyclic group is unsubstituted or comprises one substituent. The optional substituents are preferably selected from halogen atoms, alkyl groups, CN, $NO_2$, $NR^a$, $SR^a$ and $OR^a$, wherein each $R^a$ is independently selected from hydrogen and alkyl. Examples of heterocyclic groups include piperidyl, piperazinyl, tetrahydroquinolinyl, pyrrolidyl, tetrahydrofurfuryl, tetrahydro- pyranyl, morpholinyl and tetrahydrothiophenyl.

Unless defined otherwise, the term "heteroaromatic group" as used in the present invention refers to an aryl group as defined above wherein one or more ring carbon atoms are replaced with heteroatoms selected from O, S, Se, Te and N, preferably O, S and N; preferably, one, two or three carbon atoms are replaced. The heteroaromatic group can optionally comprise one or more substituents which are preferably selected from halogen atoms, alkyl groups, CN, $NR^a$, $COOR^a$, $SR^a$ and $OR^a$, wherein each $R^a$ is independently selected from hydrogen and alkyl. The substituents can be bonded to C atoms and/or N atoms. Examples of heteroaromatic groups include imidazolyl, 1,2,4-triazolyl, pyrazolyl, 1,3-thiazolyl, pyridyl, quinolinyl, pyrimidyl, 1,3,4-thiadiazolyl, 1,3,4-oxadiazolyl, 1,3,5-triazinyl, benzimidazolyl, acridinyl, furanyl and thienyl.

The term "cyclic group" or "carbocyclic group" refers to cyclic saturated or unsaturated (non-aromatic) hydrocarbon groups, optionally substituted by one or more substituents as defined above for "alkyl". It encompasses monocyclic and polycyclic groups.

When indicating the number of substituents, the term "one or more" means from one substituent to the highest possible number of substitution, i.e. replacement of one hydrogen up to replacement of all hydrogens by substituents. Thereby, one, two or three substituents are preferred. Even more preferred are one or two substituents or one substituent.

As regards the classification of dendritic polymers reference is made to "Synthesis of hyperbranched polymers with controlled degree of branching" of T. Higashihara et al. in Polymer Journal (2012) 44, 14-19. The following structures are shown in Fig. 1 of this reference and schematically show the structural differences between dendrons, dendrimers and hyperbranched polymers:

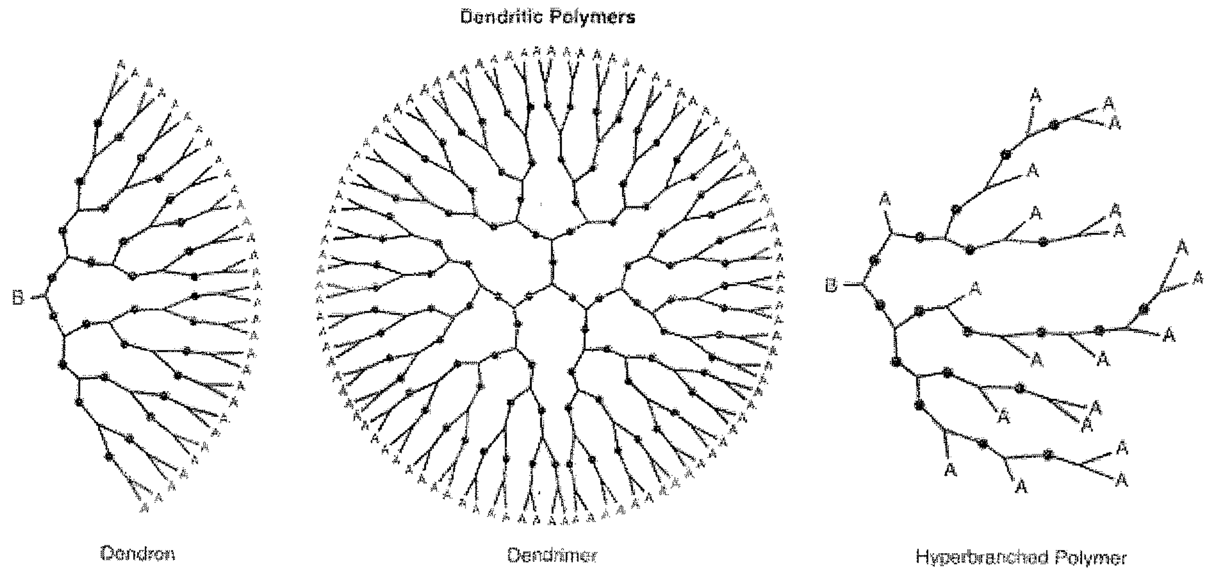


Dendrimers have a perfectly symmetric structure and thus are monodisperse; perfectly branched and monodisperse dendrons are attached to a core moiety. Contrary thereto hyperbranched polymers (HBPs) have irregularly branched and polydisperse structures.

Within this invention the expression (meth)acrylic acid includes acrylic acid and methacrylic acid; the same applies to (meth)acrylate and similar expressions.

Any embodiment or preferred embodiment described below can be combined with one or more other embodiments or preferred embodiments described below unless otherwise mentioned.

*PRECURSORS*

The negative working precursors of the present invention can be sensitive to UV/VIS radiation or IR radiation. In general, the negative working lithographic printing plate precursors comprise: (i) a substrate, (ii) a negative-working radiation-sensitive coating and (iii) optionally an oxygen barrier layer as overcoat and preferably consist of (i), (ii) and (iii) which are described in detail below.

*Substrates*

The substrate used for the precursors of the present invention is preferably a dimensionally stable plate or foil-shaped material like one that has already been used as a substrate for printing matter. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred for the present invention since it shows a remarkable degree of dimensional stability, is inexpensive and furthermore exhibits excellent adhesion to the radiation-sensitive coating. Furthermore, a composite film can be used wherein an aluminum foil has been laminated onto a plastic film, such as e.g. a polyethylene terephthalate film, or paper, or a plastic film onto which aluminum has been applied by means of vapor deposition. Preferred substrates are metal substrates, wherein the term "metal substrate" as used herein also encompasses composite films with the upper-most layer being a metal layer or foil.

A metal substrate, in particular an aluminum substrate, is preferably subjected to a surface treatment, for example graining by brushing in a dry state or brushing with abrasive suspensions, or electrochemical graining, e.g. by means of a hydrochloric acid electrolyte or $HNO_3$, and optionally anodizing, e.g. in sulfuric acid or phosphoric acid. According to a preferred embodiment the metal substrate comprises an $Al_2O_3$-, ZnO-, $SiO_2$- or $TiO_2$-layer. The roughness of the substrate surface on the image layer side expressed by Ra-value is preferably 0.1 to 1 $\mu$m, more preferably 0.2 to 0.8 $\mu$m.

An aluminum foil which preferably has a thickness of 0.1 to 0.7 mm, more preferred 0.15 to 0.5 mm, is an especially preferred substrate for the precursors of the present invention. It is preferred that the foil be grained (preferably

electrochemically, for instance in hydrochloric acid or nitric acid) and then show an average roughness of 0.2 to 1 μm, especially preferred 0.3 to 0.8 μm.

According to an especially preferred embodiment, the grained aluminum foil was furthermore anodized (for instance in sulfuric acid). The layer weight of the resulting aluminum oxide is preferably 1.5 to 5 g/m$^2$, especially preferred 2 to 4 g/m$^2$.

A metal substrate can additionally be subjected to a posttreatment (so called "sealing") with an aqueous solution of e.g. alkali metal silicate, calcium zirconium fluoride, hexafluorosilicic acid, phosphate/fluoride, polyvinylphosphonic acid, vinylphosphonic acid copolymers, or phosphonic acid thereby providing a hydrophilizing layer (also referred to as "interlayer") on its surface.

The details of the above-mentioned substrate treatments are well known to the person skilled in the art.

Any feature, preferred feature and more preferred feature of the substrate as described above can be combined with any feature, preferred feature or more/most preferred feature described below for the radiation-sensitive coating and/or oxygen barrier layer.

*Negative working radiation-sensitive coating*

The negative working coating applied onto the substrate comprises (a) at least one radical forming component selected from photoinitiators and sensitizer/coinitiator systems which absorbs radiation of a wavelength in the range of 250 to 1,200 nm and is capable of initiating a free-radical polymerization and, at least one branched binder , and (c) at least one compound having at least two free radically polymerizable groups per molecule and a Tg < 30°C.
Any aspect, preferred or more/most preferred aspect described below with respect to the radical forming component can be combined with any aspect, preferred or more/most preferred aspect described below for the branched binder material.

Except for the unique features of the present invention, details of negative-working lithographic printing plate precursors useful in the present invention are described for example, in EP Patent Publications 924,570A1 (Fujimaki et al.), 1,063,103A1 (Uesugi), and EP 1,449,650A1 (Goto), and U.S. Patents 4,511,645 (Koike et al.), 6,027,857 (Li et al.), 6,309,792 (Hauck et al.), 6,569,603 (Furukawa et al.), 6,899,994 (Huang et al.), 7,045,271 (Tao et al.), 7,261,998 (Hayashi et al.), 7,279,255 (Tao et al.), 7,285,372 (Baumann et al.), 7,291,438 (Sakurai et al.), 7,326,521 (Tao et al.), 7,332,253 (Tao et al.), 7,442,486 (Baumann et al.), 7,452,638 (Yu et al.), 7,524,614 (Tao et al.), 7,560,221 (Timpe et al.), 7,574,959 (Baumann et al.), and 7,615,323 (Strehmel et al.), and U.S. Patent Application Publications 2003/0064318 (Huang et al.), 2004/0265736 (Aoshima et al.), and 2005/0266349 (Van Damme et al.). Other useful negative-working compositions and elements are described for example in U.S. Patents 6,232,038 (Takasaki) and 6,514,657 (Sakurai et al.) and U.S. Patent Publication 2009/0092923 (Hayashi).

The negative working coating of the precursors according to the present invention is subjected to free radical polymerization upon exposure and preferably does not contain more than 40% wt% based on the dry weight of the coating of a binder different from the branched binder of this invention and having a number average molecular weight of more than 15000.

*Radical forming component*

The radiation-sensitive coating comprises at least one radical forming component selected from photoinitiators and sensitizer/coinitiator systems.

The radical forming component is selected such that it is capable of significant absorption in the range in which the radiation source to be used later on during imaging emits; preferably, the radical forming component shows an absorption maximum in that range. Thus, if the radiation-sensitive element is e.g. going to be imaged by means of an IR laser, the radical forming component should essentially absorb radiation in the range of above 750 to 1,200 nm (preferably 800 to 1100 nm) and preferably shows an absorption maximum in that range. On the other hand, if imaging is to be carried out by means of UV/VIS radiation, the radical forming component should essentially absorb radiation in the range of about 250 to 750 nm (preferably 300 to 550 nm) and preferably shows an absorption maximum in that range.

In the present invention, a photoinitiator is a compound capable of absorbing radiation when exposed thereto and of forming free radicals by itself, i.e. without the addition of coinitiators. Coinitiators are compounds that form radicals capable of initiating radical polymerization in combination with sensitizers that absorb the imaging light. The interacting mechanism is not clearly understood for all sensitizer/coinitiator combinations. The mechanisms may for instance be an energy transfer from the sensitizer to the coinitiator or an electron transfer mechanism wherein the sensitizer can be the donor or the acceptor. Many photoinitiators can also be used as coinitiators in combination with a sensitizer absorbing at higher wavelength, e.g. a sensitizer absorbing in the near infrared region (750 to 1200 nm) in combination with a coinitiator with an absorption maximum below 380 nm.

Suitable photoinitiators and/or sensitizers are known to the person skilled in the art, or it can easily be determined

whether significant absorption occurs in the desired wave length range by means of simple tests (e.g. recording an absorption spectrum).

Accordingly, the present invention provides in one aspect negative working precursors which are sensitive to UV/VIS radiation, i.e. radiation of about 250 to 750 nm (preferably 300 to 550 nm) and in another aspect negative working precursors which are sensitive to IR radiation, i.e. radiation of more than 750 to about 1200 nm (preferably 800 to 1100 nm).

In the present invention, a photoinitiator is a compound capable of absorbing radiation when exposed and of forming free radicals by itself, i.e. without the addition of coinitiators.

Examples of suitable photoinitiators absorbing UV or VIS radiation include triazine derivatives with 1 to 3 $CX_3$ groups (wherein every X is independently selected from a chlorine or bromine atom, and is preferably a chlorine atom), hexaarylbisimidazole compounds, benzoin ethers, benzil ketals, oxime ethers, oxime esters, α-hydroxy- or α-amino-acetophenones, acyl-phosphines, acylphosphine oxides, acylphosphine sulfides, metallocenes, peroxides etc. Examples of suitable triazine derivatives include 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-metboxystyryl)-4.6-bis(trichloromethyl)-s-triazine, 2-(4-methoxy-naphtho-1-yl)-4,6-bis(trichloromethyl)-s-triazine, and 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine. Suitable oxime ethers and oxime esters are for example those derived from benzoin. Preferred metallocenes are for example titanocenes with two five-membered cyclodienyl groups such as e.g. cyclopentadienyl groups and one or two six-membered aromatic groups having at least one ortho-fluorine atom and optionally also one pyrryl group; most preferred metallocenes are bis(cyclopentadienyl)-bis-[2,6-difluoro-3-(pyrr-1-yl)-phenyl]titanium and dicyclopentadiene-bis-2,4,6-trifluorophenyl-titanium or zirconium.

In the present invention, a single photoinitiator or a mixture of two or more can be used.

The photoinitiators can optionally be combined with one or more coinitiators; the addition of coinitiators can in some cases increase the effectiveness of the photoinitiation but is not essential to the invention.

The amount of photoinitiator(s) is not particularly restricted; however, if photoinitiators are present, it is preferably in the range of 0.2 to 25 wt-%, based on the dry layer weight, especially preferred 0.5 to 15 wt-%.

A sensitizer as referred to in the present invention is a compound which can absorb radiation when it is exposed but which cannot by itself, i.e. without the addition of coinitiators, form free radicals.

All light-absorbing compounds that are photooxidizable or photoreducible or capable of transferring their excitation energy to receptor molecules are suitable sensitizers for use in the present invention. Examples of such sensitizers include cyanine dyes, merocyanine dyes, oxonol dyes, diarylmethane dyes, triarylmethane dyes, xanthene dyes, coumarin derivatives, ketocoumarin dyes, acridine dyes, phenazine dyes, quinoxaline dyes, pyrrylium dyes or thiapyrrylium dyes, azaanulene dyes (such as phthalocyanines and porphyrines), indigo dyes, anthraquinone dyes, polyarylenes, polyarylpolyenes, 2,5-diphenylisobenzofuranes, 2,5-diarylfuranes, 2,5-diarylthiofuranes, 2,5-diarylpyrroles, 2,5-diarylcyctopentadienes, poly-arylphenylenes, polyaryl-2-pyrazolines, carbonyl compounds such as aromatic ketones or quinones, e.g. benzophenone derivatives, Michler's ketone, thioxanthone derivatives, anthraquinone derivatives and fluorenone derivatives.

Coumarin sensitizers of formula (I) are for example suitable for the near UV range of the electromagnetic spectrum:

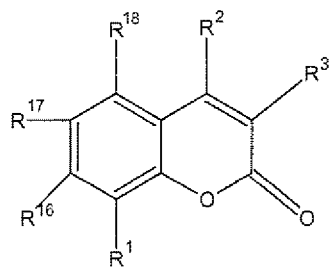

(I)

wherein

$R^1$, $R^{16}$, $R^{17}$ and $R^{18}$ are independently selected from --H, a halogen atom, $C_1$-$C_{20}$ alkyl, -OH, -O-$R^4$ and -$NR^5R^6$, wherein $R^4$ is $C_1$-$C_{20}$ alkyl, $C_5$-$C_{10}$ aryl or $C_6$-$C_{30}$ aralkyl (preferably $C_1$-$C_6$ alkyl) and $R^5$ and $R^6$ are independently selected from a hydrogen atom and $C_1$-$C_{20}$ alkyl,

or $R^1$ and $R^{16}$, $R^{16}$ and $R^{17}$ or $R^{17}$ and $R^{18}$ together form a 5- or 6-membered heterocyclic ring with a heteroatom, selected from N and O, in one or both positions adjacent to the phenyl ring shown in formula (I),

or $R^{16}$ or $R^{17}$ forms, together with its two adjacent substituents, a 5- or 6-membered heterocyclic ring with a heteroatom, selected from N and O, in one or both positions adjacent to the phenyl ring shown in formula (I),

wherein each formed 5- or 6-membered heterocyclic ring can independently be substituted with one or more $C_1$-$C_6$ alkyl groups,
with the proviso that at least one of $R^1$, $R^{16}$, $R^{17}$ and $R^{18}$ is different from hydrogen and $C_1$-$C_{20}$ alkyl,
$R^2$ is a hydrogen atom, $C_1$-$C_{20}$ alkyl, $C_5$-$C_{10}$ aryl or $C_6$-$C_{30}$ aralkyl and
$R^3$ is a hydrogen atom or a substituent selected from -COOH, -COOR$^7$, -COR$^8$, -CONR$^9$R$^{10}$, -CN, $C_5$-$C_{10}$ aryl, $C_6$-$C_{30}$ aralkyl, a 5- or 6-membered heterocyclic optionally benzofused group, a group -CH=CH-R$^{12}$ and

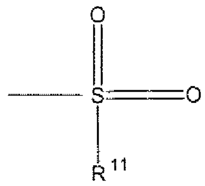

wherein $R^7$ is $C_1$-$C_{20}$ alkyl, $R^8$ is $C_1$-$C_{20}$ alkyl or a 5- or 6-membered heterocyclic group, $R^9$ and $R^{10}$ are independently selected from a hydrogen atom and $C_1$-$C_{20}$ alkyl, $R^{11}$ is $C_1$-$C_{12}$ alkyl or alkenyl, a heterocyclic non-aromatic ring or $C_5$-$C_{20}$ aryl optionally with a heteroatom, selected from O, S and N, and $R^{12}$ is $C_5$-$C_{10}$ aryl or a 5- or 6-membered heterocyclic, optionally aromatic, ring;
or $R^2$ and $R^3$, together with the carbon atoms to which they are bonded, form a 5- or 6-membered, optionally aromatic, ring.

They are described in more detail e.g. in WO 2004/049068 A1.

Furthermore, bisoxazole derivatives and analogues of the formula (II)

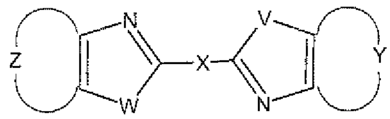

(II)

wherein X is a spacer group comprising at least one C-C double bond conjugated to the heterocycles,
Y and Z independently represent an optionally substituted fused aromatic ring and
V and W are independently selected from O, S and NR, wherein R is an alkyl, aryl or aralkyl group which can optionally be mono- or polysubstituted;
as described in more detail in WO 2004/074929 A2,
and oxazole compounds of the formula (III)

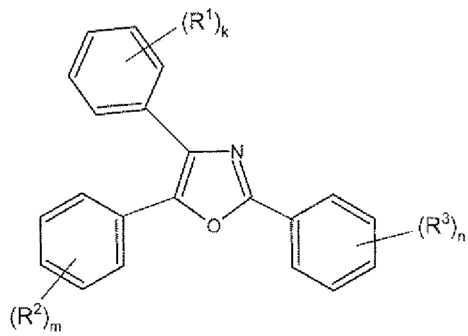

(III)

wherein each $R^1$, $R^2$ and $R^3$ is independently selected from a halogen atom, an optionally substituted alkyl group, an optionally substituted aryl group, which may also be fused, an optionally substituted aralkyl group, a group -NR$^4$R$^5$ and a group -OR$^6$,
wherein $R^4$ and $R^5$ are independently selected from a hydrogen atom, an alkyl, aryl or aralkyl group,
$R^6$ is an optionally substituted alkyl, aryl or aralkyl group or a hydrogen atom, and k, m and n are independently 0 or an integer from 1 to 5,
as described in detail in WO 2004/074930 A2;
are suitable sensitizers for the UV range.

Further suitable sensitizers for the near UV range are bis-styryl compounds of formula IV

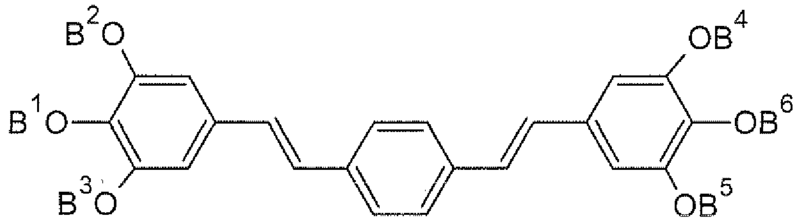

(IV)

wherein $B^1$ to $B^6$ are independently selected from $C_1$ to $C_{20}$ alkyl groups;
and a sensitizer of formula (V) wherein $C^1$ and $C^3$ each represents independently a hydrogen or a monovalent nonmetallic atom group and $C^2$ represents an alkyl group which may have a substituent or an aryl group which may have a substituent and $C^4$ represents an aromatic group which may have a substituent or a heterocyclic group which may have a substituent

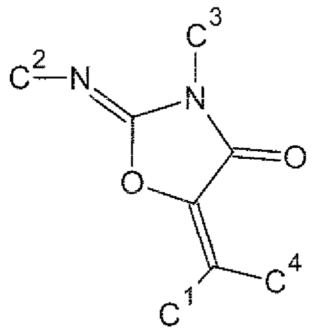

(V)

According to one embodiment of the present invention the sensitizer has a λmax in the UV/VIS range and preferably is selected from formulae I, III, IV and V above, and more preferably is selected from

Sensi 1

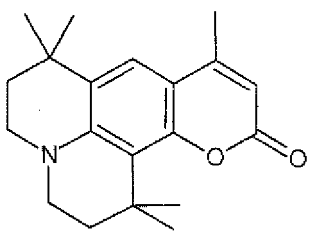

Sensi 2

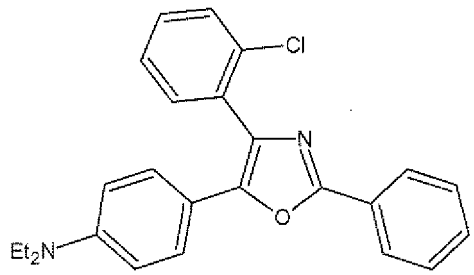

Sensi 3

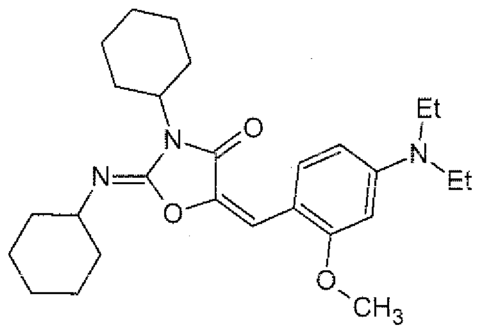

Sensi 4 Mixture of

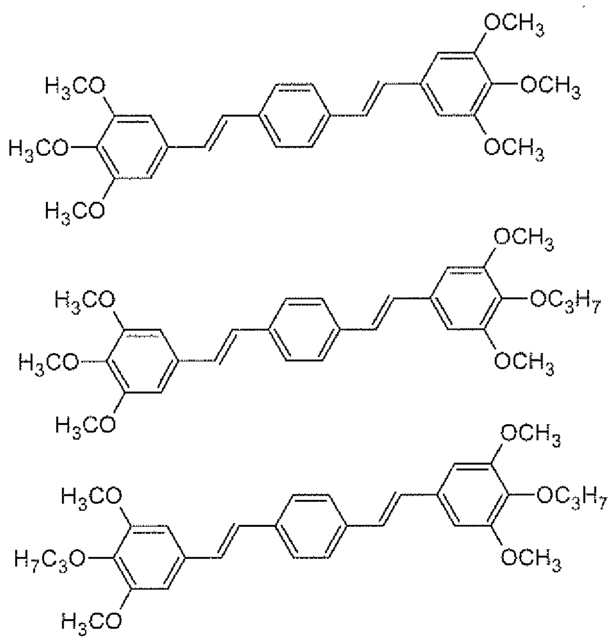

and mixtures thereof.

For IR-sensitive elements, the sensitizers are for example selected from carbon black, phthalocyanine pigments/dyes and pigments/dyes of the polythiophene, squarylium, thiazolium, croconate, merocyanine, cyanine, indolizine, pyrylium or metaldithiolin classes, especially preferred from the cyanine class. The compounds mentioned in Table 1 of US 6,326,122 for example are suitable IR dyes. Further examples can be found in US 4,327,169, US 4,756,993, US 5,156,938, WO 00/29214, US 6,410,207 and EP 1 176 007 A1.

According to one embodiment, a cyanine dye of formula (X)

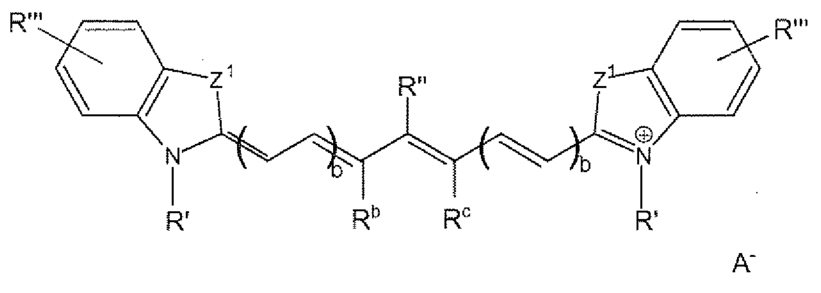

(X)

is used, wherein

each $Z^1$ independently represents S, O, $NR^a$ or $C(alkyl)_2$;
each R' independently represents an alkyl group, an alkyl sulfonate group or an alkylammonium group;
R" represents a halogen atom, $SR^a$, $OR^a$, $SO_2R^a$ or $NR^a_2$;
each R'" independently represents a hydrogen atom, an alkyl group, $-COOR^a$, $-OR^a$, $-SR^a$, $-NR^a_2$ or a halogen atom;
R"' can also be a benzofused ring;
$A^-$ represents an anion;
$R^b$ and $R^c$ either both represent hydrogen atoms or, together with the carbon atoms to which they are attached, form a carbocyclic five- or six-membered ring;
$R^a$ represents a hydrogen atom, an optionally substituted alkyl, an optionally substituted aryl group or an optionally substituted heteroaryl group;
each b is independently 0, 1, 2 or 3.
If R' represents an alkylsulfonate group, an internal salt can form so that no anion $A^-$ is necessary. If R' represents an alkylammonium group, a second counterion is needed which is the same as or different from $A^-$.

Of the IR dyes of formula (X), dyes with a symmetrical structure are especially preferred.
Examples of especially preferred dyes include:

2-[2-[2-Phenylsulfonyl-3-[2-(,1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium tosylate,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium tosylate and
2-[2-[2-chloro-3-[2-ethyl-(3H-benzthiazole-2-ylidene)-ethylidene]-1-cyclohexene-1-yl]-ethenyl]-3-ethyl-benzthiazolium tosylate.

The following compounds are also IR dyes suitable for the present invention:

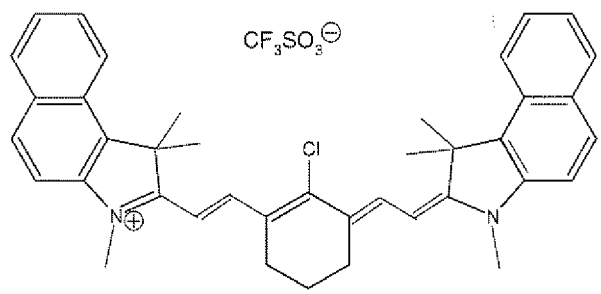

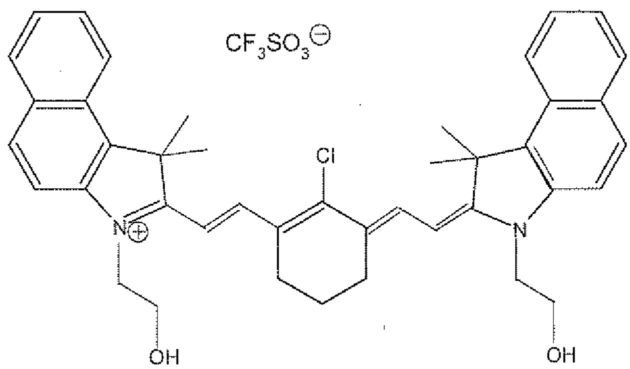

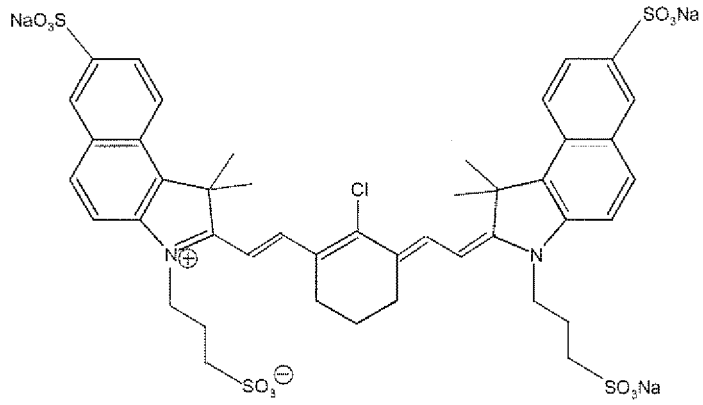

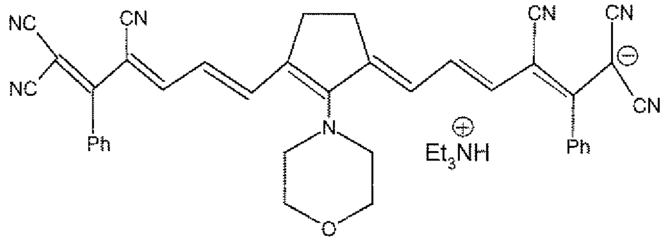

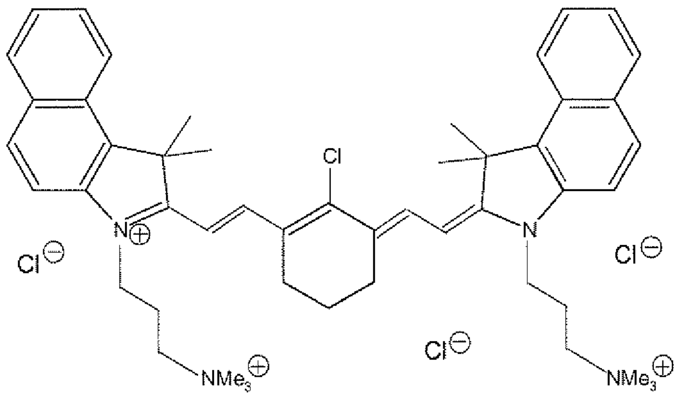

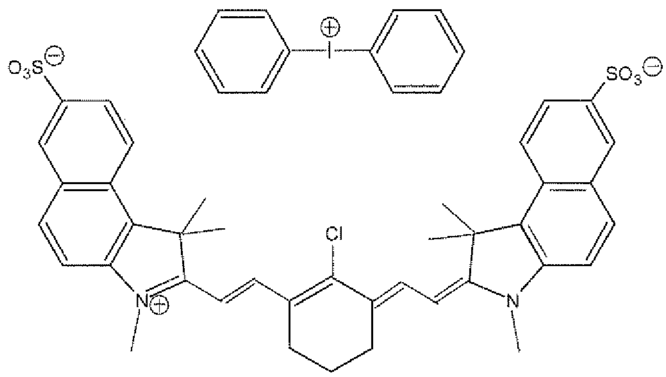

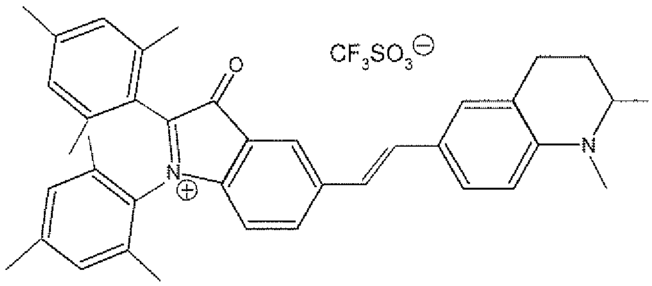

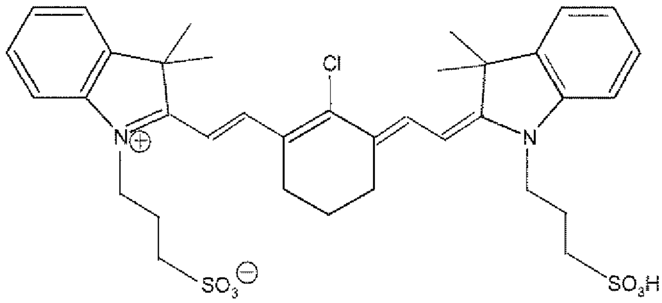

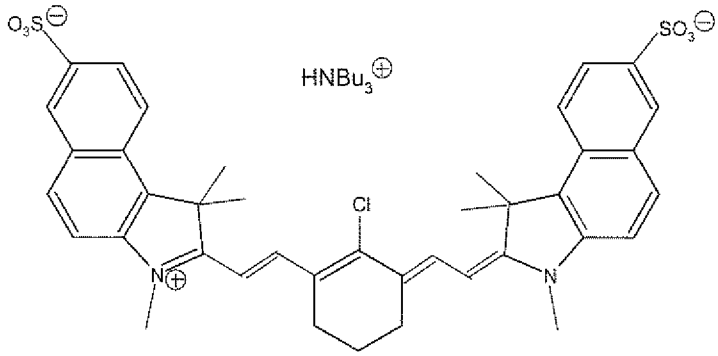

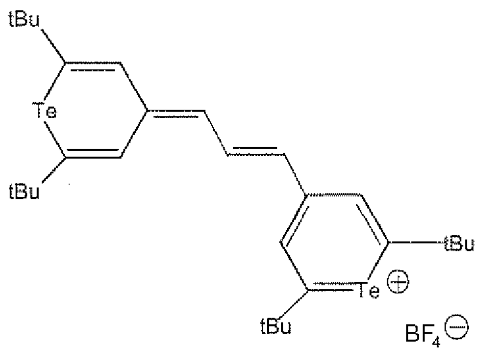

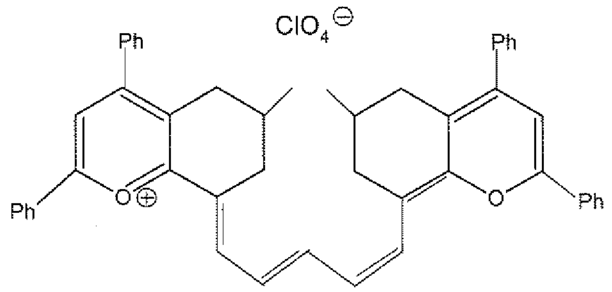

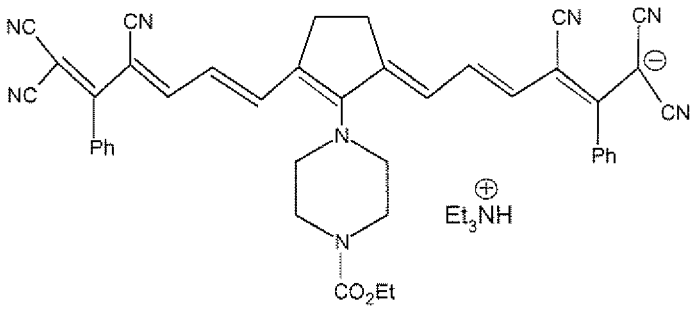

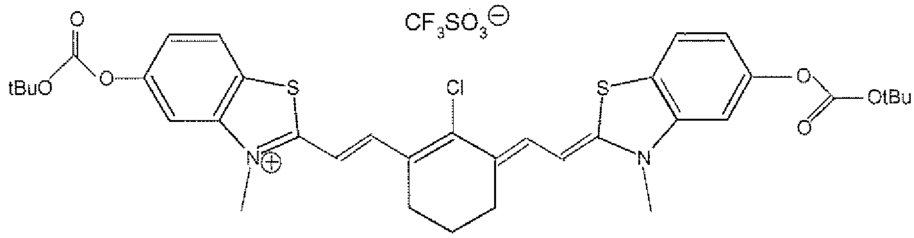

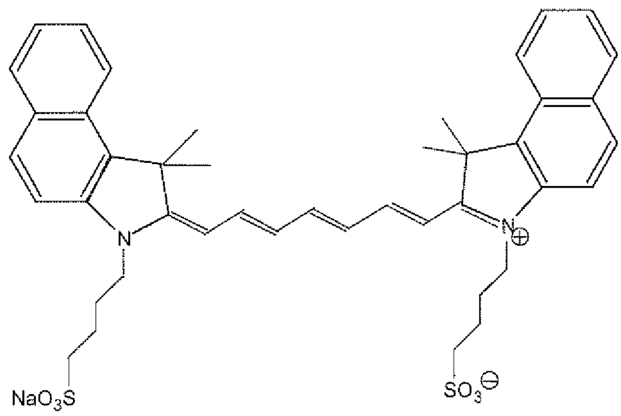

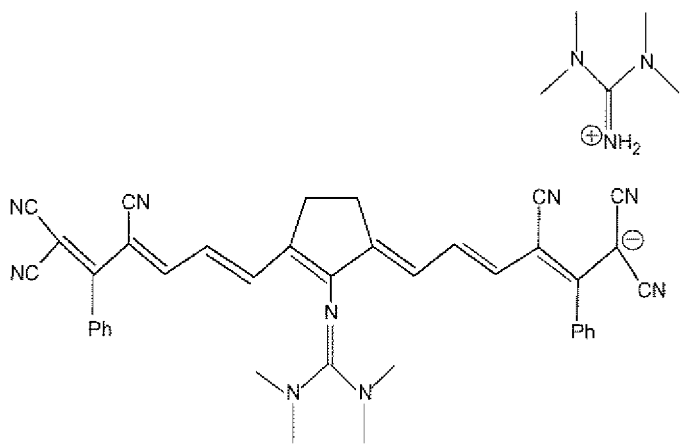

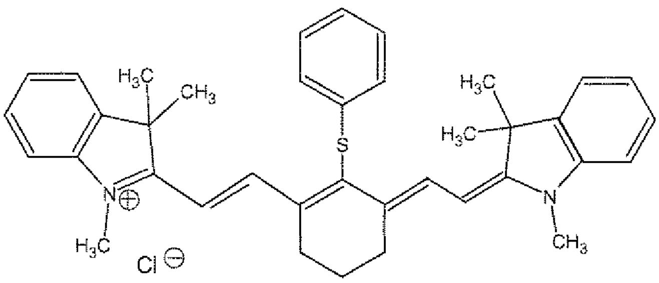

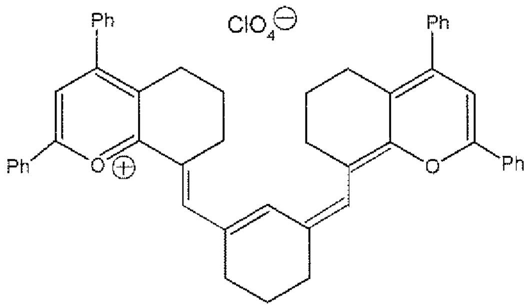

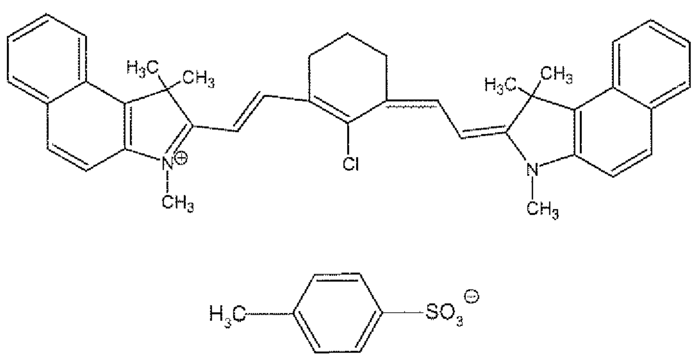

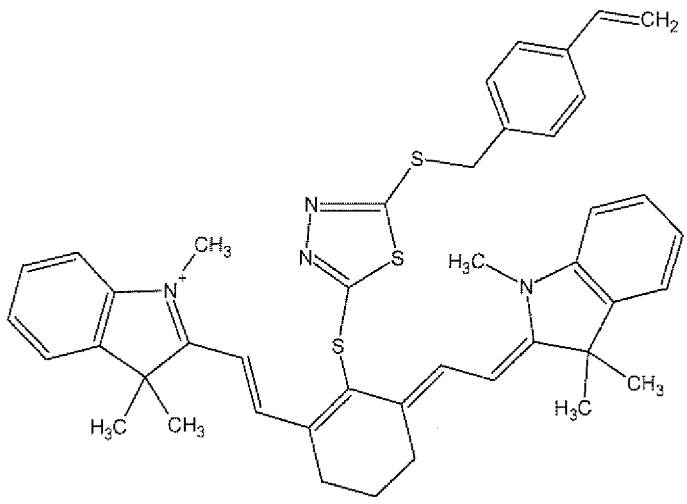

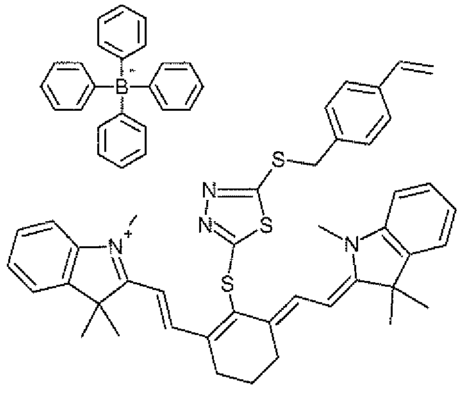

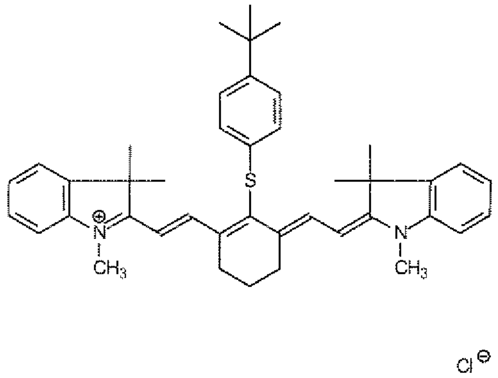

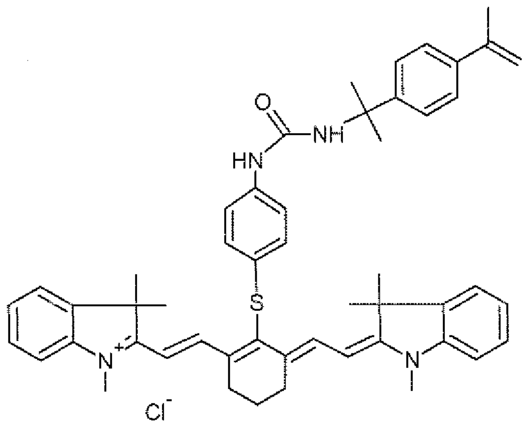

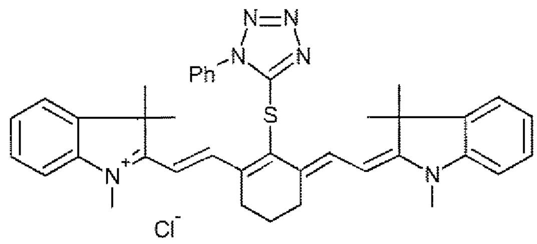

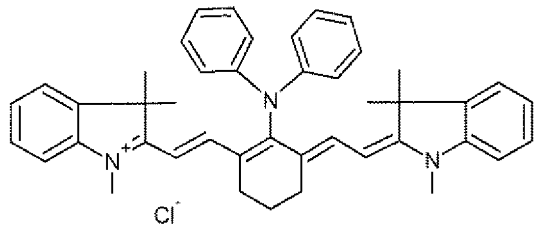

In the present invention, one sensitizer or a mixture of two or more can be used.

The sensitizers are used in combination with one or more coinitiators. Additionally, photoinitiators can be used; however, this is not preferred.

The amount of sensitizer(s) is not particularly restricted; however, if sensitizers are present, it is preferably in the range of 0.2 to 15 wt-%, based on the dry layer weight of the imageable coating, especially preferred 0.5 to 10 wt-%. If both photoinitiators and sensitizers are present in the coating, their total amount is preferably 0.5 to 30 wt-%, based on the dry layer weight, especially preferred 1 to 15 wt-%.

A coinitiator as referred to in the present invention is a compound that is essentially unable to absorb when irradiated but forms free radicals together with the radiation-absorbing sensitizers used in the present invention. The coinitiators are for example selected from onium compounds, for example those where the onium cation is selected from iodonium (such as e.g. diaryliodonium salts), sulfonium (such as triarylsulfonium salts), phosphonium, oxyl-sulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl, alkoxy or aryl; N-arylglycines and derivatives thereof (e.g. N-phenylglycine); aromatic sulfonyl halides; trihalomethylarylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US-A-5,629,354); hexaarylbiimidazoles; thiol compounds (e.g. mercaptobenzthiazole, mercaptobenzimidazole and mercaptotriazole); 1,3,5-triazine derivatives with 1 to 3 $CX_3$ groups (wherein every X is independently selected from a chlorine or bromine atom, and is preferably a chlorine atom), such as e.g. 2-phenyl-4,6-bis(trichloromethyl)-s-triazine, 2,4,6-tris(trichloromethyl)-s-triazine, 2-methyl-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; metallocenes (preferably titanocenes, and especially preferred those with two five-membered cyclodienyl groups, such as e.g. cyclopentadienyl groups and one or two six-membered aromatic groups with at least one ortho fluorine atom and optionally also a pyrryl group, such as bis(cyclopentadienyl)-bis-[2,6-difluoro-3-(pyrr-1-yl)-phenyl]titanium and dicyclopentadiene-bis-2,4,6-trifluorophenyl-titanium or zirconium).

Suitable 2,2,4,4',5,5'-hexaarylbiimidazoles (in the following simply referred to as hexaarylbiimidazoles) are represented by the following formula (XI):

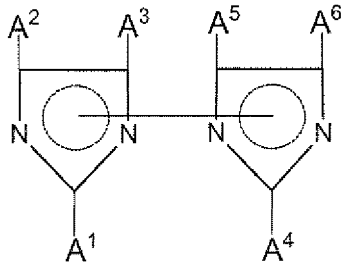

(XI)

wherein $A^1$-$A^6$ are substituted or unsubstituted $C_5$-$C_{20}$ aryl groups which are identical or different from each other and in whose rings one or more carbon atoms can optionally be substituted by heteroatoms selected from O, N and S. Suitable substituents for the aryl groups are those that do not inhibit the light-induced dissociation to triarylimidazolyl radicals, e.g. halogen atoms (fluorine, chlorine, bromine, iodine), -CN, $C_1$-$C_6$ alkyl (optionally with one or more substituents selected from halogen atoms, -CN and -OH), $C_1$-$C_6$, alkoxy, $C_1$-$C_6$ alkylthio, ($C_1$-$C_6$ alkyl) sulfonyl.
Preferred aryl groups are substituted and unsubstituted phenyl, biphenyl, naphthyl, pyridyl, furyl and thienyl groups. Especially preferred are substituted and unsubstituted phenyl groups, and particularly preferred are halogen-substituted phenyl groups.

Examples of suitable biimidazoles are for instance listed in WO 2010/066820 A1 on pages 29 to 31.

Suitable hexaarylbiimidazoles can be prepared according to known methods (see e.g. US-A-3,445,232). A preferred process is the oxidative dimerization of corresponding triarylimidazoles with iron-(III)-hexacyanoferrate (II) in an alkali solution.

The trihalogenmethyl compounds suitable as coinitiators are capable of forming free radicals. Trihalogenmethyl-substituted triazines and trihalogenmethyl-arylsulfones are preferred. The following can be mentioned as examples (without restricting the invention to these compounds): 2-(4-Methoxyphenyl)-4,6-bis(trichloromethyl)-s-triazine, 2-(4-chlorophenyl)-4,6-bis-(trichloro-methyl)-s-triazine, 2-phenyl-4,6-bis(trichloromethyl)-s-triazine, 2,4,6-tris-(trichloromethyl)-s-triazine, 2,4,6-tris-(tribromomethyl)-s-triazine and tribromomethylphenylsulfone.

Among the suitable onium compounds described above iodonium compounds are preferred and especially preferred are diaryliodonium compounds represented by the following formula (XII):

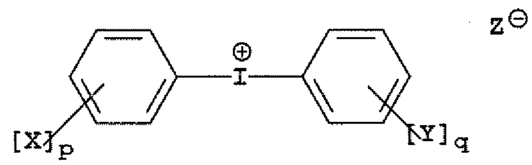

(XII)

wherein X and Y are independently halo groups (for example, fluoro, chloro, or bromo), substituted or unsubstituted alkyl groups having 1 to 20 carbon atoms (for example, methyl, chloromethyl, ethyl, 2-methoxyethyl, *n*-propyl, *iso*propyl, *iso*butyl, *n*-butyl, *t*-butyl, all branched and linear pentyl groups, 1-ethylpentyl, 4-methylpentyl, all hexyl isomers, all octyl isomers, benzyl, 4-methoxybenzyl, *p*-methylbenzyl, all dodecyl isomers, all icosyl isomers, and substituted or unsubstituted mono-and poly-, branched and linear haloalkyls), substituted or unsubstituted alkyloxy having 1 to 20 carbon atoms (for example, substituted or unsubstituted methoxy, ethoxy, *iso*-propoxy, *t*-butoxy, (2-hydroxytetradecyl)oxy, and various other linear and branched alkyleneoxyalkoxy groups), substituted or unsubstituted aryl groups having 6 or 10 carbon atoms in the carbocyclic aromatic ring (such as substituted or unsubstituted phenyl and naphthyl groups including mono- and polyhalophenyl and naphthyl groups), or substituted or unsubstituted cycloalkyl groups having 3 to 8 carbon atoms in the ring structure (for example, substituted or unsubstituted cyclopropyl, cyclopentyl, cyclohexyl, 4-methylcyclohexyl, and cyclooctyl groups). For example, X and Y are independently substituted or unsubstituted alkyl groups having 1 to 8 carbon atoms, alkyloxy groups having 1 to 8 carbon atoms, or cycloalkyl groups having 5 or 6 carbon atoms in the ring, and more preferably, X and Y are independently substituted or unsubstituted alkyl groups having 3 to 6 carbon atoms (and particularly branched alkyl groups having 3 to 6 carbon atoms). Thus, X and Y can be the same or different groups, the various X groups can be the same or different groups, and the various Y groups can be the same or different groups. Both "symmetric" and "asymmetric" diaryliodonium compounds are contemplated by this invention but the "symmetric" compounds are preferred (that is, they have the same groups on both phenyl rings).

In addition, two or more adjacent X or Y groups can be combined to form a fused carbocyclic or heterocyclic ring with the respective phenyl groups.
The X and Y groups can be in any position on the phenyl rings but preferably they are at the 2- or 4-positions, and more preferably at the 4-position, on either or both phenyl rings.
In formula (XII), p and q are independently 0 or integers of 1 to 5. For example, both p and q can be 1. Thus, it is understood that the carbon atoms in the phenyl rings that are not substituted by X or Y groups have a hydrogen atom at those ring positions.

$Z^-$ is an inorganic or organic anion and preferably an organic borate anion represented by the following formula (XIII):

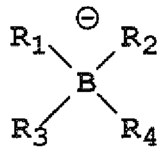

(XIII)

wherein $R_1$, $R_2$, $R_3$, and $R_4$ are independently substituted or unsubstituted alkyl, aryl, alkenyl, alkynyl, cycloalkyl or heterocyclyl groups, or two or more of $R_1$, $R_2$, $R_3$ and $R_4$ together form a 5-7 membered heterocyclic ring with a boron atom and optionally one or more further hetero ring atoms selected from nitrogen and oxygen. Preferably $R_1$, $R_2$, $R_3$ and $R_4$ are independently selected from substituted or unsubstituted alkyl groups having 1 to 12 carbon atoms (such as methyl, ethyl, *n*-propyl, *iso*-propyl, *n*-butyl, *iso*butyl, *t*-butyl, all pentyl isomers, 2-methylpentyl, all hexyl isomers, 2-ethylhexyl, all octyl isomers, 2,4,4-trimethylpentyl, all nonyl isomers, all decyl isomers, all undecyl isomers, all dodecyl isomers, methoxymethyl, and benzyl) other than fluoroalkyl groups, substituted or unsubstituted carbocyclic aryl groups having 6 to 10 carbon atoms in the aromatic ring (such as phenyl, p-methylphenyl, 2,4-methoxyphenyl, naphthyl, and pentafluorophenyl. groups), substituted or unsubstituted alkenyl groups having 2 to 12 carbon atoms (such as ethenyl, 2-methylethenyl, allyl, vinylbenzyl, acryloyl, and crotonotyl groups), substituted or unsubstituted alkynyl groups having 2 to 12 carbon atoms (such as ethynyl, 2-methylethynyl, and 2,3-propynyl groups), substituted or unsubstituted cycloalkyl groups having 3 to 8 carbon atoms in the ring structure (such as cyclopropyl, cyclopentyl, cyclohexyl, 4-methylcyclohexyl, and cyclooctyl groups), or substituted or unsubstituted heterocyclyl groups having 5 to 10 carbon, oxygen, sulfur, and nitrogen atoms (including both aromatic and non-aromatic groups, such as substituted or unsubstituted pyridyl, pyrimidyl, furanyl, pyrrolyl, imidazolyl, triazolyl, tetrazoylyl, indolyl, quinolinyl, oxadiazolyl, and benzoxazolyl groups); alternatively, two or more of $R_1$, $R_2$, $R_3$, and $R_4$ can be joined together to form a heterocyclic ring with the boron atom, such rings having up to 7 carbon, nitrogen, oxygen, or nitrogen atoms.

For example, $R_1$, $R_2$, $R_3$, and $R_4$ are independently substituted or unsubstituted alkyl or aryl groups as defined above, or at least 3 of $R_1$, $R_2$, $R_3$, and $R_4$ are the same or different substituted or unsubstituted aryl groups (such as substituted or unsubstituted phenyl groups). In some embodiments, all of $R_1$, $R_2$, $R_3$, and $R_4$ are the same or different substituted or unsubstituted aryl groups or, all of the groups are the same substituted or unsubstituted phenyl group. For example, $Z^-$ is a tetraphenyl borate wherein the phenyl groups are substituted or unsubstituted.

Representative iodonium borate compounds include but are not limited to, 4-octyloxyphenyl phenyliodonium tetraphenylborate, [4-[(2-hydroxytetradecyl)-oxy]phenyl]phenyliodonium tetraphenylborate, *bis*(4-*t*-butylphenyl)iodonium tetraphenylborate, 4-methylphenyl-4'-hexylphenyliodonium tetraphenylborate, 4-methylphenyl-4'-cyclohexylphenyliodonium tetraphenylborate, *bis*(*t*-butylphenyl)iodonium tetrakis(pentafluorophenyl)borate, 4-hexylphenylphenyliodonium tetraphenylborate, 4-methylphenyl-4'-cyclohexylphenyliodonium *n*-butyltriphenylborate, 4-cyclohexylphenyl-phenyliodonium tetraphenylborate, 2-methyl-4-*t*-butylphenyl-4'-methylphenyliodonium tetraphenylborate, 4-methylphenyl-4'-pentylphenyliodonium tetrakis(3,5-bis(trifluoromethyl)phenyl]-borate, 4-methoxyphenyl-4'-cyclohexylphenyliodonium tetrakis(penta-fluorophenyl)borate, 4-methylphenyl-4'-dodecylphenyliodonium tetrakis(4-fluorophenyl)borate, bis(dodecylphenyl)iodonium tetrakis(pentafluorophenyl)-borate, and bis(4-*t*-butylphenyl)iodonium tetrakis(1-imidazolyl)borate. Particularly useful compounds include bis(4-*t*-butylphenyl)iodonium tetraphenylborate, 4-methylphenyl-4'-hexylphenyliodonium tetraphenylborate, 2-methyl-4-*t*-butylphenyl-4'-methylphenyliodonium tetraphenylborate, and 4-methylphenyl-4'-cyclohexylphenyliodonium tetraphenylborate.

Many coinitiators can also function as photoinitiators when they are exposed in their absorption band. This way, photosensitive layers can be obtained that are e.g. sensitive over a wide spectral range because a photoinitiator or sensitizer covers the long-wavelength spectral range (IR and/or visible range) and a coinitiator covers the short-wavelength spectral range (e.g. the UV range), This effect can be advantageous if the consumer wants to irradiate the same material with different radiation sources. In this case, the coinitiator functions as an actual coinitiator in the sense of the definition given above for the IR or visible range, while it functions as a photoinitiator for the UV range.

In the present invention, one coinitiator or a mixture of coinitiators can be used.

The amount of coinitiator(s) is not particularly restricted; however, it is preferably in the range of 0.2 to 25 wt-%, based on the dry layer weight of the imageable coating, especially preferred 0.5 to 15 wt-%.

Further examples of suitable sensitizers and coinitiators for IR-sensitive coatings are also mentioned in WO 2004/041544, WO 2000/48836 and DE 10 2004 003143.

If the precursor is sensitive to UV/VIS radiation it is preferred that a biimidazole as defined above and more preferably such a biimidazole in combination with a mercapto compound as defined above is used as coinitiator. For IR sensitive precursors iodonium borates are preferred as coinitiators. These aspects can be combined with any other aspect or preferred aspect of the present invention described above or below (including any of aspects (aa) to (kk) of the branched binder described below).

*Branched binder material*

The radiation sensitive coatings of the precursors according to the present invention contain 10 to 90 wt% based on the dry coating weight of a branched binder material (sometimes also referred to as highly branched binder or hyperbranched binder), preferably 20 to 70 wt%, more preferably 30 to 60 wt%. The preferred and more preferred range can be combined with any other feature, preferred, more preferred or most preferred feature of the branched binder material described in the following; in addition, they can be combined with any other feature of the precursors of the present invention described above or below.

This binder material is characterized by the following essential features:

- a number average molecular weight Mn (determined with GPC using polystyrene standards) of 500 to 15000, preferably 500 to 10000, more preferably 900 to 5000
- a Tg > 30°C (determined by DSC; measuring conditions: -60 to +160°C; 10K/min; Tg determined by half step method in the 1. heating circle), preferably > 35°C, more preferably > 40°C (any of these ranges can be combined with any range disclosed for the molecular weight above)
- a branched structure (due to the high number of branching units compared to spacer units sometimes also called "hyperbranched structure")
- it consists of structural moieties derived from $n_{EG}$ moles of end group precursors of formula (I), and $n_{BU}$ moles branching unit precursors of formula (II), and optionally $n_{SU}$ moles of spacer unit precursors of formula (III):

$L^1X^1$ (I)

$L^2(X^2)_n$ (II)

$L^3(X^3)_2$ (III)

with $n_{EG} > n_{BU} > 0$ and $0 \leq n_{SU} < (n_{EG} + n_{BU})$

- it comprises urea and/or urethane linkages which connect the structural moieties derived from the precursors of formula (I) and (II) and optionally (III)
- it comprises radically polymerizable groups (preferably ethylenically unsaturated double bonds), which are preferably introduced into the binder via $L^1$.

In the following each of the aspects of the branched binder material mentioned above will be explained in detail, including methods for the preparation of the binder material.

For the preparation of the branched binder material at least one end group precursor of formula (I) is used; according to one embodiment two or more (preferably 2 to 3) different end group precursors of formula (I) are used:

$L^1X^1$ (I)

$X^1$ in formula (I) is selected from an isocyanate group and isocyanate reactive groups selected from the group consisting of -OH and -NHR. If $X^1$ is an isocyanate reactive group it is not directly adjacent to a carbonyl group C=O. R is selected from H, $C_{1-20}$ alkyl optionally substituted by one or more halogen atoms, and $C_{5-20}$ aryl optionally substituted by one or more halogen atoms or $C_{1-20}$ alkyl, preferably H, optionally substituted $C_{1-12}$ alkyl and optionally substituted $C_{5-14}$ aryl; more preferably H, optionally substituted $C_{1-8}$ alkyl and optionally substituted $C_{5-10}$ aryl; and most preferably R is H, optionally substituted $C_{1-6}$ alkyl and optionally substituted $C_{5-6}$ aryl.

$L^1$ in formula (I) is an aliphatic, aromatic, heterocyclic or heteroaromatic moiety, each of which being optionally substituted by one or more (preferably 1 to 10, more preferably 1 to 5) substituents $R^{EG}$. $L^1$ does not contain urethane and urea linkages besides urea linkages being part of cyanuric acid derivatives having the structural moiety

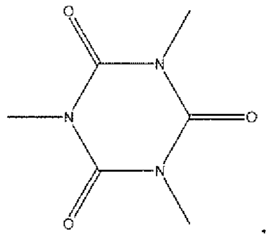

$L^1$ has a valence of 1 and preferably a maximum number of carbon atoms (including any optional substituents) of 250, more preferably 100, even more preferably 50 and most preferably 30.

It is preferred that $L^1$ in the end group precursor of formula (I) comprises at least one (preferably 1 to 10, more preferably 1 to 5, most preferably 1 to 3) functional group $R^{EG}$ (if two or more different end group precursors of formula I are used it is preferred that at least one thereof comprises at least one functional group $R^{EG}$) which is independently selected from

(i) radical reactive groups having an ethylenically unsaturated double bond
(ii) acidic groups selected from -COOH, $-SO_3H$, $-PO_3H_2$ and $--PO_4H_2$, and
(iii) hydrophobic or hydrophilic groups which are different from isocyanate groups, -OH and -NHR groups as well as different from (i) and (ii).

The branched binder material is inter alia characterized by the presence of radically polymerizable groups having an ethylenically unsaturated double bond; it is preferred that at least one end group precursor of formula (I) is used wherein $L^1$ comprises at least one radically polymerizable group.

According to one embodiment at least two different end group precursors are used for the preparation of the branched binder material, wherein one comprises at least one radical reactive group having an ethylenically unsaturated double bond and the other one comprises at least one acidic group selected from -COOH, $-SO_3H$, $-PO_3H_2$ and $-PO_4H_2$ (preferably -COOH).

According to one embodiment the functional groups $R^{EG}$ are selected from -COOH, $-Y-C(O)CR^x=CH_2$, $-(Y)_b-(CH_2)_a-CR^x=CH_2$,

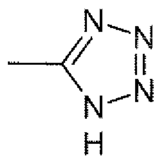

and

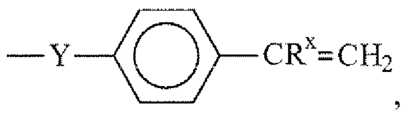

,

wherein Y is -O- or $-NR^y-$; $R^x$ is H or $CH_3$; $R^y$ is H, $C_{1-20}$alkyl or $C_{5-20}$aryl, preferably H or $CH_3$; a is 0 or 1; and b is 0 or 1.

According to a preferred embodiment $L^1$ of formula (I) is represented by a formula (I-1)

$$(\Delta\text{-}Y^5\text{-}Y^6\text{-}Y^7)_{na}\text{-}Z^4\text{-}Y^8\text{-}Y^9\text{-}Y^{10} \qquad \text{(I-1)}$$

wherein $Z^4$ is selected from
C; $(C(R^p)_p)_{ny}$; $(-O)_3P=Y^4$ (with $Y^4$ being O or S); N;

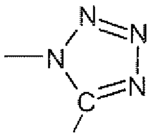 ; 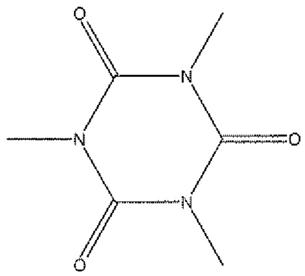 ; 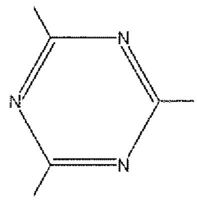 ;

a 5 or 6 membered saturated heterocyclic group containing 2 oxygen ring atoms; and a 5-6 membered aromatic or saturated carbocyclic group;

$Y^5$ to $Y^9$ are independently selected from single bond; -O-; -NR- with R being H, $C_{1-20}$ alkyl- or $C_{5-20}$ aryl; $-SO_2-$; $-((CH_2)_q-CR^aH-O)_{nb}-$ ; $-(O-C(=O)-(CH_2)_{nc})_{nb}-$; divalent aromatic, heteroaromatic, heterocyclic or cyclic group (e.g. phenylene, pyridinylene, pyrrolidinylene, cyclohexylene) each optionally substituted by one or more substituents selected from halogen atoms and $C_{1-20}$ alkyl, or alkylene group optionally being substituted by one or more halogen atoms;

each $Y^{10}$ is independently selected from -*, $-(CH_2-CR^aH-O)_{ny}-*$ ; -T-* with T being a divalent aromatic, heteroaromatic, heterocyclic or cyclic group (e.g. phenylene, pyridinylene, pyrrolidinylene, cyclohexylene) each optionally substituted by one or more substituents selected from halogen atoms and $C_{1-20}$ alkyl, or alkylene group, optionally being substituted by one or more halogen atoms;

each $R^p$ is independently selected from H, $C_{1-5}$ alkyl and $-(CH_2)_e-\Delta$, preferably H, $CH_3$;

each $R^a$ is independently selected from H and $C_{1-5}$ alkyl (preferably H and $CH_3$);

with each na being an integer independently selected from 1 to 10 (preferably 1 to 3); each nb being an integer independently selected from 1 to 10 (preferably 1 to 5); each nc being an integer of at least 2 (preferably 2 to 10);

e is 0 or an integer of 1 to 10 (preferably 0 or an integer of 1 to 5);

p is 0 or 1 or 2; q is 0 or an integer from 1 to 5;

each ny is independently an integer from 1 to 20, preferably 1 to 10;

* denotes the binding site of $X^1$;

and Δ denotes the binding site of functional group $R^{EG}$ or H with $R^{EG}$ being defined as above; with the proviso that $Z^4$ and $Y^5$ to $Y^{10}$ are selected such that $L^1$ of formula (I-1) does not contain

(1) an oxygen atom directly bonded to a nitrogen atom or another oxygen atom,
(2) a nitrogen atom directly bonded to another nitrogen atom, and
(3) a sulphur atom directly bonded to another sulphur atom.

More preferably $L^1$ of formula (I) is represented by a formula selected from (I-1') to (I-8'):

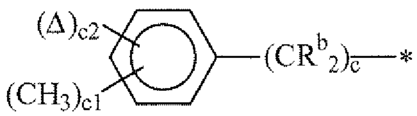 (I-1')

wherein c is 0 or 1; each $R^b$ is independently H or $CH_3$; cl is 0 or 1; c2 is an integer of 1 to 3 (preferably 1);
* denotes the binding site of $X^1$;
Δ denotes the binding site of a functional group $R^{EG}$ or H;

$$\Delta-(CR^c_2)_d-* \qquad (I-2')$$

wherein d is an integer of 1 to 20 (preferably 1 to 10); each $R^c$ is independently H or $CH_3$;
* denotes the binding site of $X^1$; Δ denotes the binding site of functional group $R^{EG}$ or H;

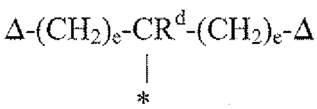 (I-3')

wherein each e is independently 0 or an integer of 1 to 10 (preferably 1 to 5);

$R^d$ is H or $-(CH_2)_e-\Delta$;
* denotes the binding site of $X^1$;
$\Delta$ denotes the binding site of functional groups $R^{EG}$ or H;

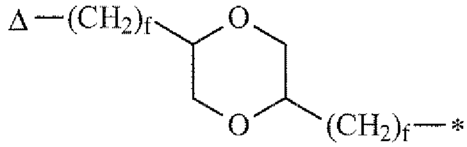

(I-4')

wherein each f is independently an integer of 1 to 10 (preferably 1 to 5);
* denotes the binding site of $X^1$; $\Delta$ denotes the binding site of functional group $R^{EG}$ or H;

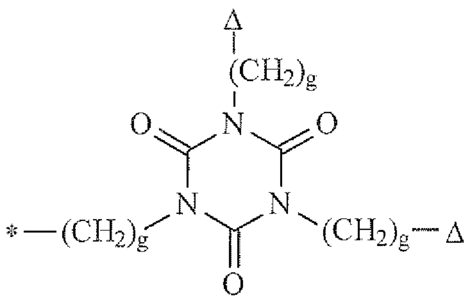

(I-5')

wherein each g is independently an integer of 1 to 10 (preferably 1 to 5); * denotes the binding site of $X^1$; $\Delta$ denotes the binding site of functional groups $R^{EG}$ or H;

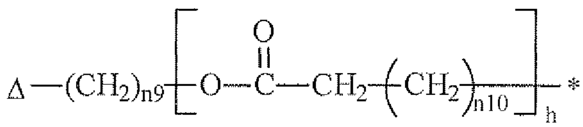

(I-6')

wherein h is an integer of 1 to 10 (preferably 1 to 5); n9 is an integer from 1 to 10 (preferably 1 or 2) and n10 is an integer from 1 to 20 (preferably 1 to 5); * denotes the binding site of $X^1$; $\Delta$ denotes the binding site of functional group $R^{EG}$ or H;

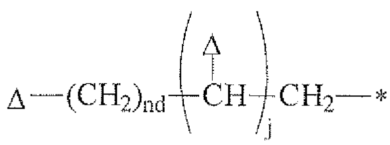

(I-7)

wherein j is an integer of 2 to 20 (preferably 2 to 10); nd is an integer of 1 to 10 (preferably 1 or 2), * denotes the binding site of $X^1$; $\Delta$ denotes the binding site of functional groups $R^{EG}$ or H;

$R^e(CR^e{}_2CH_2\text{-}O)_{a1}CH_2CR^e{}_2\text{-}CH_2\text{-}*$ (I-8')

wherein al is an integer of 1 to 20 (preferably 1 to 10); each $R^e$ is independently H, $CH_3$ or $-(CH_2)_{a7}-\Delta$;
a7 is 0 or an integer of 1 to 10, preferably 1 to 5;
$\Delta$ denotes the binding site of functional group $R^{EG}$ or H;
* denotes the binding site of $X^1$;
wherein in formulae (I-1') to (I-8') $R^{EG}$ is as defined above.

It is further preferred that the end group precursor of formula (I) used for the preparation of the branched binder material is at least one selected from group IA consisting of: Aryl-OH, Aryl-$CH_2$-OH, Alkyl-OH, Aryl-$NH_2$, Aryl-$CH_2$-$NH_2$, Alkyl-$NH_2$, Alkyl-NCO, Aryl-NCO, Aryl-$CH_2$-NCO, R-O-$(CH_2CH_2\text{-}O)_yH$, R-O-$(CH(CH_3)CH_2\text{-}O)_zH$,

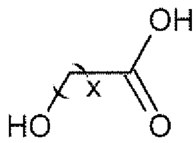 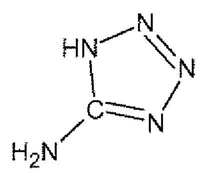 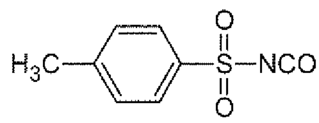 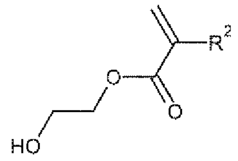

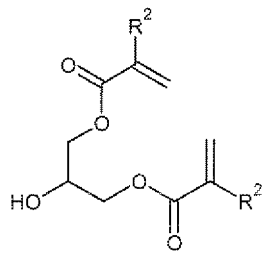 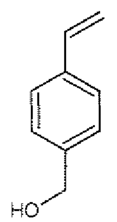 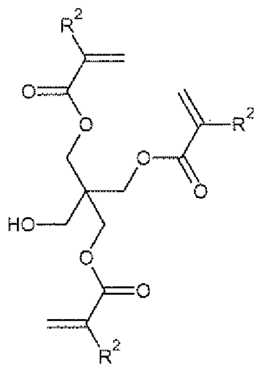 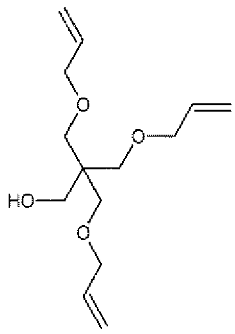

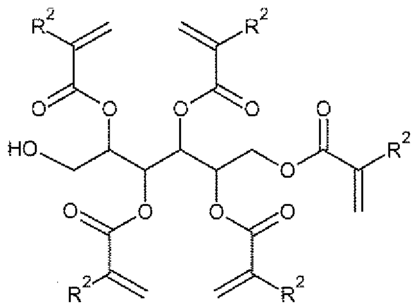 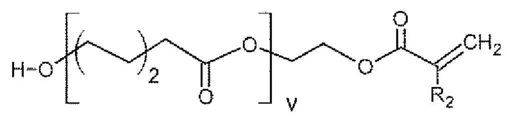

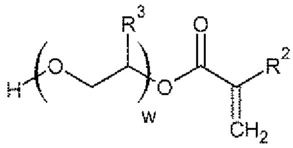 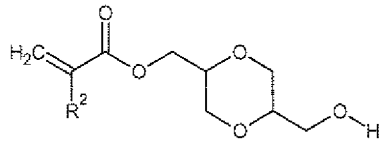

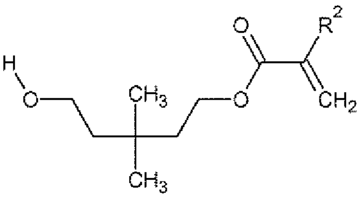 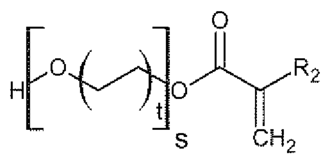

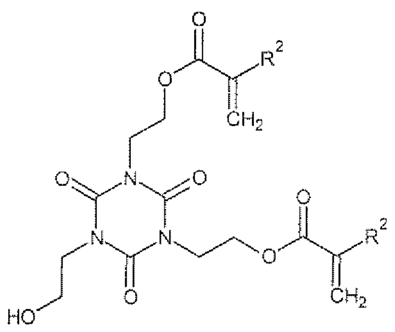 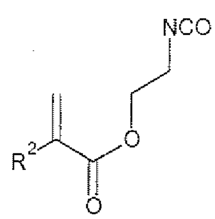 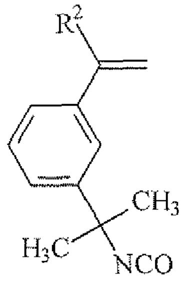

wherein each $R^2$ and $R^3$ is independently H or $CH_3$;

R is $C_{5-20}$aryl or $C_{1-20}$alkyl, preferably $C_{5-6}$aryl or $C_{1-12}$alkyl;
each of x, y, z, t, s and w is independently an integer of 1 to 20, preferably 1 to 12;
v is an integer of 1 to 10, preferably 1 to 6;
Aryl is phenyl or naphthyl which may be optionally substituted with 1 to 5 substituents independently selected from $C_{1-50}$ alkyl (preferably $C_{1-20}$ alkyl); ar($C_{1-50}$)alkyl (preferably ar($C_{1-20}$)alkyl); halogen; and -Si($R^z$)$_3$ with $R^z$ being $C_{1-10}$alkyl or $C_{1-10}$alkoxy;
and
"Alkyl" means straight-chain or branched chain $C_1$-$C_{50}$ alkyl, preferably $C_1$-$C_{20}$ alkyl, which may be optionally substituted by one or more groups selected from aryl; halogen; and -Si($R^z$)$_3$ with $R^z$ being $C_{1-10}$calkyl or $C_{1-10}$alkoxy.

Examples of $L^1X^1$ are for instance those of group IB consisting of:

(1) the following compounds with an ethylenically unsaturated group, and $X^1$ = -OH: mono(meth)acrylates of a diol like hydroxyethyl (meth)acrylate, hydroxypropyl (meth)acrylate, hydroxybutyl (meth)acrylate, neopentyl glycol mono(meth)acrylate, dodecandiol mono(meth)acrylate, dioxane glycol mono(meth)acrylate di(meth)acrylates of a triol like trimethylolpropane di(meth)acrylate, glycerol di(meth)acrylate, tris(2-hydroxyethyl) isocyanurate di(meth)acrylate, (meth)acrylates of polyols like pentaerythritol tri(meth)acrylate, dipentaerythritol penta(meth)acrylate, ditrimethylolpropane tri(meth)acrylate, hexamethylolmelamin penta(meth)acrylate mono(meth)acrylate of poly(alkylene glycols) like poly(ethylene glycol) mono(meth)acrylate, poly(propylene glycol) mono(meth)acrylate, mono(meth)acrylated block copolymers of poly(ethylene glycol- propylene glycol) caprolactone (meth)acrylate hydroxymethyl styrene allyl alcohol;

(2) the following compounds with ethylenically unsaturated group and $X^1$ = -$NH_2$: mono(meth)acrylic amides of aliphatic, aromatic or araliphatic diamines like ethylene diamine, 1,2-diaminopropane, 1,3-diaminopropane, 1,4-diaminobutane, 1,5-diaminopentane, 1,2-diaminocyclohexane, 2,4-diaminotoluene, 4-aminobenzylaminehexamethylene diamine, trimethylhexamethylene diamine, isophorone diamine, 4,4'-diaminodiphenylsulfon, 2,4-diaminopyrimidine, 2,5-diaminopyrimidine, 4,5-diaminopyrimidine, 4,6-diaminopyrimidine, and o-, m- or p-phenylene diamine or di(meth)acrylic amides of aliphatic or aromatic triamines like diethylenetriamine;

(3) the following compounds with ethylenically unsaturated group and $X^1$ = -N=C=O isocyanatoethyl acrylate, isocyanatoethyl methacrylate, m-isopropenyl-$\alpha$,$\alpha$-dimethyl benzyl isocyanate.

(4) the following compounds with acidic groups and $X^1$ = -OH or -$NH_2$ carboxylic acids with OH-groups like 2-hydroxyethanoic acid, 2-hydroxypropionic acid, 3-hydroxypropionic acid, 2-hydroxy butyric acid, 3-hydroxy butyric acid, citric acid, mandelic acid, and salicylic acid amino acids like alanine, valine, phenyl alanine, leucine, isoleucine, 4-aminobenzoic acid, and 2-aminobenzoic acid;
aminotetrazol;
toluene sulfonyl isocyanate;

(5) the following compounds having hydrophilic groups
R-O-($CH_2CH_2$-O)$_n$H und
R-O-(CH($CH_3$)$CH_2$-O)$_n$H
with R = $C_{1-4}$ alkyl and n being an integer of 1 to 60, preferably 1 to 15

(6) the following compounds having hydrophobic groups
$R^x$-OH ($R^x$ = $C_{5-20}$aryl, $C_{1-50}$alkyl, $C_{5-10}$ar$C_{1-50}$alkyl; preferably $C_{5-6}$aryl, $C_{1-20}$alkyl, $C_{5-6}$ar$C_{1-20}$alkyl)
$R^x$-NHR ($R^x$ = $C_{5-20}$aryl, $C_{1-50}$alkyl, $C_{5-10}$ar$C_{1-50}$alkyl; preferably $C_{5-6}$aryl, $C_{1-20}$alkyl, $C_{5-6}$ar$C_{1-20}$alkyl)
$R^x$-N=C=O ($R^x$ = $C_{5-20}$aryl, $C_{1-50}$alkyl, $C_{5-10}$ar$C_{1-50}$alkyl; preferably $C_{5-6}$aryl, $C_{1-20}$alkyl, $C_{5-6}$ar$C_{1-20}$alkyl)

For the preparation of a branched binder material also a branching unit precursor of formula (II) is used; it is also possible to use two or more different branching unit precursors:

$$L^2(X^2)_n \qquad (II)$$

wherein n is an integer of at least 3, preferably 3 to 20, more preferably 3 to 10, most preferably 3 to 6.

$X^2$ in formula (II) is selected from an isocyanate group and isocyanate reactive groups selected from the group consisting of -OH and -NHR (with R being defined as above for formula (I)). According to one embodiment all $X^2$ groups are isocyanate groups. According to another embodiment they are all isocyanate reactive groups (which can be the

same or different); if they are all isocyanate reactive groups they are preferably either all OH or all -NHR (with R being the same or different).

The reactivity of the isocyanate reactive groups is as follows: $R_{aliphatic}$-$NH_2$ > $R_{2,aliphatic}$-NH > $R_{aromatic}$-$NH_2$ > $RCH_2$-OH > R2CH-OH > $R_3$C-OH If $X^2$ is an isocyanate reactive group it is not directly adjacent to a carbonyl group C=O.

$L^2$ in formula (II) is an aliphatic, aromatic, heterocyclic or heteroaromatic moiety, each of which being optionally substituted by one or more (preferably 1 to 10) substituents selected from halogen atoms and $R^{EG}$ as defined above, i.e. radical reactive groups (i), acidic groups (ii) or hydrophobic or hydrophilic groups (iii) (preferably selected from the group consisting of (i) and (ii)). $L^2$ does not contain urethane and urea linkages beside urea linkages in $L^2$ being part of cyanuric acid derivatives having the structural moiety

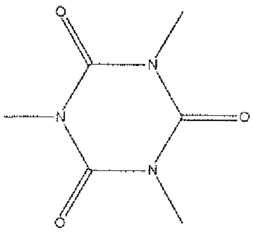
;

$L^2$ has a valence of n (which is an integer as defined above) and preferably a maximum number of carbon atoms (including any optional substituents) of 250, more preferably 100, even more preferably 50 and most preferably 30.

According to a preferred embodiment $L^2$ in formula (II) is represented by formula (II-1)

$$Z^1[-(Y^1\text{-}Y^2\text{-}Y^3]_{nx} \qquad \text{(II-1)}$$

wherein $Z^1$ is selected from $(C(R^a)_p)_{ny}$; $(-O)_3P=Y^4$ (with $Y^4$ being O or S); N;

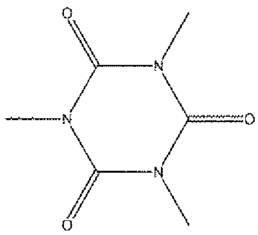
;
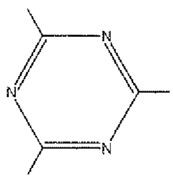
;

a 5-6 membered aromatic or saturated carbocyclic group; or a branched polyester moiety based on dimethylol propionic acid and a multivalent alcohol;

$Y^1$ and $Y^2$ are independently selected from single bond; -O-; -NR- with R being H, $C_{1-20}$ alkyl- or $C_{5-20}$ aryl; $-((CH_2)_q-CR^aH-O)_{ny}-$ ; divalent aromatic, heteroaromatic, heterocyclic or cyclic group or alkylene group, each being optionally substituted; $-C((-CR^aH)_{nz}-*)_2$, or $-CR^a((-CR^aH)_{nz}-*)$;
each $Y^1$ is independently selected from -*; $-(CH_2-CR^aH-O)_{ny}-*$; -T-* with T being a divalent aromatic, heteroaromatic, heterocyclic or cyclic group each optionally substituted by one or more substituents selected from halogen atoms and $C_{1-20}$ alkyl, or alkylene group, optionally substituted by one or more halogen atoms; or - $Z^2((-CR^aH)_{ny}-*)_2$ with $Z^2$ being CH or N; or $-Z^3((-CR^aH)_{ny}-*)_3$ with $Z^3$ being C;
each $R^a$ is independently selected from H or $C_{1-5}$ alkyl;
with each nz being an integer independently selected from 0 to 10; each ny being an integer independently selected from 1 to 10; each nx being an integer of at least 3 depending on the valency of $Z^1$;
p is 0 or 1 or 2; q is 0 or an integer from 1 to 5;
and * denotes the binding site of $X^2$;
with the proviso that $Z^1$, $Y^1$, $Y^2$ and $Y^3$ are selected such that $L^2$ of formula (II-1) does not contain

(1) an oxygen atom directly bonded to a nitrogen atom or another oxygen atom and
(2) a nitrogen atom directly bonded to another nitrogen atom.

More preferably Lof formula (II) is represented by a formula selected from (II-1') to (II-7')

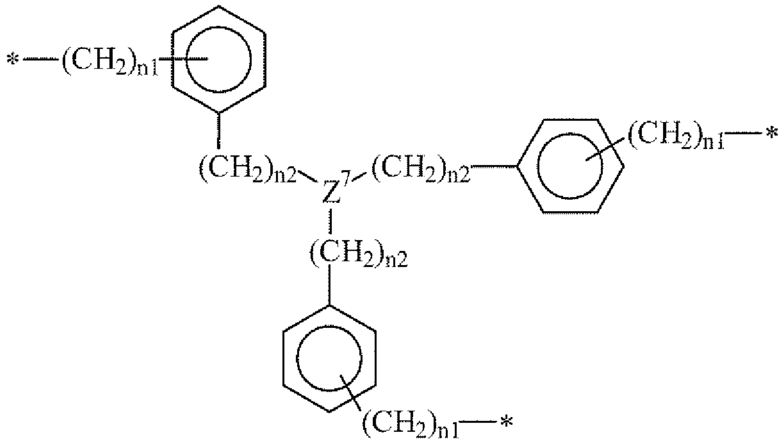

(II-1')

wherein $Z^7$ is $CR^4$,

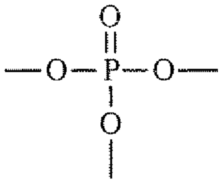

,

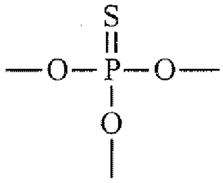

or N,
$R^4$ is H or $C_1$-$C_5$alkyl, preferably H or $CH_3$; each n1 is independently 0 or an integer of 1 to 10, preferably 0 to 6; each n2 is independently 0 or an integer of 1 to 10, preferably 0 to 6;
and * denotes the binding site of $X^2$;

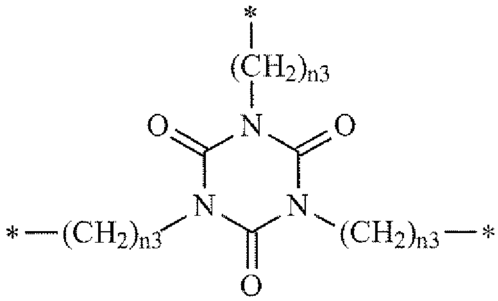

(II-2')

wherein each n3 is independently an integer of 2 to 10, preferably 2 to 6;
and * denotes the binding site of $X^2$;

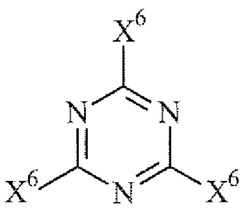

(II-3')

wherein each $X^6$ is independently -* or

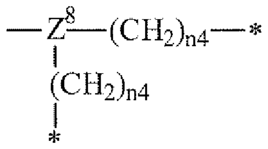

;

$Z^8$ is CH or N; n4 is an integer of 1 to 10, preferably 1 to 3; and * denotes the binding site of $X^2$;

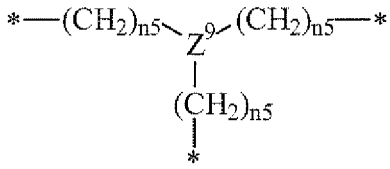

(II-4')

;

wherein $Z^9$ is $CR^4$ or N; $R^4$ is H or $C_1$-$C_5$alkyl, preferably H or $CH_3$; each n5 is independently 0 or an integer of 1 to 10, preferably 2 to 6; and * denotes the binding site of $X^2$;

$$(^*Y^{11})_3C[Y^{11}\text{-}O\text{-}Y^{11}\text{-}C(Y^{11}{}_*)2]_{n11}Y^{11*} \qquad \text{(II-5')}$$

wherein each $Y^{11}$ is independently selected from $-(CH_2)_{n6}-$ and $-(O-CH_2-CH_2)_{n7}-$ wherein the O atom is bonded to the C atom in formula (II-5'); n6 and n7 are independently 0 or an integer of 1 to 10, preferably 1 to 6; n11 is 0, 1 or 2; and * denotes the binding site of $X^2$;

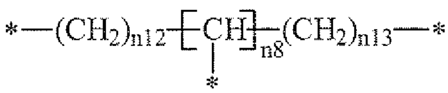

(II-6')

wherein n8 is an integer of 2 to 10, preferably 2 to 6; and * denotes the binding site of $X^2$; n12 and n13 are independently integers of 1 to 10 (preferably 1 to 5);

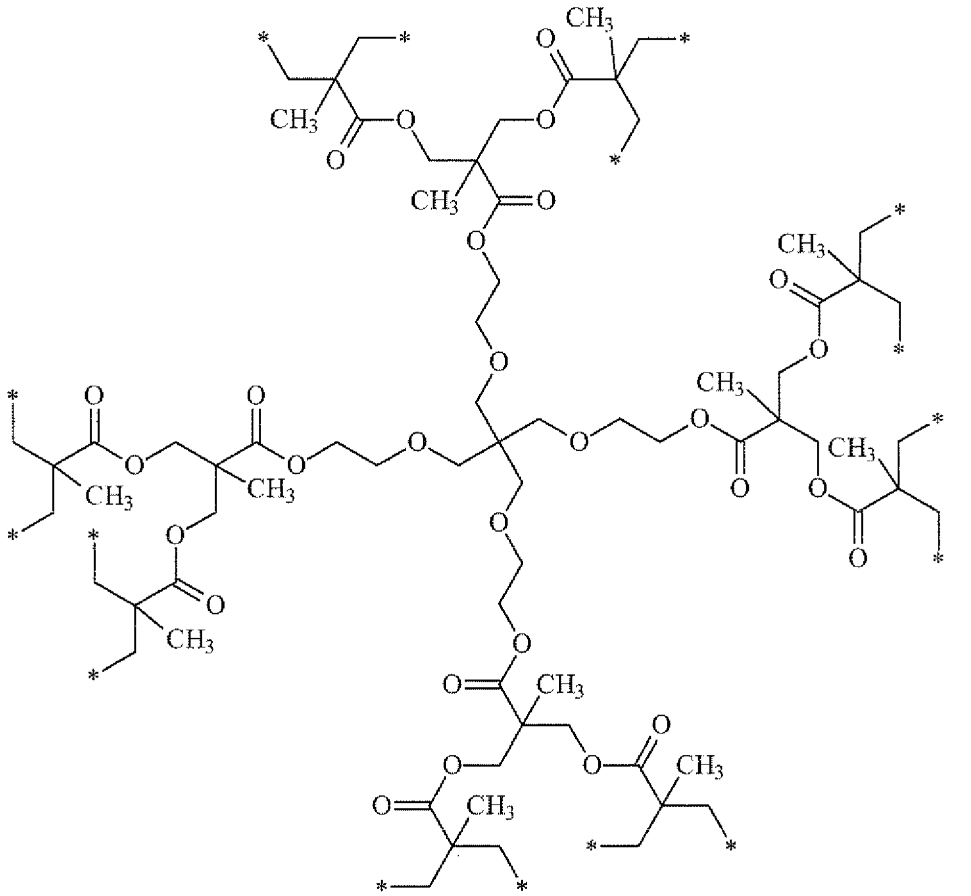

(II-7')

wherein * denotes the binding site of $X^2$.

It is further preferred that the branching unit precursor of formula (II) is at least one selected from group IIA consisting of:

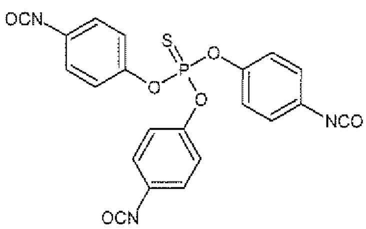
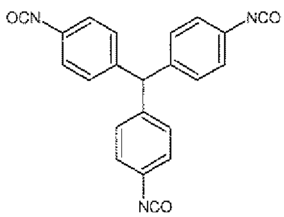
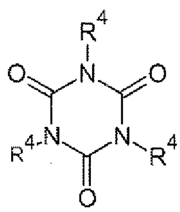
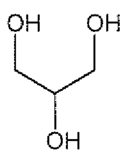

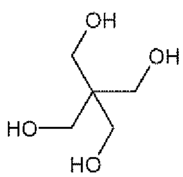
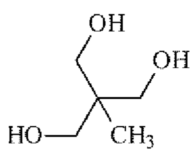
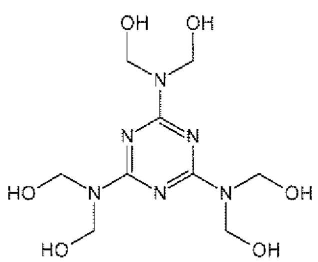

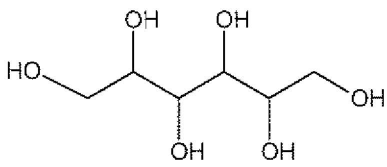

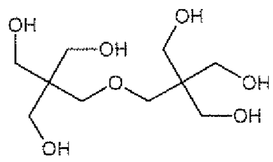

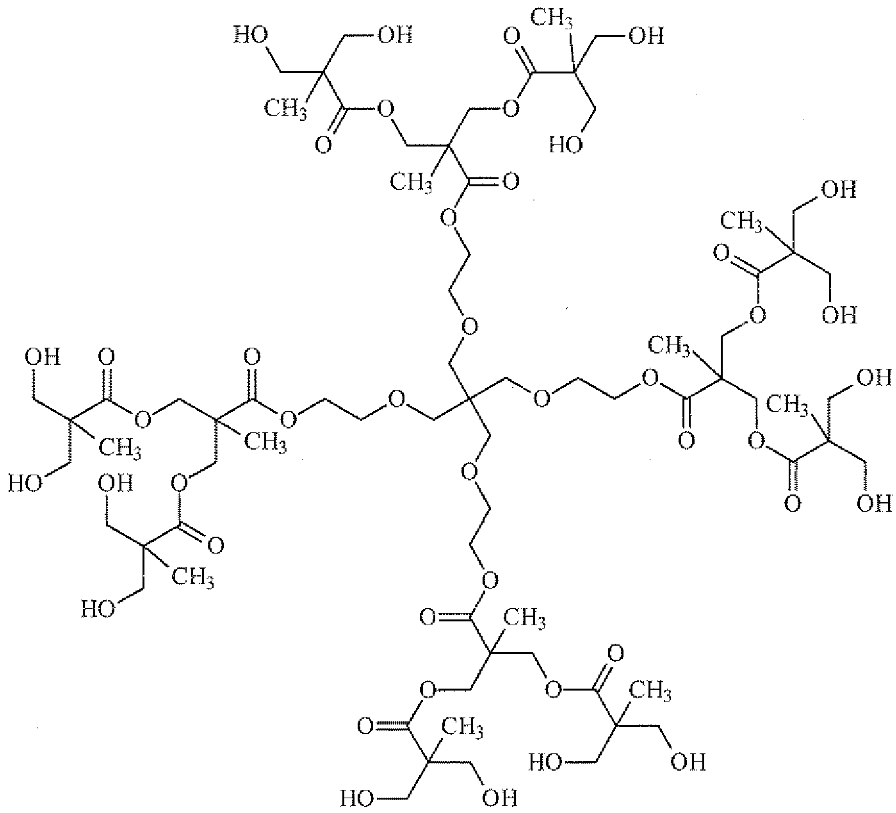

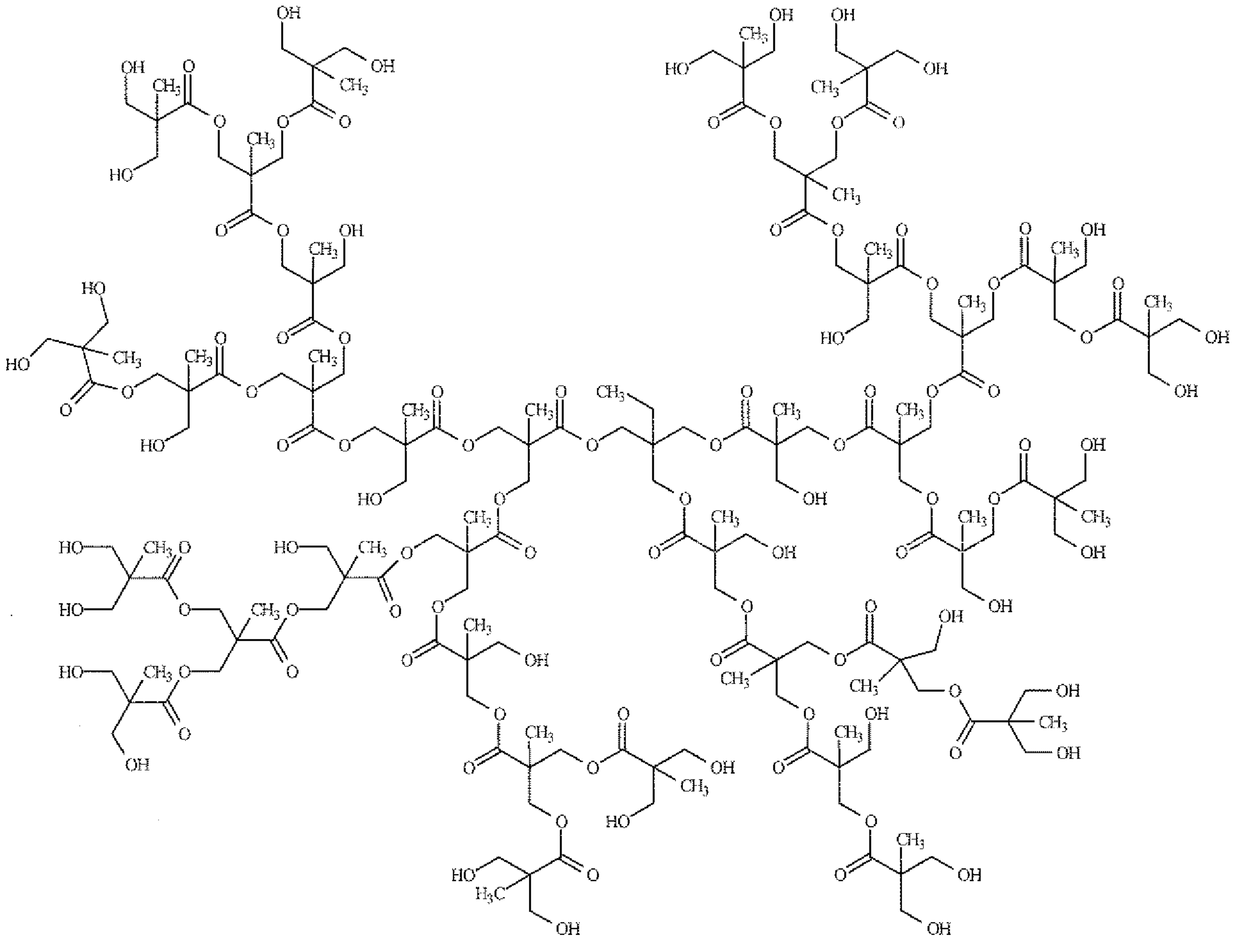

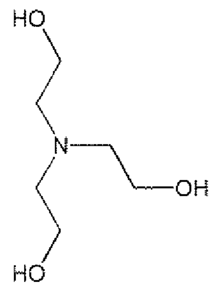

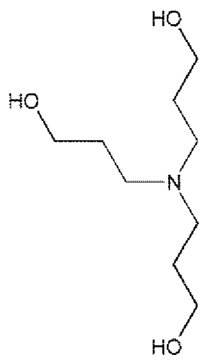

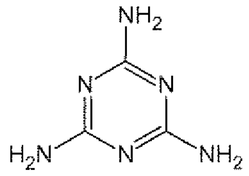

wherein each $R^4$ is $-(CH_2)_uNCO$ or $-(CH_2)_uOH$ with u being an integer of 2 to 10, preferably 2 to 6.

Examples of $L^2(X^2)_n$ are for instance those of group IIB consisting of:

(1) Trifunctional isocyanates like triphenylmethane-4,4',4"-triisocyanate, tris(p-isocyanatophenyl)thiophosphate, and isocyanurates of diisocyanates like isocyanurate of hexamethylene diisocyanate or isocyanurate of dimethylhexamethylene diisocyanate.

(2) Polyhydroxy or polyamino compounds having at least 3 OH or amino groups, respectively, like glycerol, erythritol, threitol, arabitol, xylitol, ribitol, pentaerythritol, trimethylolpropane, trimethylolethane, dipentaerythritol, tris(2-hydroxyethyl)isocyanurate, hexamethylol melamine, sorbitol, mannitol, lactitol, glucose, furanose, pyranose and hyperbranched polyester with OH-end-groups available from Perstorp (Boltorn H20 with 16 OH-groups, Boltorn H2003 with 12 OH-groups, Boltorn H30 with 32 OH-groups) and triethanol amine, tripropanol amine, diethylene triamine, triethylene tetramine, N,N,N',N'-tetrakis(2-hydroxypropyl) ethylenediamine, and melamine.

For the preparation of the branched binder material a spacer unit precursor of formula (III) is optionally used:

$$L^3(X^3)_2 \qquad (III)$$

It is also possible to use two or more different spacer unit precursors. The spacer unit precursors can be used as spacers between the end group moieties derived from precursors of formula (I) and the branching unit moieties derived from precursors of formula (II) and/or between different branching unit moieties derived from precursors of formula (II).

$X^3$ in formula (III) is independently selected from an isocyanate group and isocyanate reactive groups selected from the group consisting of -OH and -NHR (with R being defined as above for formulae (I) and (II)). The $X^3$ groups are either both isocyanate groups or both isocyanate reactive groups (which can be the same or different); if they are isocyanate reactive groups they are preferably either both -OH or both -NHR (with R being the same or different). If $X^3$ is an isocyanate reactive group it is not directly adjacent to a carbonyl group C=O.

$L^3$ in formula (III) is an aliphatic, aromatic, heterocyclic or heteroaromatic moiety, each of which being optionally substituted by one or more (preferably 1 to 10) substituents selected from the group consisting of halogen atoms, and $R^{EG}$ as defined above, i.e. radical reactive groups (i), acidic groups (ii) or hydrophobic or hydrophilic groups (iii) (preferably selected from the group consisting of (i) and (ii)). $L^3$ does not contain urethane and urea linkages besides urea linkages being part of cyanuric acid derivatives having the structural moiety

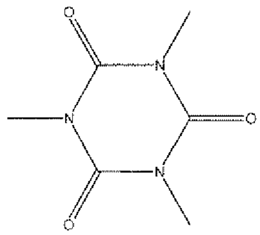
;

*$L^3$* has a valence of 2 and preferably a maximum number of carbon atoms (including any optional substituents) of 250, more preferably 100, even more preferably 50 and most preferably 30.

According to a preferred embodiment the spacer unit precursor is selected from diols, diamines, diisocyanates and amino alcohols.

According to a further preferred embodiment a spacer unit precursor of formula (III) is used which is at least one selected from group IIIA consisting of:

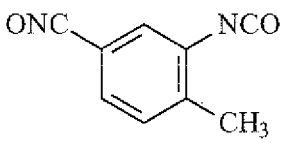
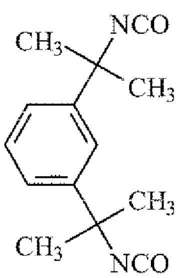
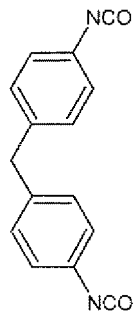
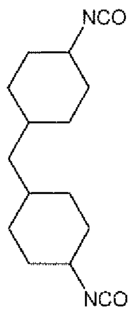

$OCN-(CH_2)_{a2}-NCO$; $OH-(CH_2)_{a3}-OH$; $OH-(CH_2CH_2-O)_{a4}-H$; $OH-(CH(CH_3)CH_2-O)_{a5}-H$; $OH-CH_2-C(CH_3)_2-CH_2-OH$

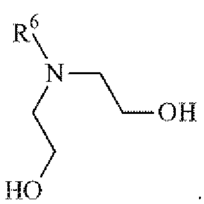
;

$H_2N-(CH_2)_{a6}-NH_2$; $H_2N-Aryl-NH_2$;

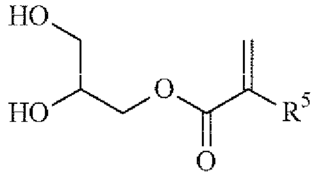

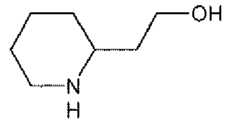

wherein a2 is an integer of 1 to 20; a3 is an integer of 1 to 20; a4 is an integer of 1 to 20; a5 is an integer of 1 to 20, preferably 1 to 15; a6 is an integer of 1 to 20; $R^5$ is H or $CH_3$; $R^6$ is $C_{1-20}$alkyl or $C_{5-20}$aryl,
"Aryl" is phenyl or naphthyl which may be optionally substituted with 1 to 5 substituents selected from $C_{1-50}$alkyl (preferably $C_{1-20}$alkyl), ar$C_{1-50}$alkyl (preferably ar$C_{1-20}$alkyl), halogen, and -Si$(R^z)_3$, with $R^z$ being $C_{1-10}$alkyl or $C_{1-10}$ alkoxy.

Examples of $L^3(X^3)_2$ are for instance those of group IIIB consisting of:

diisocyanates such as hexamethylene diisocyanate, dimethylhexamethylene diisocyanate, phenylene diisocyanate, toluene diisocyanate, diphenylmethane 1,4'-diisocyanate, diphenylmethan 4,4' diisocyanate, isophorondiisocyanate, diplienylsulfon-4,4'-diisocyanate, 4,4'-diisocyanato dicyclohexylmethane, tetramethylxylene diisocyanate, naphthylenediisocyanate, and 1,3-bis(isocyanatomethyl)cyclohexane;
diols such as ethylene glycol, propylene glycol, diethylene glycol, triethylene glycol, tetraethylene glycol, dipropylene glycol, tripropylene glycol, 1,4 butanediol, 1,3 butanediol, 1,6-hexanediol, cyclohexane dimethanol, hydroquinone bis(2-hydroxyethyl) ether, neopentyl glycol, polyethylene glycols, polypropylene glycols, polyesterdiols;
amino alcohols such as ethanolamine, methyldiethanolamine, and phenyldiethanolamine; diamines such as ethylene diamine, 1,2-diaminopropane, 1,3-diaminopropane, 1,4-diaminobutane, 1,5-diaminopentane, 1,2-diaminocyclohexane, 2,4-diaminotoluene, 4-aminobenzylamine, hexamethylene diamine, trimethylhexamethylenediamine, isophorone diamine, 4,4'-diaminodiphenylsulfon, 2,4-diaminopyrimidine, 2,5-diaminopyrimidine, 4,5-diaminopyrimidine, 4,6-diaminopyrimidine, and o-, m- or p-phenylene diamine or monoamides of carboxylic acids and diethylenetriamine or aromatic triamines.

(aa) According to one aspect the branched binder material comprises structural moieties derived from at least one end group precursor of formula (I).
(bb) According to one aspect the branched binder material comprises structural moieties derived from at least one end group precursor of formula (I-1).
(cc) According to one aspect the branched binder material comprises structural moieties derived from at least one end group precursor selected from those of formulae (I-1') to (I-8').
(dd) According to one aspect the branched binder material comprises structural moieties derived from at least one end group precursor selected from those of group IA defined above.
(ee) According to one aspect the branched binder material comprises structural moieties derived from at least one end group precursor selected from those of group IB defined above.
(ff) According to one aspect the branched binder material comprises structural moieties derived from at least one end group precursor as defined in any one of aspects (aa) to (ee) and at least one branching unit precursor of formula (II).
(gg) According to one aspect the branched binder material comprises structural moieties derived from at least one end group precursor as defined in any one of aspects (aa) to (ee) and at least one branching unit precursor of formula (II-1).
(hh) According to one aspect the branched binder material comprises structural moieties derived from at least one end group precursor as defined in any one of aspects (aa) to (ee) and at least one branching unit precursor selected from those of formulae (II-1') to (II-7').
(ii) According to one aspect the branched binder material comprises structural moieties derived from at least one end group precursor as defined in any one of aspects (aa) to (ee) and at least one branching unit precursor selected from those of group IIA defined above.
(jj) According to one aspect the branched binder material comprises structural moieties derived from at least one end group precursor as defined in any one of aspects (aa) to (ee) and at least one branching unit precursor selected from those of group IIB defined above.
(kk) According to one aspect the branched binder material comprises structural moieties derived from at least one

end group precursor as defined in any one of aspects (aa) to (ee) and at least one branching unit precursor as defined in any one of aspects (ff) to (jj) and at least one spacer unit precursor of formula (III), or those selected from group IIIA defined above or those selected from group IIIB defined above.

According to one embodiment the negative working lithographic printing plate precursor is UV/VIS-sensitive and the branched binder material is as defined in any one of items (aa) to (kk) above.

According to another embodiment the negative working lithographic printing plate precursor is IR-sensitive and the branched binder material is as defined in any one of items (aa) to (kk) above.

The branched binder material can be obtained by sequential addition of precursors in such a way that urethane or urea linkages are formed following a convergent mechanism comprising the following steps:

(A) simultaneous or sequential reaction of one or more end group precursors of formula (I), (I-1), (I-1') to (I-8'), group 1A or group IB with a branching unit precursor of formula (II), (II-1), (II-1') to (II-7'), group IIA or group IIB in a molar ratio of end group precursor to branching unit precursor of (n-1) : 1 to form the first intermediate with one of the n reactive groups $X^2$ of the branching unit precursor remaining unreacted, wherein n are the moles of $X^2$ per branching unit precursor molecule of formula $L^2(X^2)_n$;

(B) optional reaction of the first intermediate with another branching unit precursor of formula (II), (II-1), (II-1') to (II-7'), group IIA or group IIB in a molar ratio of first intermediate to other branching unit precursor of (n-1) : 1 to form the next intermediate with one of the n reactive groups $X^2$ of the other branching unit precursor remaining unreacted, and repetition of step (B) zero to five times to form a final intermediate;

(C) reaction of the first or final intermediate with a precursor of formula (I), (II), (III), (I-1), (II-1), (I-1') to (I-8'), (II-1') to (II-7'), group IA, IB, IIA, IIB, IIIA or IIIB in a molar ratio such that the number of equivalences of the isocyanate reactive groups is equal to or greater than the number of equivalences of the isocyanate groups,

(D) and optionally before step (A) and/or between steps (A) and (B) and/or between steps (B) and (C) and/or between different steps (B) reaction with spacer unit precursors of formula (III), group IIIA or group IIIB in a molar ratio of the respective intermediate/end group precursor to spacer unit precursor of 1 : 1 to form the next intermediate with one of the two reactive groups $X^3$ of the spacer unit precursor remaining unreacted,

with the proviso that in each reaction step (A) to (D) one reaction partner has isocyanate functionality and the other reaction partner has isocyanate-reactive functionality selected from -OH and -NHR, with R being $C_{1-20}$alkyl- or $C_{5-20}$aryl so that urethane or urea linkages are formed between the reaction partners.

According to one embodiment the binder material is obtained by carrying out steps A, B and C and optionally D (i.e. in step C the final intermediate of step B is further reacted).

If an end group precursor $L^1X^1$ is reacted with a branching unit precursor $L^2(X^2)_n$, $X^1$ is -OH or -NHR if $X^2$ is -NCO or $X^1$ is -NCO if $X^2$ is -OH or -NHR so that urethane/urea linkages are formed.

If an end group precursor $L^1X^1$ is first reacted with a spacer unit precursor $L^3(X^3)_2$ before the product of said reaction is reacted with a branching unit precursor $L^2(X^2)_n$, $X^1$, $X^2$ and $X^3$ are suitably selected so that in each reaction step urethane/urea linkages are formed:

(1) if $X^1$ is -OH or -NHR, $X^3$ is -NCO and $X^2$ then is -OH or -NHR
(2) if $X^1$ is -NCO, each $X^3$ is independently -OH or -NHR and $X^2$ then is -NCO

In other words the groups $X^1$, $X^2$, $X^3$ of the precursors used for the preparation of the branched binder material are for each step selected such that one reactant comprises -NCO and the other reactant comprises -OH and/or -NHR.

If in step (A) above two or more end group precursors of formula (I) are used it is preferred that in all end group precursors $X^1$ is -NCO (if $X^2$ in the branching unit precursor are -OH and/or -NHR) or $X^1$ in all end group precursors are isocyanate reactive groups independently selected from -OH and -NHR (if $X^2$ in the branching unit precursor are isocyanate groups).

If in step (A) two or more end group precursors are used they can be reacted with the branching unit precursor either simultaneously or subsequently.

If in step (A) two or more end group precursors are used the molar ratio of end group precursor to branching unit precursor of (n-1) : 1 refers to the total amount of all end group precursors to branching unit precursor.

In step (C) above the intermediate is preferably reacted with a precursor of formula (II), (II-1), (II-1') to (II-7'), group IIA, group IIB, (III), group IIIA, or group IIIB, more preferably a precursor of formula (II), (II-1), (II-1') to (II-7'), group IIA or group IIB.

The synthesis can be made in bulk, in solution or dispersion; the synthesis in a solvent dissolving both starting materials and products is preferred. The reactants are dissolved in aprotic, preferably polar organic solvents, medium concentrations (10 to 50 wt%, preferably 15 to 40 wt%) are preferred to avoid crosslinking reactions. Examples of suitable solvents are dimethylacetamide, dimethylformamide, n-methylpyrrolidone, dimethylsulfoxide, acetonitril, formamide, 1,4-dioxane, sulfolane, tetrahydrofuran and ethylacetate.

Reaction temperatures should remain low (0 to 30°C) in order to prevent radical reactions; if elevated temperatures are used radical inhibitors should be added in order to prevent radical reactions. Typically, a solution of the first branching unit precursor is placed in the reaction vessel and a solution of the end group precursor is added slowly. If more than one end group precursor is applied, they can be added simultaneously or subsequently; preferably the one with lower reactivity is added first, and the more reactive end group precursor is added after consumption of the first one. It is also possible to first react either the end group precursor or the first branching unit precursor with a spacer precursor before reacting the end group precursor and the first branching unit precursor. Next, a solution of a spacer unit may be added slowly if desired. After consumption, a solution of a second branching unit precursor may be added. An arbitrary number of spacers and branching unit precursors may be added adequately. Consumption of isocyanate groups may be followed by IR spectroscopy easily. After completion, methanol is added and stirred for some time to decompose isocyanate residues, if any. Part of the solvents may be removed by distillation. The obtained solution may be used as such in radiation sensitive coating solutions or the binder can be isolated as solid material by precipitation with a liquid that does not dissolve the product (e.g., water, methanol, hexane heptane, petrol ether) and adding the isolated binder then to the coating solution.

To avoid high reaction temperatures and prolonged reaction times which might cause undesired crosslinking, catalysts may be applied for the synthesis of HBB's in case of reaction of isocyanate and OH-group containing partners. Suitable catalysts may be amines or organometallic complexes. The amine catalysts are tertiary amines like triethylamine, 1,4-azabicyclo[2.2.2]octane, dimethylcyclohexylamine, tetra-methylbutanediamine, pentamethyldipropylenetriamine, 1,3,5-(tris(3-dimethylamino)propyl)-hexahydro-s-triazine, bis-(2-dimethylaminoethyl)ether, N-methylmorpholine, 1,8-diazabicyclo[5.4.0]undecene-7, pentamethyldiethylenetriamine, and benzyldimethylamine. Examples of organometallic catalysts are alkyl tin carboxylates like dibutyltin dilaurate, bismuth octanoate, phenylmercuric neodecanoate, bismuth or zinc carboxylates, dioctyltin mercaptide, dibutyltin oxide and metal acetylacetonates.

The formation of the branched binder material is preferably performed convergently (i.e. from outer shell to inner core). The basic principle necessary to avoid crosslinking reactions is to have in each growth step one compound with isocyanate group(s) and a reaction partner with isocyanate-reactive group, to control their amounts and the reaction temperature.

$X^1$, $X^2$, $X^3$ are selected such that urethane linkages (1) or urea linkages (2) are formed, i.e.

□-NCO + ■-OH → □-NH-CO-O-■ (1)

□-NCO + ■-NHR → □-NH-CO-NR-■ (2)

In Scheme 1 an example of the synthesis of a branched binder is shown. In this example 4 moles of triisocyanatophenyl thiophosphate (branching unit precursor; $X^2$ = -NCO, n=3) are reacted with 4 moles glycerol dimethacrylate (first end group precursor; $R^{EG}$ = $-OC(O)C(CH_3)=CH_2$; $X^1$ = OH); in a next step the resulting intermediate is reacted with 4 moles of glycolic acid (second end group precursor; $R^{EG}$ = COOH; $X^1$ = OH). In a third step the second intermediate is reacted with 1 mol of a further branching unit precursor, i.e. pentaerythritol ($X^2$ = OH, n = 4).

Although the stepwise reaction and the controlling of amounts of added precursors as well as the reaction conditions (relatively low temperature etc.) seem to result in the idealized product shown for instance in Scheme 1 (as confirmed by analysis) it cannot be excluded that a certain amount of other products is also obtained. Referring to Scheme 1 the first reaction can for instance result in statistical distribution of mono-(main product), di- and tri-urethane and some non-reacted triisocyanate will remain. When glycolic acid is added (step 2) and the polyhydroxy compound is added (step 3) again statistical distribution of the products is possible.

It is not within the present invention to produce and use monodisperse symmetric structures (= dendrimers) as this would require complex synthesis and intermediate isolating steps resulting in high costs which is contrary to the object of the present invention. The branched binder material used in the present invention is considered to be a hyperbranched binder material.

By using the convergent synthesis route described above crosslinking is avoided during the preparation of the hyperbranched binder material.

Scheme 1

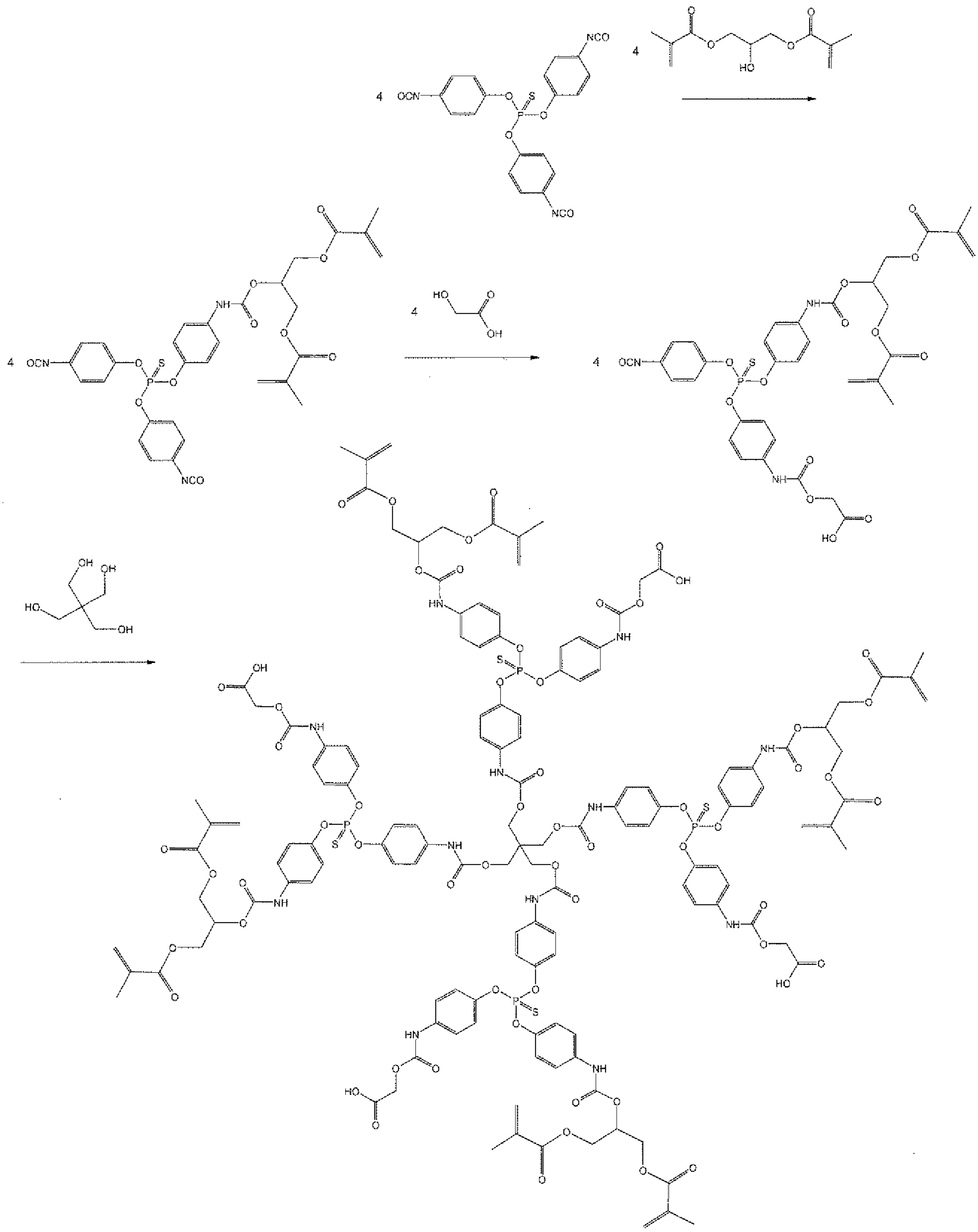

*Free- radical polymerizable component*

The radiation sensitive coating of the precursors of the present invention also comprises a free-radical polymerizable component having at least two free radically polymerizable groups per molecule and having a Tg < 30°C, preferably a free radical polymerizable component which is liquid or in viscous form at room temperature (25°C).

All monomers or oligomers which comprise at least two C-C double bonds and have a Tg < 30°C can be used. Suitable compounds are well known to the person skilled in the art and can be used in the present invention without any particular limitations. Esters of acrylic and methacrylic acids, itaconic acid, crotonic and isocrotonic acid, maleic acid and fumaric acid with one or more unsaturated groups in the form of monomers, oligomers or prepolymers are preferred. They may be present in liquid or viscous form. Compounds suitable as monomers include for instance trimethylol propane triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, ditrimethylol propane tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins. According to the present invention the free-radical polymerizable component is a compound with low molecular weight, i.e. a molecular weight of preferably below 3000.

Another class of free-radical polymerizable components is the class of urethane acrylates or urethane methacrylates. They are derived either from polyhydroxy compounds like pentaerythritol or glycerol that react with monoisocyanate having acrylate or methacrylates groups, e.g. like isocyanatoethyl methacrylate or isocyanatoethyl acrylate or from polyisocyanates that reacts with monohydroxy compounds carrying acrylate or methacrylate group. Examples for the latter type are adducts of 1 mole hexamethylene-1,6-diisocyanate and 2 moles hydroxyethyl methacrylate, adducts of 1 mole hexamethylene-1,6-diisocyanate and 2 moles glycerol dimethacrylate, adducts of 1 mole trimethylhexamethylene-1,6-diisocyanate and 2 moles hydroxyethylmethacrylate, and adducts of 1 mole of the biuret of hexamethylene-1,6-diisocyanate with 3 moles of hydroxycompounds having acrylate or methacrylate groups as disclosed in EP 1969426.

Another class of free-radical polymerizable components are compounds that have a molecular weight of 3,000 or less and are reaction products obtained by reacting a diisocyanate with (i) an ethylenically unsaturated compound with one hydroxy group, and at the same time (ii) a saturated organic compound with one NH group and one OH group as disclosed in EP 355387. A representative example for this type of polymerizable compound is the adduct of 2 moles of hexamethylene-1,6-diisocyanate, 1 mole of 2-(2-hydroxyethyl)piperidine and 2 moles of hydroxyethylmethacrylate as described in Preparation Example 1 of US 7,574,959.

It is of course possible to use different kinds of monomers or oligomers in the coating; furthermore, mixtures of monomers and oligomers can be used in the present invention.

According to the present invention the radiation sensitive coating comprises a free-radical polymerizable component as defined above with a softening point of less than 30°C; according to one embodiment the free-radical polymerizable component is preferably used in an amount of 5 to 70 wt wt-%, based on the dry layer weight of the imageable coating, especially preferred 10 to 50 wt-%.

Any aspect, or preferred aspect described for the free-radical polymerizable component can be combined with any aspect, or preferred aspect of the branched binder material described above (in particular items (aa) to (kk) above) and/or any aspect or preferred aspect of the radical forming component described above and/or any aspect or preferred aspect of the substrate described above.

*Optional other Binders*

Suitable optional other polymer binders are e.g. polymers/copolymers which do not contain radically polymerizable groups and are soluble or dispersible in aqueous alkaline developer, such as e.g. phenolic resins such as novolaks and resols, and copolymers of (meth)acrylic acid, N-phenylmaleimide and (meth)acrylamide (see DE 199 36 331) or polymers/copolymers which contain radically polymerizable groups but which are different from the branched binder material described above.

The total amount of optional further binders is preferably 0 to 30 wt%, based on the dry layer weight of the radiation-sensitive coating; according to one embodiment an optional further binder is present but its amount does not exceed 40 wt% based on the dry layer weight of the radiation-sensitive coating and according to another embodiment no such optional further binder is present.

Useful are for instance random copolymers derived from polyethylene glycol methacrylate/acrylonitrile/styrene monomers in random fashion and in particulate form, dissolved random copolymers derived from carboxyphenyl methacrylamide/acrylonitrile/- methacrylamide/N-phenyl maleimide, random copolymers derived from polyethylene glycol methacrylate/acrylonitrile/vinyl carbazole/styrene/-methacrylic acid, random copolymers derived from N-phenyl maleimide/methacrylamide/methacrylic acid, random copolymers derived from urethane-acrylic intermediate A (the reaction product of *p*-toluene sulfonyl isocyanate and hydroxyl ethyl methacrylate)/acrylonitrile/N-phenyl maleimide, and random copolymers derived from N-methoxymethylmethacrylamide/methacrylic acid/acrylonitrile/*n*-phenylmaleimide. By "random" copolymers, we mean the conventional use of the term, that is, the structural units in the polymer hydrophobic backbone that are derived from the monomers are arranged in random order as opposed to being block copolymers, although two or more of the same structural units can be in a chain incidentally.
Other useful polymeric binders can be selected from those described below that is not an exhaustive list:

I. Polymers formed by polymerization of a combination or mixture of (a) (meth)acrylonitrile, (b) poly(alkylene oxide) esters of (meth)acrylic acid, and optionally (c) (meth)acrylic acid, (meth)acrylate esters, styrene and its derivatives, and (meth)acrylamide as described for example in U.S. Patent 7,326,521 (Tao et al.). Some particularly useful polymeric binders in this class are derived from one or more (meth)acrylic acids, (meth)acrylate esters, styrene and its derivatives, vinyl carbazoles, and poly(alkylene oxide) (meth)acrylates.

II. Polymers having pendant allyl ester groups as described in U.S. Patent 7,332,253 (Tao et al.). Such polymers can also include pendant cyano groups or have recurring units derived from a variety of other monomers as described in Col. 8, line 31 to Col. 10, line 3 of the noted patent.

III. Polymers having all carbon backbones wherein at least 40 mol % and up to and including 100 mol % (and typically at least 40 mol % and up to and including 50 mol %) of the carbon atoms forming the all carbon backbones are tertiary carbon atoms, and the remaining carbon atoms in the all carbon backbone being non-tertiary carbon atoms. Further details of such polymeric binders are provided in U.S. Patent Application Publication 2008-0280229 (Tao et al.).

IV. Polymeric binders that have one or more ethylenically unsaturated pendant groups (reactive vinyl groups) attached to the polymer backbone. Such reactive groups are capable of undergoing polymerizable or crosslinking in the presence of free radicals. The pendant groups can be directly attached to the polymer backbone with a carbon-carbon direct bond, or through a linking group ("X") that is not particularly limited. The reactive vinyl groups can be substituted with at least one halogen atom, carboxy group, nitro group, cyano group, amide group, or alkyl, aryl, alkoxy, or aryloxy group, and particularly one or more alkyl groups. In some embodiments, the reactive vinyl group is attached to the polymer backbone through a phenylene group as described, for example, in U.S. Patent 6,569,603 (Furukawa et al.). Other useful polymeric binders have vinyl groups in pendant groups that are described, for example in EP 1,182,033A1 (Fujimaki et al.) and U.S. Patents 4,874,686 (Urabe et al.), 6,916,595 (Fujimaki et al.), and 7,041,416 (Wakata et al.), especially with respect to the general formulae (1) through (3) noted in EP 1,182,03 3A1.

V. Polymeric binders can have pendant 1H-tetrazole groups as described in U.S. Patent Application Publication 2009-0142695 (Baumann et al.).

VI. Still other useful polymeric binders include but are not limited to, (meth)acrylic acid and acid ester resins [such as (meth)acrylates], polyvinyl acetals, phenolic resins, polymers derived from styrene, N-substituted cyclic imides or maleic anhydrides, such as those described in EP 1,182,033 (noted above) and U.S. Patents 6,309,792 (Hauck et al.), 6,352,812 (Shimazu et al.), 6,569,603 (noted above), and 6,893,797 (Munnelly et al.). Also useful are the vinyl carbazole polymers described in U.S. Patent 7,175,949 (Tao et al.).

Other useful polymeric binders are particulate poly(urethane-acrylic) hybrids that are distributed (usually uniformly) throughout the imageable layer. Each of these hybrids has a molecular weight of at least 50,000 and up to and including 500,000 and the particles have an average particle size of at least 10 and up to and including 10,000 nm (typically at least 30 and up to and including 500 nm).
Any aspect or preferred aspect described for the optional non-reactive binder can be combined with any aspect or preferred aspect of the branched binder material and/or radical forming component and/or substrate described above.

*Further optional components*

Independently of whether the element is UV/VIS- or IR-sensitive, the radiation-sensitive coating can further comprise one or more of the following optional components in addition to the above-mentioned essential and optional components. Dyes or pigments having a high absorption in the visible spectral range can be present in order to increase the contrast ("colorants"). Particularly suitable dyes and pigments are those that dissolve well in the solvent or solvent mixture used for coating or are easily introduced in the disperse form of a pigment. Suitable contrast dyes include *inter alia* rhodamine dyes, triarylmethane dyes such as Victoria blue R and Victoria blue BO, crystal violet and methyl violet, anthraquinone pigments, azo pigments and phthalocyanine dyes and/or pigments. The colorants are preferably present in an amount of 0 to 15 wt-%, more preferred 0.5 to 10 wt-%, particularly preferred 1.5 to 7 wt-%, based on the dry layer

weight.

Furthermore, the layer can comprise surfactants (e.g. anionic, cationic, amphoteric or non-ionic surfactants or mixtures thereof). Suitable examples include fluorine-containing polymers, polymers with blocks of ethylene oxide and/or propylene oxide, sorbitol-tri-stearate and alkyldi-(aminoethyl)-glycines. They are preferably present in an amount of 0 to 10 wt-%, based on the dry layer weight, especially preferred 0.2 to 5 wt-%.

The layer can furthermore comprise print-out dyes such as crystal violet lactone or photochromic dyes (e.g. spiropyrans etc.). They are preferably present in an amount of 0 to 15 wt-%, based on the dry layer weight, especially preferred 0.5 to 5 wt-%.

Also, flow improvers can be present in the layer(s), such as poly(glycol)ether-modified siloxanes; they are preferably present in an amount of 0 to 1 wt-%, based on the dry layer weight.

The layer(s) can furthermore comprise antioxidants such as e.g. mercapto compounds (2-mercaptobenzimidazole, 2-mercaptobenzthiazole, 2-mercaptobenzoxazole and 3-mercapto-1,2,4-triazole), and triphenylphosphate. They are preferably used in an amount of 0 to 15 wt-%, based on the dry layer weight, especially preferred 0.5 to 5 wt-%. The presence of mercapto compounds is especially preferred for UV-sensitive elements of the present invention.

The layer(s) can furthermore comprise anaerobic or aerobic radical polymerization inhibitors. The anaerobic free radical inhibitors function different from aerobic inhibitors in the absence of oxygen because they are able to react directly with the free radicals. Useful compounds of this type include nitroso compounds (both N- and C-nitroso), N-oxides, and hydroxylamine derivatives. Typical examples include but are not limited to:

C-nitroso compounds such as $C_4$ to $C_{10}$ nitroso alkanes (for example, *t*-nitrosobutane and *t*-nitrosoctane), aromatic C-nitroso compounds (for example, nitrosobenzene, 2-nitrosotoluene, nitrosodurene, 4-nitrosophenol, 1-nitroso-2-naphthole, 2-nitroso-1-naphthole, 4-nitrosodiphenylamine, 3,5-dibromo-4-nitrosobenzenesulfonic acid or salt, and 2-methyl-2-nitrosopropane dimer);

N-nitroso-compounds such as N-nitroso-N-phenyl hydroxylamine and their complexes with cations ($[PhN(NO)O]_mM1$ wherein MI is ammonium ion, or metal ions of the 3rd-6th period elements of the Groups I-VIII of the Periodic Table, and m is 1 to 4), N-nitrosodiphenylamine, N-nitrosopyrrolidine, N-*t*-butyl-N-nitrosoaniline, N-nitrosodimethylamine, N-nitrosodiethylamine, 1-(aminocarbonyl)-1-methyl-2-oxohydrazine, 1-nitrosopiperidine, 4-nitrosomorpholine, N-nitroso-N-methylbutylamine, N-nitroso-N-ethylurea, and N-nitrosohexamethyleneimine; N-oxides such as 5,5-dimethyl-1-pyrroline N-oxide, α-(4-pyridyl N-oxide)-N-*t*-butylnitrone, N-*t*-butyl-α-phenylnitrone, and 3,3,5,5-tetramethyl-1-pyrroline N-oxide;

hydroxylamine derivatives such as 1-hydroxy-2,2,6,6-tetramethyl-4-piperidone,

The N-nitroso compounds are particularly useful, including N-nitroso-N-phenyl hydroxylamine and their aluminum or sodium complexes.

The aerobic free radical inhibitors can function as an inhibitor in a free radical polymerizable composition only in the presence of oxygen. These inhibitors have a low inhibiting efficiency in the absence of oxygen. Typical representatives of aerobic free radical inhibitors include phenolic compounds such as phenols including sterically hindered phenols. Examples include but are not limited to, hydroquinone, 4-methoxyphenol (MEHQ), 2,6-di-tert-butyl-4-methylphenol (BHT), 4,4'-bis(2,6-di-tert-butylphenol), 1,3,5-trimethyl-2,4,6-tris(3,5-di-tert-butyl-4-hydroxybenzyl)-benzene, and 3,5-di-tert-butyl-1,2-benzenediol.

A combination of aerobic and anaerobic inhibitors as disclosed in EP 2310909 gives advantage in some cases.

The concentrations of each of the aerobic and anaerobic free radical inhibitors in the radiation-sensitive composition or imageable layer - if present at all - are independently from about 0.001 to about 2 weight %, or from about 0.003 to about 0.5 weight % based on the total dry weight. The molar ratio of the aerobic free radical inhibitor to the anaerobic free radical inhibitor is preferably from about 1:1 to about 200:1.

The layer(s) may furthermore comprise inorganic particles such as surface-modified fumed silica particles and sol-gel silica particles such as disclosed in EP 2260351, that - if present at all - are present in an amount of from about 1 to about 40 weight %, and preferably have an average particle size of from about 1 to about 500 nm. The presence of the surface-modified silica particles may provide improved abrasion resistance, reduced tackiness, and various other desired properties.

*Overcoat as Oxygen-barrier*

An oxygen-impermeable overcoat ("oxygen barrier layer") can be applied over the radiation sensitive coating; "oxygen-impermeable" does not necessarily mean "impermeable to 100 %" but sufficient for protecting the coating from atmospheric oxygen during storage, exposure and in particular during the time between exposure and further processing in order to avoid undesired image loss. During that time the overcoat has to exhibit sufficient adhesion to the radiation-sensitive coating so that safe handling (manufacture, packing, transport, exposure etc.) is guaranteed without tearing

of the layers. In addition to its function as oxygen barrier layer the overcoat also protects the radiation sensitive coating from fingerprints and mechanical damage like scratches.

A number of water-soluble polymers are described in the literature as being suitable for such overcoats. Suitable examples are polyvinyl alcohol; partly saponified polyvinyl acetate having a saponification degree of from 70 to 99% and which can also contain vinylether and vinylacetal units; polyvinyl pyrrolidone and copolymers thereof with vinyl acetate and vinyl ethers; hydroxy alkyl cellulose; gelatin; polyacrylic acid; gum Arabic; polyacryl amide; dextrin; cyclodextrin; copolymers of alkylvinyl ethers and maleic acid anhydride; as well as water-soluble high molecular polymers of ethylene oxide having molecular weights of above 5,000 are particularly suitable. Polyvinyl alcohol is a preferred overcoat polymer.

In some application it is desired to remove the overcoat during processing of the exposed lithographic plates not in a separate prewash step but together with the non-image areas in the developing step. This type of processing requires high solubility of the overcoat polymer in the developer. It was found that using PVA with acidic side groups like carboxylic acid or sulfonic acid groups (JP2009086514) or hydrophilic side groups like glycol groups (US7928166) or alkylene oxide side chains (EP2275258) in the overcoat results in clean processing at high loading rates.

To improve the adhesion of a PVA overcoat to the photopolymer layer basic adhesion promoters like poly(1-vinylimidazole) or a copolymer of 1-vinyl-imidazole as described in WO 99/06890 or polyvinyl pyrrolidone (or a copolymer thereof) can be added in an amount of e.g. 2 to 30%.

Also polyvinyl alcohol in combination with poly(1-vinylimidazole) or a copolymer of 1-vinyl-imidazole and at least one further monomer as described in WO 99/06890 can be used.

Also polyvinyl alcohol in combination with poly(1-vinylimidazole) or a copolymer of 1-vinyl-imidazole and at least one further monomer as described in WO 99/06890 can be used.

Overcoats are also described in US 3,458,311, US 4,072,527, US 4,072,528, EP 275 147 A1, EP 403 096 A1, EP 354 475 A1, EP 465 034 A1 and EP 352 630 A1.

In a preferred embodiment the overcoat comprises polyvinyl alcohol or polyvinyl alcohol in combination with poly(vinyl pyrrolidone) (or a copolymer thereof).

Suitable polyvinyl alcohols are commercially available at inexpensive prices. They usually have a residual content of acetate groups in the range of 0.1 to 30 wt-%. Especially preferred are polyvinyl alcohols obtained from polyvinylacetate with a residual acetate content of 0.5 to 22 wt-%. By means of the molecular weight of the used polyvinyl alcohols, adhesion and water-solubility of the overcoats can be controlled. A lower molecular weight promotes the removal of the overcoat with aqueous solutions.

The water-soluble overcoats can be applied by means of surface coating methods known to the skilled practician such as doctor blade coating, roller coating, slot coating, curtain coating, spray or dipping processes. Dry layer weights of from 0.05 to 10 $g/m^2$, more preferably 0.2 to 5 $g/m^2$, most preferably 0.3 to 3 $g/m^2$ are suitable.

In many cases it is favorable to apply the water-soluble overcoats in an aqueous solution. This has the least detrimental effects on the environment and the human body.

For some applications, however, it can also be favorable to use organic solvents. In some substrates the addition of 0.5 to 60 wt-% of an organic solvent to the aqueous coating solution improves adhesion. By means of a slight solvation of the surface to be overcoated, the adhesive effect of the polymers of the overcoats according to the present invention is increased further. Such additives to solvents can e. g. be alcohols or ketones.

For a uniform and rapid wetting of the surface to be coated, anionic, cationic or non-ionic wetting agents may be added to the coating solutions. The overcoat furthermore can comprise stabilizers, preservatives, dyeing agents, foam separators and rheological additives.

Any aspect or preferred aspect of the overcoat can be combined with any aspect or preferred aspect described above for the substrate and/or radical forming component and/or branched binder material and/or optional components like for instance free-radical polymerizable components and binders different from the essential branched binder material according to the present invention.

*IMAGEWISE EXPOSURE*

If the absorber component used in the photopolymerizable coating absorbs UV/VIS radiation, the precursors are imagewise exposed in a manner known to the person skilled in the art with UV/VIS radiation of a wavelength of 300 to 750 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 ± 10 nm), argon ion lasers emitting in the visible range (488 nm or 514 nm) and frequency-doubled fd:Nd:YAG lasers emitting at around 532 nm are of particular interest as a radiation source. The laser radiation can be digitally controlled via a computer, i.e. it can be turned on or off so that an imagewise exposure of the plates can be effected via stored digitized information in the computer; this way, so-called computer-to-plate (ctp) printing plates can be obtained.

If the absorber component absorbs IR radiation, i.e. noticeably absorbs radiation of a wavelength in the range

of more than 750 to 1,200 nm, and preferably shows an absorption maximum in this range in its absorption spectrum, imagewise exposure can be carried out with IR radiation sources. Suitable radiation sources are e.g. semi-conductor lasers or laser diodes which emit in the range of 750 to 1200 nm, for example Nd:YAG lasers (1,064 nm), laser diodes which emit between 790 and 990 nm, and Ti:sapphire lasers. The laser radiation can be digitally controlled via a computer, i.e. it can be turned on or off so that an imagewise exposure of the plates can be effected via stored digitized information in the computer; this way, so-called computer-to-plate (ctp) printing plates can be obtained. Any image-setters equipped with IR lasers that are known to the person skilled in the art can be used.

The imagewise exposed precursor comprises exposed and unexposed areas of the coating.

To strengthen the image the exposed plate precursor can be optionally heated to 60 to 150°C in a separate oven or in a unit being part of a processor to develop the plate.

*PROCESSING OF THE EXPOSED PRECURSOR*

After imagewise exposure the precursor is treated with the developer in order to remove the coating in the non-image (i.e. non-exposed) areas thereby revealing the substrate in said areas.

If the precursor comprises an overcoat which protects the radiation sensitive coating, the overcoat can be removed by washing/rinsing with water before applying the developer. According to one embodiment the overcoat is not removed in a separate step but is removed together with the non-image areas of the radiation sensitive coating in a single step by treating the exposed precursor with a suitably selected developer.

After removing the non-image areas of the coating (and optionally the overcoat) with the developer, the treated precursor can be dried.

According to another embodiment after removing the non-image areas of the coating (and optionally the overcoat) with the developer, the treated precursor can be rinsed with water.

According to a further embodiment after removing the non-image areas of the coating (and optionally the overcoat) with the developer and rinsing the precursor with water it is possible to apply a hydrophilic finishing gum.

According to one embodiment treating an exposed precursor with a developer results in (1) removing of the overcoat in the exposed and unexposed areas (if an overcoat is present at all or was not removed before the treatment with the developer), (2) removing of the non-image areas of the radiation sensitive coating, and (3) providing of a protective gumming in one single step provided that the developer is selected accordingly.

Typically, the exposed precursor is contacted with the developer by rubbing or wiping the imageable layer with an applicator containing this liquid. Alternatively, the exposed precursor may be brushed with the developer or the developer may be applied to the precursor by spraying. The treatment with the developer can also be carried out by immersing the exposed precursor in a bath of the developer. According to one embodiment, the processing may be carried out in a commercially available processor, such as TDP 60 (Horsell) which contains only one bath for the developer and a drying section. Additionally, a conductivity-measuring unit can be incorporated into the processor.

According to another embodiment, conventional processors equipped with an immersion type developing bath, a section for rinsing with water, a gumming section, and a drying section, can be used. Additionally, a conductivity-measuring unit can be incorporated into the processor for controlling the developer activity of the developer.

The exposed precursor is typically treated with the developer at a temperature of 18°C to about 28°C, for a period of about 5 seconds to about 60 seconds.

After a certain number of exposed precursors have been processed, the developing activity (for instance measured by titration or conductivity measurement) of a developer bath falls below a predetermined level. Then fresh developer is added to the bath (also called "top-up" process). Usually about 10 mL to about 200 mL, typically about 20 -120 mL, of fresh developer per 1 $m^2$ of precursor processed is necessary to keep both the volume of developer and its activity/conductivity value constant. The processed lithographic printing plate comprises regions in which the imageable layer has been removed revealing the underlying surface of the hydrophilic substrate, and complimentary regions in which the imageable layer has not been removed. The regions in which the imageable layer has not been removed are ink receptive.

Instead of adding fresh developer for keeping the activity of the developer bath constant a regenerator can be added. The regenerator suitably differs from the fresh developer in that the concentration of the alkaline reagent is higher compared to the concentration of the alkaline reagent in the fresh developer used; the concentration of the other components might be the same or higher as in the fresh developer.

After having contacted the precursor with the developer any excess of said developer remaining on the precursor is removed (for instance by means of squeeze rollers; washing/rinsing the precursor with a liquid like water etc). After a subsequent optional drying step the processed precursor can be transferred to the press. On the press the processed precursor is contacted with fountain solution and printing ink, either simultaneously or subsequently (in any order, but preferably first fountain solution and thereafter ink). By contacting the precursor with the fountain solution and ink and thereafter with paper any remainders of undesired coating (radiation-sensitive coating in the non-image areas and/or

overcoat) which have not already been removed by the treatment with the developer are removed.

*Developer*

The developer used in the method of the present invention is an aqueous solution having a pH value of >5, preferably a pH of from 7.5 to 13.5, more preferably a pH of from 8 to 12.

*Water*

Tap water, deionized water or distilled water can be used. The amount of water is preferably in the range of 45 to 98 wt-%, based on the total weight of the developer, especially preferred 50 to 95 wt-% and particularly preferred 80 to 95 wt-%.

*Alkaline component*

The developer used in the present invention may comprise an organic or inorganic alkaline component.

The alkaline component can for instance be selected from alkali silicates, alkali hydroxides, $Na_3PO_4$, $K_3PO_4$, $NR_4OH$, wherein each R is independently selected from $C_1$-$C_4$ alkyl groups and $C_1$-$C_4$ hydroxyalkyl groups, amines and mixtures of 2 or more of the foregoing.

The amount of the alkaline component, or in case of mixtures the total amount of the alkaline components, is preferably selected such that the pH value of the developer is >5 to 14, preferably, the pH is in the range of 7.5 to 13.5, more preferably in the range of 8 to 12.

As used in the present invention, the term "alkali silicates" also encompasses metasilicates and water glasses. Sodium silicates and potassium silicates are preferred silicates. When alkali silicates are used, the amount of silicate is preferably at least 1 wt-% (calculated as $SiO_2$), based on the developer.

Of the alkali hydroxides, NaOH and KOH are especially preferred.

Usually the use of alkali metasilicates readily provides a pH value of more than 12 without further alkaline additives such as e.g. alkali hydroxide. When water glass is used, an alkali hydroxide is used in addition if a pH value of more than 12 is desired.

Preferred quaternary ammonium hydroxides $NR_4OH$ include for example tetramethyl ammonium hydroxide, trimethylethanol ammonium hydroxide, methyltriethanol ammonium hydroxide and mixtures thereof; an especially preferred ammonium hydroxide is tetramethyl ammonium hydroxide.

Suitable amines are primary, secondary and tertiary amines. Examples are mono-, di-, and trialkanol amines like monoethanol amine, diethanol amine, triethanolamine, (2-aminoethoxy)ethanol, 2-amino-2-methyl-1-propanol, 1-aminopropanol, diisopropanol amine, 2-(methylamino) ethanol, and triisopropanol amine. Monoethanol amine, diethanol amine, triethanolamine are most preferred.

The preferred alkaline compound is an amine as defined above.

*Surfactant*

An optional component of the developer used in the present invention is the surfactant.

The surfactant is not specifically limited as long as it is compatible with the other components of the developer and soluble in aqueous alkaline solutions with a pH of >5. The surfactant can be a cationic, an anionic, an amphoteric or a nonionic one.

Examples of anionic surfactants include hydroxyalkanesulfonates, alkylsulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylethers, salts of phosphoric esters of polyoxyethylenealkylphenylethers, partially saponified compounds of styrenemaleic anhydride copolymers, partially saponified compounds of olefin-maleic anhydride copolymers, naphthalenesulfonateformalin condensates, sodium dodecylphenoxybenzene disulfonates, the sodium salts of alkylated naphthalenesulfonate, disodium methylene-dinaphtalene-disulfonate, sodium dodecyl-benzenesulfonate, (di)sulfonated alkyldiphenyloxides, ammonium or potassium perfluoroalkylsulfonates and sodium dioctyl-sulfosuccinate.

Particularly preferred among these anionic surfactants are alkylnaphthalenesulfonates, disulfonated alkyldiphenyloxides, and alkylsulfonates.

Suitable examples of the nonionic surfactants include polyoxyethylene alkyl ethers, polyoxyethylene phenyl ethers, polyoxyethylene 2-naphthyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolamine aliphatic esters, alkoxylated aromatic compounds and trialkylamine oxides. Particularly preferred among these nonionic surfactants are alkoxylated aromatic compounds like polyoxyethylene phenyl ethers, polyoxyethylene-2-naphthyl ethers as disclosed in EP 1172699, polyoxyethylene di-styryl phenyl ether and polyoxyethylene tri-styryl phenyl ether as disclosed in EP 1722275.

Further, fluorine containing and silicone anionic and nonionic surfactants may be similarly used.

Amphoteric surfactants are for example N-alkylamino acid triethanol ammonium salts, cocamidopropyl betaines, cocamidoalkyl glycinates, sodium salt of a short chain alkylaminocarboxylate, N-2-hydroxyethyl-N-2-carboxyethyl fatty acid amidoethylamin sodium salts, and carboxylic acid amidoetherpropionates; preferred are cocamidopropylbetaines.

Examples of cationic surfactants are tetraalkyl ammoniumchlorides like tetrabutyl ammoniumchloride and tetramethyl ammoniumchloride, and polypropoxylated quaternary ammonium chlorides.

Nonionic, anionic and amphoteric surfactants as well as mixtures thereof are preferred.

It is preferred that the developer used in the present invention comprises at least one member selected from surfactants and alkaline components.

Two or more of the above surfactants may be used in combination. The amount of the surfactant (or total amount of surfactants if more than one is used) is not specifically limited but is preferably from 0.01 to 20 wt-%, more preferably from 2 to 8 wt-% based on the total weight of the developer.

*Water-soluble film forming hydrophilic polymer*

One optional component of the developer is a water-soluble film forming hydrophilic polymer. The use of such a polymer is especially suitable if a "single step processing" (i.e. developing and gumming in one process step) is desired.

Examples of suitable polymers are gum arabic, pullulan, cellulose derivatives such as hydroxymethyl celluloses, carboxymethylcelluloses, carboxyethylcelluloses or methylcelluloses, starch derivatives like (cyclo)dextrins, polyvinyl alcohol), poly(vinyl pyrrolidone), polyhydroxy compounds like polysaccharides, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid and acrylamidopropane sulfonic acid, polyhydroxy compounds and starch derivatives.

Polyhydroxy compounds and starch derivatives are especially preferred. The starch derivative should be water-soluble, preferably cold-water-soluble and is selected from starch hydrolysis products such as dextrins and cyclodextrins, starch esters, such as phosphate esters and carbamate esters, starch ethers, such as e.g. cationic starch ethers and hydroxypropyl ethers, carboxymethyl starch and acetylated starch; from the above derivatives dextrins (including dextrin comprising sodium tetraborate and available as borax dextrin from Emsland Stärke GmbH) are preferred.

The starch used as a starting product for the starch derivatives can be of various origins, it can e.g. be obtained from corn, potatoes, rye, wheat, rice, manioc, tapioca, chestnuts or acorns; corn starch and potato starch are preferred.

Suitable water-soluble polyhydroxy compounds can be represented by the following structure:

$$R^1(CHOH)_nR^2$$

in which n is 4 to 7; and

either (i) $R^1$ is hydrogen, aryl, or $CH_2OH$; and $R^2$ is hydrogen, an alkyl group having 1 to 4 carbon atoms, $CH_2OR^3$ in which $R^3$ is hydrogen or an alkyl group having 1 to 4 carbon atoms, $CH_2N(R^4R^5)$ in which $R^4$ and $R^5$ are each independently hydrogen or an alkyl group having 1 to 4 carbon atoms, or $CO_2H$,

or (ii) $R^1$ and $R^2$ together form a carbon-carbon single bond.

In one group of polyhydroxy compounds, $R^1$ is hydrogen or $CH_2OH$ and $R^2$ is hydrogen. In a preferred group of these polyhydroxy compounds, n is 5 or 6. This group includes the sugar alcohols, compounds of the structure $H(CHOH)_nH$, which do not carry a free aldehyde or ketone group and do not show a reducing property. The sugar alcohols may be obtained from natural sources or prepared by hydrogenation of reducing sugars. Preferred sugar

alcohols include mannitol, sorbitol, xylitol, ribitol, and arabitol. Other sugar alcohols include, for example, talitol, dulcitol, and allodulcitol.

In another group of polyhydroxy compounds, $R^1$ and $R^2$ together form a carbon-carbon single bond. Included are carbocyclic compounds of the structure: $(CHOH)_n$, in which n is 4 to 7. In a preferred group of these polyhydroxy compounds, n is 5 or 6, more preferably 6. There are nine possible stereoisomers of 1,2,3,4,5,6-hexahydroxycyclohexane, several of which are naturally occurring. A preferred polyhydroxy compound is meso-inosit (cis-1.2,3.5-trans-4,6-hexahydroxycyclohexane). meso-Inosit can be isolated from corn steep liquor.

In another group of polyhydroxy compounds, $R^1$ is hydrogen, aryl, or $CH_2OH$; and $R^2$ is an alkyl group having 1 to 4 carbon atoms, $CH_2OR^3$ in which $R^3$ is an alkyl group having 1 to 4 carbon atoms, $CH_2N(R^4R^5)$ in which $R^4$ and $R^5$ are each independently H or an alkyl group having 1 to 4 carbon atoms, or $CO_2H$.

In another group of polyhydroxy compounds, $R^1$ is hydrogen or $CH_2OH$; and $R^2$ is $CO_2H$. More preferably, $R^1$ is H and n is 4 or 5. This group includes polyhydroxy compounds of the structure $H(CHOH)_nCO_2H$, in which n is 4 or 5. Conceptually, these polyhydroxy compounds may be produced by oxidation of the corresponding hexose or pentose sugar, i.e., oxidation of the aldehyde group of a hexose sugar such as glucose, galactose, allose, mannose, etc., or oxidation of the aldehyde of a pentose sugar such as arabinose, ribose, xylose, etc.

Particularly preferred polyhydroxy compounds are the sugar alcohols mentioned above, like sorbitol.

The amount of the film forming polymer is not specifically limited; preferably - if present at all - it is from 1 to 30 wt-% based on the total weight of the developer, more preferably from 5 to 20 wt-%.

*Further optional components of the developer*

Besides the essential components and the above-cited optional components the developer used in the present invention may contain further additives like organic solvents, biocides, complexing agents, buffer substances, dyes, antifoaming agents, odorants, anticorrosive agents and radical inhibitors.

Antifoaming agents:

Suitable antifoaming agents include e.g. the commercially available Silicone Antifoam Emulsion SE57 (Wacker), TRITON® CF32 (Rohm & Haas), AKYPO® LF (ethercarboxylic acid Chem Y), Agitan 190 (Münzing Chemie), TEGO® Foamese 825 (modified polysiloxane, TEGO Chemie Service GmbH, Germany). Silicone-based antifoaming agents are preferred. They are either dispersible or soluble in water. The amount of antifoaming agent in the developer is preferably 0 to 1 wt-%, based on the weight of the developer especially preferred 0.01 to 0.5 wt-%. One antifoaming agent or a mixture of two or more can be used.

Buffers:

Suitable buffer substances include e.g. tris(hydroxymethyl)-aminomethane (TRIS), hydrogen phosphates, glycine, 3-(cyclohexylamino)-propane sulfonic acid (CAPS), hydrogen carbonates, borates including borax, 2-amino-2-methyl-1-propanol (AMP), 3-(cyclohexylamino)-2-hydroxy-1-propane-sulfonic acid (CAPSO), and 2-(N-cyclohexylamino)ethan-sulfonic acid (CHES).

Biocides:

The biocides should be effective against bacteria, fungi and/or yeasts. Suitable biocides include e.g. N-methylol-chloroacetamide, benzoic acid, p-hydroxybenzoic acid esters, phenol or its derivatives, formalin, imidazol derivatives, isothiazolinone derivatives like 1,2-benzisothiazolin-3-on, benzotriazole derivatives, amidines, guanidine derivatives, quaternary ammonium salts, pyridine, quinoline derivatives, diazine, triazole derivatives, oxazole and oxazine derivatives and mixtures thereof. Their amount is not particularly restricted and preferably accounts for 0 to 10 wt-% in the developer, based on the total weight of the solution, especially preferred 0.1 to 1 wt-%. One biocide or a mixture of two or more can be used.

Complexing agents:

Examples of suitable complexing agents include: Aminopolycarboxylic acid and salts thereof, such as ethylene diamine tetraacetic acid and potassium or sodium salts thereof, diethylene triamine pentaacetic acid and potassium or sodium salts thereof, triethylene tetraaminohexaacetic acid and potassium or sodium salts thereof, hydroxyethyl ethylene diamine triacetic acid and potassium or sodium salts thereof, nitrilotriacetic acid and potassium or sodium salts thereof, 1,2-diaminocyclohexane-tetraacetic acid and potassium or sodium salts thereof and 1,3-diamino-2-propanol-tetraacetic

acid and potassium or sodium salts thereof, and an organophosphonic acid, phosphonoalkane tricarboxylic acid or salts thereof, such as 2-phosphonobutane-1,2,4-tricarboxylic acid and potassium or sodium salts thereof, phosphonobutane-2,3,4-tricarboxylic acid and potassium or sodium salts thereof, phosphonoethane-2,2,2-tricarboxylic acid and potassium or sodium salts thereof, aminotris-(methylene-phosphonic acid) and potassium or sodium salts thereof and sodium gluconate. The complexing agents can be used individually or as a combination of two or more. Organic amine salts of the above-mentioned complexing agents can be used instead of the potassium or sodium salts thereof. The amount of complexing agent preferably accounts for 0 to 5 wt-% in the developer, based on the total weight of the solution, especially preferred 0.01 to 1 wt-%.

Solvents:

The developer may also comprise an organic solvent or a mixture of organic solvents. The developer is a single phase. Consequently, the organic solvent must be miscible with water, or at least soluble in the developer to the extent it is added to the developer, so that phase separation does not occur. The following solvents and mixtures of these solvents are suitable for use in the developer: the reaction products of phenol with ethylene oxide and propylene oxide, such as ethylene glycol phenyl ether; benzyl alcohol; esters of ethylene glycol and of propylene glycol with acids having six or fewer carbon atoms, and ethers of ethylene glycol, diethylene glycol, and of propylene glycol with alkyl groups having six or fewer carbon atoms, such as 2-ethylethanol and 2-butoxyethanol. A single organic solvent or a mixture of organic solvents can be used. The organic solvent is typically present in the developer at a concentration of between about 0 wt-% to about 15 wt-%, based on the weight of the developer preferably between about 3 wt-% and about 5 wt-%, based on the weight of the developer.

Anticorrosive agents:

Examples of anticorrosive agents are phosphonic acids and their salts like hydroxyethyl phosphonic acid and its salts, amino trismethylene phosphonic acid and its salts, and diethylentriaminpentamethylene phosphonic acid and its salts; phosphates like trisodium phosphate; borates like borax; as well as glycerol and glycols having the formula

$$R^{20}-\underset{OH}{\underset{|}{CH}}-(CH_2)_z-\underset{OH}{\underset{|}{CH}}-R^{21}$$

(wherein z is 0, 1 or 2 and $R^{20}$ and $R^{21}$ are independently hydrogen or $C_1$-$C_3$ alkyl).

The anticorrosive agent or mixture of such agents is typically present in the developer at a concentration of about 0 to 10 wt-% based on the weight of the developer, preferably 0.1 to 5 wt-%, in case of glycerol or a glycol 5 to 10 wt-%.

Further additives:

Odorants and dyes can also be present in the developer, if desired. The dyes are added in order to prevent confusion at the users when different processing chemicals like developer and replenisher are used parallel at the same user. Examples for classes of dyes that can be used are azo dyes, triarylmethan dyes or phthalocyanines. The concentration of the dyes in the developer is typically 0.0005 to 0.5 wt.-%.

Odorants are used in order to compensate unpleasant smell of other components in the developer. The typical concentration of odorants is within 0.001 to 1 wt.-%.

The present invention is described in more details in the following examples; however they are not intended to restrict the invention in any way.

## Examples

The following abbreviations are used:

| | |
|---|---|
| APE | triallyl pentaerythritol |
| Binder 9 | copolymer of 20mol-% methacrylic acid, 40 mol-% allyl methacrylate, 20 mol-% benzyl methacrylate and 20 mol-% N-isopropyl methacrylamide (unbranched) |
| Binder 10 | polymer made like polymer P2 of EP 1344783 (unbranched) |
| Binder 11 | polymer made like polymer P11 of EP 1344783 (unbranched) |

| | |
|---|---|
| Binder 12 | corresponds to M1 of EP 1522557 (branched polyester with ethylenically unsaturated double bonds) |
| D20H | 1,10-decan-diol |
| G | glycerol |
| GA | glycolic acid |
| GDMA | glycerol 1,3-dimethacrylate |
| Hydridur 580 | polymer dispersion (40 % in water) of anionically stabilized urethane-acrylic hybrid polymers available from Air Products |
| Initiator 1 | 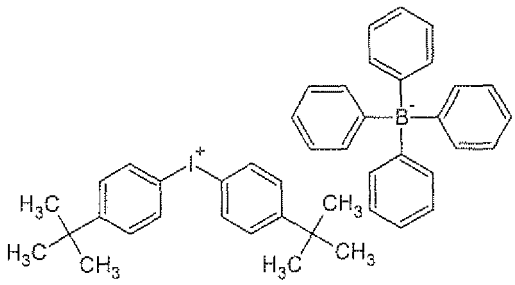 |
| Kayamer PM-2 | ester of 1 mol phosphoric acid and 1.5 mol hydroxyethyl methacrylate, available from Nippon Kayaku/Japan |
| Lutensol® TO-10 | C13 oxo alcohol ethoxylate having 10 EO groups, available from BASF, Germany |
| Monomer 1 | urethane methacrylate made from glycerol dimethacrylate, glycerol monomethacrylate, propylene glycol methacrylate and biuret of hexamethylene diisocyanate corresponding to oligomer ml in EP1969426 B1 |
| Monomer 2 | dipentaerythritol pentaacrylate available from Sartomer |
| Naxan ABL | alkylated naphthalene sulfonate, sodium salt from Nease Corporation |
| NK Ester BPE-200 | ethoxylated bisphenol A having methacrylic end groups available from Shin Nakamura, Japan |
| PEry | pentaerythritol |
| PVA 1 | Mowiol® 4/98, poly(vinyl alcohol) from Kuraray, Germany, having a saponification degree of about 98% |
| PVA 2 | Poval PVA-403 available from Kuraray, Germany |
| PVA 3 | CKS-50 available from Nippon Gohsei, Japan |
| Pigment 1 | dispersion in propylene glycol monomethyl ether containing 9 wt. % of copper phthalocyanine and 1 wt. % of a polyvinyl acetal) binder containing 39.9 mol% of vinyl alcohol, 1.2 mol% of vinylacetate, 15.4 mol% of acetal groups from acetaldehyde, 36.1 mol% of acetal groups from butyraldehyde, and 7.4 acetal groups from 4-formylbenzoic acid |
| PVP K15 | poly(vinyl pyrrolidone) from ISP, USA |
| Q-1301 | N-nitrosophenylhydroxylamine aluminum salt |
| Sensi 1 | 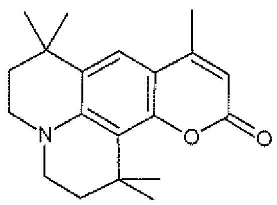 |

Sensi 2

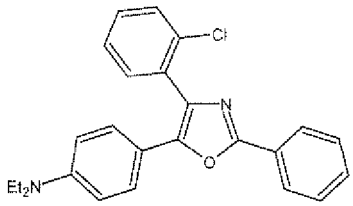

Sensi 3

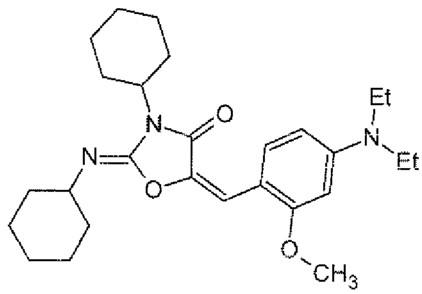

Sensi 4

Mixture of

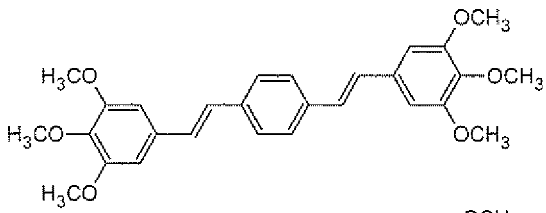

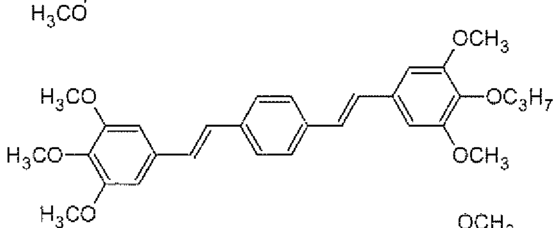

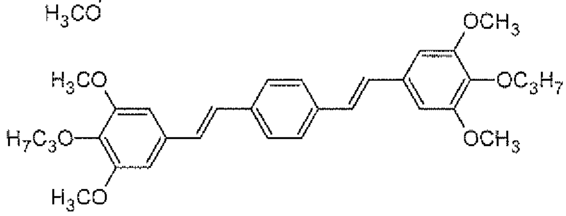

Sensi5

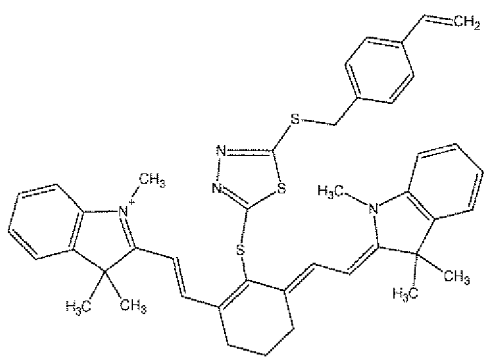

SH-compound 1

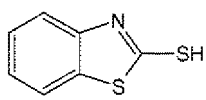

SH-compound 2

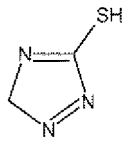

SH-compound 3

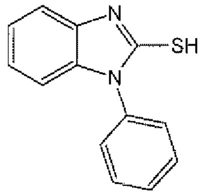

| | |
|---|---|
| Sorbidex 200 | Sorbit from CG Germany |
| SR9053 | mixture of an ethoxylated trimethylolpropantriacrylate and a trifunctional acidic ester from Sartomer |
| TIPTP | tris(isocyanatophenyl)thiophosphate |

***Preparation of Hyperbranched Binder Material***

Binder 1

A three-necked round bottom flask equipped with magnetic stirrer, thermometer, condenser, drying tube and dropping funnel was loaded with 68.94 g of a 27 wt% solution of trisisocyanatophenylthiophosphate in ethyl acetate (40 mmol). 10.25 g of triallyl pentaerythritol (40 mmol) were dissolved in 50 g of dry ethyl acetate and added to the isocyanate solution. The reaction mixture was stirred at room temperature for three hours before a solution of 3.04 g of glycolic acid (40 mmol) in 50 g of dry ethyl acetate was added. The mixture was stirred at room temperature for two hours, and then a suspension of 1.36 g of pentaerythritol (10 mmol) in 50 g of dry ethyl acetate was added. The reaction was stirred over night at room temperature. About 5 ml of methanol were added and the reaction was stirred for one more hour to remove excess isocyanate, then a portion of organic solvent was removed by rotary evaporation to yield a 50 wt% solution. Yield: 100%.

To access the tackiness of the binders of the invention a small portion of the obtained binder solution was slowly added to cold water and the precipitated polymer was isolated. After drying for 24h at 25°C a non-tacky powder was obtained.

$$Tg > 30°C$$

$M_n$ = 3300 g/mol
$n_{EG}$ = 40 mmol + 40 mmol
$n_{SU}$ = 0
$n_{BU}$ = 40 mmol + 10 mmol

Binder 2

A three-necked round bottom flask equipped with magnetic stirrer, thermometer, condenser, drying tube and dropping funnel was loaded with 333.14 g of a 27 wt% solution of trisisocyanatophenylthiophosphate in ethyl acetate (200 mmol). 49.10 g of glycerol 1,3-dimethacrylate (200 mmol) were dissolved in 150 g of dry ethyl acetate and 30 g of dry N,N-dimethyl acetamide and added to the isocyanate solution. The reaction mixture was stirred at room temperature for two hours before a solution of 15.21 g of glycolic acid (200 mmol) in 200 g of dry ethyl acetate was added. The mixture was stirred at room temperature for two hours, then a solution of 6.81 g of pentaerythritol (50 mmol) in 100 g of dry N,N-dimethylacetamide was added. The reaction was stirred over night at room temperature. About 20 ml of methanol were added and the reaction was stirred for one more hour to remove excess isocyanate, then a portion of organic solvent was removed by rotary evaporation to yield a 50 wt% solution. Yield: 100%.

To access the tackiness of the binders of the invention a small portion of the obtained binder solution was slowly added to cold water and the precipitated polymer was isolated. After drying for 24h at 25°C a non-tacky powder was obtained.

Tg > 30°C

$M_n$ = 3200 g/mol
$n_{EG}$ = 200 mmol + 200 mmol
$n_{BU}$ = 200 mmol + 50 mmol
$n_{SU}$ = 0

Binder 3

A three-necked round bottom flask equipped with magnetic stirrer, thermometer, condenser, drying tube and dropping funnel was loaded with 180 mg of 2,6-bis(1,1-dimethylethyl)-4-methylphenol, 2.3 g of glycolic acid (30 mmol), 14,3 g of glycerol 1,3-dimethacrylate (60 mmol) and 77.6 g of a 27 wt% solution of trisisocyanatophenylthiophosphate in ethyl acetate (45 mmol). The reaction mixture was stirred for 8 h at 60°C before 2.0 g glycerol (22 mmol) were added and left stirring for 8 h at 60°C. Next, 11.6 g of a 27 wt% solution of trisisocyanatophenylthiophosphate in ethyl acetate (7 mmol) were added and the reaction was stirred for 4 h at 60°C. About 10 ml of methanol were added and the reaction was stirred for one more hour to remove excess isocyanate. Yield: 100%.

To access the tackiness of the binders of the invention a small portion of the obtained binder solution was slowly added to cold water and the precipitated polymer was isolated. After drying for 24h at 25°C a non-tacky powder was obtained.

Tg >30°C

$M_n$ = 2500 g/mol
$n_{EG}$ = 30 mmol + 60 mmol
$n_{BU}$ = 45 mmol + 7 mmol + 22 mmol
$n_{SU}$ = 0

Binder 4

A three-necked round bottom flask equipped with magnetic stirrer, thermometer, condenser, drying tube and dropping funnel was loaded with 51.71 g of a 27 wt% solution of trisisocyanatophenylthiophosphate in ethyl acetate (30 mmol). 14.73 g of glycerol 1,3-dimethacrylate (60 mmol) were dissolved in 50 g of dry ethyl acetate and added to the isocyanate solution. The reaction mixture was stirred at room temperature over night before a solution of 1.38 g glycerol (15 mmol) in dry 20 g of dry N,N-dimethyl acetamide was added and left stirring at room temperature for two hours. Next, 8.62 g of a 27 wt% solution of trisisocyanatophenylthiophosphate in ethyl acetate (5 mmol) were added and the reaction was stirred over night at room temperature. About 5 ml of methanol were added and the reaction was stirred for one more hour to remove excess isocyanate, then a portion of organic solvent was removed by rotary evaporation to yield a 30 wt% solution. Yield: 100%.

To access the tackiness of the binders of the invention a small portion of the obtained binder solution was slowly added to cold water and the precipitated polymer was isolated. After drying for 24h at 25°C a non-tacky powder was obtained.

Tg > 30°C

$M_n$ = 3400 g/mol
$n_{EG}$ = 60 mmol
$n_{BU}$ = 30 mmol + 5 mmol 4 15 mmol
$n_{SU}$ = 0

Binder 5

A three-necked round bottom flask equipped with magnetic stirrer, thermometer, condenser, drying tube and dropping funnel was loaded with 55.16 g of a 27 wt% solution of trisisocyanatophenylthiophosphate in ethyl acetate (32 mmol). 15.71 g of glycerol 1,3-dimethacrylate (64 mmol) were dissolved in 50 g of dry ethyl acetate and added to the isocyanate solution. The reaction mixture was stirred at room temperature over night before a solution of 3.49 g Boltom

H20 (Perstorp) in 100 g of dry N,N-dimethyl acetamide was added and left stirring at room temperature over night. Next, about 5 ml of methanol were added and the reaction was stirred for one more hour to remove excess isocyanate, then a portion of organic solvent was removed by rotary evaporation to yield a 30 wt% solution. Yield: 100%. To access the tackiness of the binders of the invention a small portion of the obtained binder solution was slowly added to cold water and the precipitated polymer was isolated. After drying for 24h at 25°C a non-tacky powder was obtained.

$$Tg > 30°C$$

$M_n$ = 3400 g/mol
$n_{EG}$ = 64 mmol
$n_{SU}$ = 0 mmol
$n_{BU}$ = 32 mmol + 2 mmol

Binder 6

A three-necked round bottom flask equipped with magnetic stirrer, thermometer, condenser, drying tube and dropping funnel was loaded with 103.42 g of a 27 wt% solution of trisisocyanatophenylthiophosphate in ethyl acetate (60 mmol). 14.73 g of glycerol 1,3-dimethacrylate (60 mmol) were dissolved in 50 g of dry ethyl acetate and added to the isocyanate solution. The reaction mixture was stirred at room temperature over night before a solution of 4.56g of glycolic acid (60 mmol) in 100 g of dry ethyl acetate was added. The mixture was stirred at room temperature for two hours, then a solution of 2.76 g glycerol (30 mmol) in dry N,N-dimethyl acetamide was added and left stirring at room temperature for two hours. Next, 17.24 g of a 27 wt% solution of trisisocyanatophenylthiophosphate in ethyl acetate (10 mmol) were added and the reaction was stirred for two hours at room temperature. About 5 ml of methanol were added and the reaction was stirred for one more hour to remove excess isocyanate, then a portion of organic solvent was removed by rotary evaporation to yield a 30 wt% solution. Yield: 100%.

To access the tackiness of the binders of the invention a small portion of the obtained binder solution was slowly added to cold water and the precipitated polymer was isolated. After drying for 24h at 25°C a non-tacky powder was obtained.

$$Tg > 30°C$$

$M_n$ = 2100 g/mol
$n_{EG}$ = 60 mmol + 60 mmol
$n_{BU}$ = 60 mmol + 30 mmol + 10 mmol
$n_{SU}$ = 0

Binder 7

A three-necked round bottom flask equipped with magnetic stirrer, thermometer, condenser, drying tube and dropping funnel was loaded with 6.96 g of toluene diisocyanate (40 mmol) in 50 g of dry ethyl acetate, a solution of 10.15 g of glycerol 1,3-dimethacrylate (40 mmol) in 50 g of dry ethyl acetate was added slowly and left stirring at room temperature for five hours. Next, 6.97 g of 1,10-decane diol (40 mmol) were dissolved in 350 g of dry ethyl acetate and added to the isocyanate solution. The reaction mixture was stirred at room temperature for two hours before 68.94 g of a 27 wt% solution of trisisocyanatophenylthiophosphate in ethyl acetate (40 mmol) was added. Then 3.05 g of glycolic acid (40 mmol) in 50 g of dry ethyl acetate were added and stirred for one hour at room temperature. Finally, a solution of 1.32 g of pentaerythritol (10 mmol) in 100 g of dry N,N-dimethyl acetamide was added. The reaction was stirred for two hours at room temperature. About 5 ml of methanol were added and the reaction was stirred for one more hour to remove excess isocyanate, then a portion of organic solvent was removed by rotary evaporation to yield a 40 wt% solution. Yield: 100%

To access the tackiness of the binders of the invention a small portion of the obtained binder solution was slowly added to cold water and the precipitated polymer was isolated. After drying for 24h at 25°C a non-tacky powder was obtained.

$$Tg > 30°C$$

$M_n$ = 2100 g/mol
$n_{EG}$ = 40 mmol + 40 mmol + 40 mmol
$n_{BU}$ = 40 mmol + 10 mmol
$n_{SU}$ = 40 mmol

Binder 8

A three-necked round bottom flask equipped with magnetic stirrer, thermometer, condenser, drying tube and dropping funnel was loaded with 68.94 g of a 27 wt% solution of trisisocyanatophenylthiophosphate in ethyl acetate (40 mmol). 20.30 g of glycerol 1,3-dimethacrylate (80 mmol) were dissolved in 50 g of dry ethyl acetate and added to the isocyanate solution. The reaction mixture was stirred for six hours, then a solution of 3.05 g of glycolic acid (40 mmol) in 50 g of dry ethyl acetate was added. The mixture was stirred at room temperature for two hours before about 5 ml of methanol were added and the reaction was stirred for one more hour to remove excess isocyanate, then a portion of organic solvent was removed by rotary evaporation to yield a 50 wt% solution. Yield: 100%.

To access the tackiness of the binders of the invention a small portion of the obtained binder solution was slowly added to cold water and the precipitated polymer was isolated. After drying for 24h at 25°C a non-tacky powder was obtained.

$$Tg > 30°C$$

$M_n$ = 900 g/mol
$n_{EG}$ = 80 mmol + 40 mmol
$n_{BU}$ = 40 mmol
$n_{SU}$ = 0

The molecular weight given for binders 1 to 8 above is a number average molecular weight which was determined by GPC at room temperature (about 25°C) using polystyrene standards for calibration.

Tg was measured with DSC 820 available from Mettler-Toledo; the temperature range was -60°C to +160°C with a heating/cooling rate of 10K/min. The Tg was obtained by the half step method in the first heating circle as polymerization started at about 80°C so that a Tg obtained in the second heating circle was not considered to be the correct one for the binder used in the coating of the lithographic printing plate precursor.

***Description of Testing***

**Shelflife testing**

For an estimation of the shelflife plates were subjected to an accelerated ageing test in a climate chamber for 10d at 40°C and 80% RH wrapped in aluminized wrapping paper. The loss of tonal values of a 50 % tint in a 150 lpi screen compared to the fresh plate was taken as a criterion. The following rating regarding the thermal stability is given:

++ < 0.25% change of tonal values; clean background
+ < 1 % change of tonal values, clean background

- background visible after inking

-- background visible before inking.

**Press testing**

Test plates were exposed in such a way that when using an UGRA Offset test scale 1982 with overall exposure two solid steps were received; thereafter the plates were loaded in a sheet-fed offset printing machine using abrasive ink (Offset S 7184 available from Sun Chemical which contains 10% of calcium carbonate; fountain solution was Böttcher Fount S-3021 available from Böttcher GmbH). The length of run of the plate is the number of copies when first sign of wear in solid areas of the plate becomes visible.

++ > 150 % of the value obtained for Comparative Example 1 (405 nm plates) and Comparative Example 6 (830 nm plates), respectively

+ 120 - 150 % of Comparative Example 1 and 6, respectively

- Equal to or worse than Comparative Example 1 and 6, respectively

**Developer capacity**

The developer capacity was measured by loading of 15$m^2$ plates in 1 litre developer (in case of 405nm sensitive plates with prewash step before development). The following rating for the developer bath is given:

| | |
|---|---|
| high | very clean, no deposition, low viscosity of loaded developer, loading could have been continued |
| medium | small depositions, medium viscosity, loading cycle can not be continued |
| low | deposition, difficult to clean, viscose developer, plates are not clean anymore after leaving the processor |

**Complexity of synthesis**

The complexity of synthesis determining the cost of binders has been classified as follows:

| | |
|---|---|
| low | low cost raw materials, one pot synthesis, short reaction time, simple isolation |
| medium | low cost raw materials, one pot synthesis, long reaction time, difficult isolation |
| high | expensive raw materials, several reaction steps, long reaction times, difficult isolation |

***Preparation of Elements***

An electrochemically roughened and anodized aluminum foil with an oxide weight of 3 g/$m^2$ was subjected to an after treatment using an aqueous solution of poly(vinyl phosphoric acid). The average roughness of the surface was 0.55 μm. Imageable layer coating compositions corresponding to Table 1 (405 nm plates) and Table 4 (830 nm plates) below were applied to the substrate after filtering using a wire bar coater. The coatings were dried for 4 minutes at 90°C to provide a dry coating weight of 1.7 g/$m^2$ of 405 nm sensitive composition and 1.2 g/$m^2$ of 830nm sensitive composition. All coatings based on binders of the invention gave non-tacky coatings.

The dried imageable layers were overcoated with an aqueous solution using a wire bar coater to provide lithographic printing plate precursors having a dry overcoat weight of 2 g/$m^2$ after drying for 4 minutes at 90°C for the 405 nm sensitive composition and 0.4 g/$m^2$ for the 830 nm sensitive composition.

For the plates of Invention Examples 1 to 11 and Comparative Examples 1 to 5 the overcoat solution described in Table 2 was used.

For the plates of Invention Examples 12 and 13 the overcoat solution described in Table 3 was used.

For the plates of Invention Examples 14 to 19 and Comparative Examples 6 to 8 the overcoat solution described in Table 5 was used.

Table 1

| Composition of the 405 nm sensitive layers | |
|---|---|
| 40 g | propylene glycol monomethyl ether |
| 5 g | acetone |
| X g | of binder corresponding to table 7 |
| 2,00 g | Pigment 1 |
| 0.05 g | Kayamer PM-2 |
| 5,77 g | Monomer 1 |
| 0.35 g | HB-NK Ester PBE 200 |
| Y g | of sensitizer corresponding to table 7 |
| 0.16 g | 2,2-bis-(2-chlorophenyl)-4,5,4',5'-tetraphenyl-2'H-[1,2]biimidazolyl |
| Z g | mercapto compound |

(continued)

| Composition of the 405 nm sensitive layers | |
|---|---|
| 0.73 g | Q1301 (1% solution in propylene glycol monomethyl ether) |

Table 2

| Overcoat formulation of 405 nm sensitive plates | |
|---|---|
| 25 g | water |
| 56 g | 15% solution of PVA 1 in water |
| 10 g | 15% solution of PVP K15 in water |

Table 3

| Overcoat formulation of 405 nm sensitive plates for gum development | |
|---|---|
| 25 g | water |
| 56 g | 15% solution of PVA 3 in water |
| 10 g | 15% solution of PVP K15 in water |

Table 4

| Composition of the 830 nm sensitive layers | |
|---|---|
| 16 g | butanone |
| 20 g | propylene glycol monomethyl ether |
| 2 g | water |
| X g | of binder corresponding to table 8 |
| 3.61 g | Pigment 1 |
| 6.51 g | Monomer 2 (40% in propylene glycol monomethyl ether) |
| 0.27 g | SR9053 |
| 0.13 g | Sensitizer 5 |
| 0.75 g | Hybridur 580 (40 % in water) |
| 0.39 g | Initiator 1 |

Table 5

| Overcoat formulation of 830 nm sensitive plates | |
|---|---|
| 80 g | water |
| 6.13 g | 15% solution of PVA 2 in water |

***Imaging of the Precursors***

**Photospeed of 405 nm sensitive plates (Invention Examples 1 to 13 and Comparative Examples 1 to 5)**

The UGRA/FOGRA Postscript Strip version 2.0 EPS (available from UGRA), which contains different elements for evaluating the quality of the copies, was used for imaging the imageable elements using the ProSetter platesetter

from Heidelberger Druckmaschinen. The exposure wavelength was 405 nm and the energy was 50 $\mu$J/cm$^2$. The sensitivity of the printing plate precursors was determined using an UGRA Offset test scale 1982 with overall exposure and defined as the turning point of the O.D. (optical density) vs. log(exposure energy) curve. The results are summarized in Table 7.

The imaged plates of Invention Example 1 to 11 and Comparative Examples 1 to 5 were developed in a Raptor 68 Polymer processor from Glunz & Jenzen, Denmark, using the following processor settings: preheat temperature 110°C, prewash section with water recirculation, developer temperature 23°C, developer Kodak 206, regenerator Kodak 206R, regeneration rate 40 ml/m$^2$, post rinse section with water recirculation, gumming section filled with Kodak 850S.

The imaged plates of Invention Example 12 and 13 were preheated in an oven for 2 minutes at 90°C and processed in a single bath dip tank processor (dwell time of 20sec) having a developing bath equipped with two brushes and a drying unit using air of 65°C. The single bath processor was filled with gum developer having the following composition:

Table 6 Composition of gum-developer

| | |
|---|---|
| water | 82.62% |
| Ethylene glycol phenyl ether | 5.00% |
| Tristyrylphenol ethoxylate (EO54) | 5.00% |
| Diethanolamine | 2.00% |
| Sorbidex 200 | 5.00% |
| Naxan ABL | 0.38% |
| pH | 11 |

**Photospeed of 830nm sensitive plates (Invention Examples 14 to 19 and Comparative Examples 6 to 8)**

The UGRA/FOGRA Postscript Strip version 2.0 EPS (available from UGRA), which contains different elements for evaluating the quality of the copies, was used for imaging the plates of the Examples and Comparative Examples with Trendsetter 3244 from Kodak at 830nm with an exposure energy of 80 mJ/cm$^2$. The imaged elements of Invention Examples 14 to 17 and Comparative Examples 6 to 8 were developed in a processor Kodak Thermal using the following processor settings: developer temperature 23°C, developer Kodak 500, regenerator Kodak 550R, regeneration rate 40 ml/m$^2$, post rinse section with water recirculation, gumming section filled with Kodak 850S. The sensitivity of the plate was determined using an UGRA Offset test scale 1982 with overall exposure and defined as the turning point of the O.D. (optical density) vs. log(exposure energy) curve. The results are summarized in Table 8.

The imaged plates of Invention Example 18 and 19 were processed in a single bath dip tank processor (dwell time of 20sec) having a developing bath equipped with two brushes and a drying unit using air of 65°C. The single bath processor was filled with gum developer having the following composition described in Table 6.

***Results***

In following Table 7 the results (photospeed, shelflife, press durability, developer capacity, complexity of synthesis of the binder material) obtained for the elements exposed to radiation of 405 nm are summarized.

The results obtained for the elements exposed to radiation of 830 nm are summarized in Table 8 below.

Table 7

| | Binder | sensitizer | mercapto compound | Sensitivity µJ/cm² | shelflife | press durability | developer capacity | complexity of synthesis |
|---|---|---|---|---|---|---|---|---|
| Invention Example 1 | 1.5 g Binder 1 | 0.16 g Sensi 1 | 0.05 g SH-compound 1 | 16 | ++ | + | high | low |
| Invention Example 2 | 1.5 g Binder 2 | 0.16 g Sensi 1 | 0.05 g SH-compound 1 | 16 | ++ | ++ | high | low |
| Invention Example 3 | 1.5 g Binder 3 | 0.16 g Sensi 1 | 0.05 g SH-compound 1 | 13 | ++ | ++ | high | low |
| Invention Example 4 | 1.5 g Binder 4 | 0.16 g Sensi 1 | 0.05 g SH-compound 1 | 2 | + | + | high | low |
| Invention Example 5 | 1.5 g Binder 5 | 0.16 g Sensi 1 | 0.05 g SH-compound 1 | 2 | + | + | high | low |
| Invention Example 6 | 1.5 g Binder 6 | 0.16 g Sensi 1 | 0.05 g SH-compound 1 | 17 | ++ | + | high | low |
| Invention Example 7 | 1.5 g Binder 7 | 0.16 g Sensi 1 | 0.05 g SH-compound 1 | 9 | ++ | ++ | high | low |
| Invention Example 8 | 1.5 g Binder 8 | 0.16 g Sensi 1 | 0.05 g SH-compound 1 | 10 | + | + | high | low |
| Invention Example 9 | 1.5 g Binder 1 | 0.16 g Sensi 3 | 0.1 g SH-compound 3 | 18 | ++ | + | high | low |
| Invention Example 10 | 1.5 g Binder 1 | 0,16 g Sensi 4 | 0.05 g SH-compound 1 | 17 | ++ | + | high | low |
| Invention Example 11 | 1.5 g Binder 1 | 0.62 g Sensi 2 | 0.28 g SH-compound 2 | 9 | + | + | high | low |
| Invention Example 12 | 1.5 g Binder 1 | 0.16 g Sensi 1 | 0.05 g SH-compound 1 | 16 | ++ | + | high | low |
| Invention Example 13 | 1.5 g Binder 2 | 0.16 g Sensi 1 | 0.05 g SH-compound 1 | 17 | ++ | ++ | high | low |
| Comparative Example 1 | 1.3 g Binder 9 | 0.62 g Sensi 2 | 0.28 g SH-compound 2 | 19 | + | - | medium | medium |

(continued)

| | Binder | sensitizer | mercapto compound | Sensitivity µJ/cm$^2$ | shelflife | press durability | developer capacity | complexity of synthesis |
|---|---|---|---|---|---|---|---|---|
| Comparative Example 2 | 1.5 g Binder 9 | 0.16 g Sensi 1 | 0.05 g SH-compound 1 | 17 | + | + | medium | medium |
| Comparative Example 3 | 1.5 g Binder 10 | 0.16 g Sensi 1 | 0.05 g SH-compound 1 | 15 | - | + | low | high |
| Comparative Example 4 | 1.5 g Binder 11 | 0.16 g Sensi 1 | 0.05 g SH-compound 1 | 12 | - | + | low | high |
| Comparative Example 5 | 1.5 g Binder 12 | 0.16 g Sensi 1 | 0.05 g SH-compound 1 | 5 | - | - | medium | medium |

Table 8

| | Binder | Sensitivity mJ/cm$^2$ | shelflife | press durability | developer capacity | complexity of synthesis |
|---|---|---|---|---|---|---|
| Invention Example 14 | 1.9 g Binder 1 | 37 | + | + | high | low |
| Invention Example 15 | 1.9 g Binder 2 | 40 | + | ++ | high | low |
| Invention Example 16 | 1.9 g Binder 4 | 18 | ++ | + | high | low |
| Invention Example 17 | 1.9 g Binder 5 | 21 | ++ | + | high | low |
| Invention Example 18 | 1.9 g Binder 1 | 36 | + | + | high | low |
| Invention Example 19 | 1.9 g Binder 2 | 37 | + | ++ | high | low |
| Comparative Example 6 | 1.9 g Binder 9 | 27 | + | - | medium | medium |
| Comparative Example 7 | 1.9 g Binder 10 | 29 | - | + | low | high |
| Comparative Example 8 | 1.9 g Binder 11 | 24 | - | + | low | high |

## Claims

**1.** Negative working lithographic printing plate precursor comprising:

(a) a substrate,
(b) negative working radiation sensitive coating comprising:

(i) 10 to 90 wt% based on the dry coating weight of a branched binder material
(ii) at least one radical forming component selected from photoinitiators and sensitizer/coinitiator systems which absorbs wavelength in the range of 300 to 1200 nm and is capable of initiating a radical polymerization, and
(iii) at least one compound having at least two free radically polymerizable groups per molecule and a Tg $< 30°C$,

(c) and optionally an overcoat acting as oxygen barrier;

**characterized in that** the branched binder material comprises radically polymerizable groups, has a number average molecular weight in the range of 500 to 15000, and a Tg $> 30°C$, and consists of structural moieties connected to each other by urethane and/or urea linkages, said structural moieties being derived from $n_{EG}$ moles of end group precursors represented by formula (I), $n_{BU}$ moles of branching unit precursors represented by formula (II), and optionally $n_{SU}$ moles of spacer unit precursors represented by formula (III)

$$L^1X^1 \quad (I)$$

$$L^2(X^2)_n \quad (II)$$

$$L^3(X^3)_2 \quad (III)$$

wherein each of $X^1$, $X^2$ and $X^3$ is independently an isocyanate group, or the same or different isocyanate reactive

group selected from the group consisting of -OH and -NHR, with R being H, $C_{1-20}$alkyl- or $C_{5-20}$aryl, each of $L^1$, $L^2$ and $L^3$ is independently an optionally substituted aliphatic, aromatic, heterocyclic or heteroaromatic moiety with a valence of 1, n and 2, respectively, wherein n is an integer equal to or larger than 3; and wherein $L^1$, $L^2$ and $L^3$ do not contain urethane and urea linkages besides urea linkages being part of cyanuric acid derivatives having the structural moiety

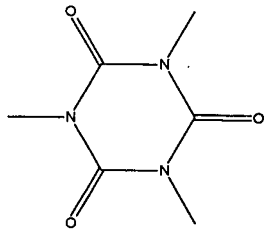
;

and wherein the molar quantities $n_{EG}$ , $n_{BU}$ , and $n_{SU}$ are satisfying the following conditions,

$$n_{EG} > n_{BU} > 0$$

and

$$0 \leq n_{SU} < (n_{EG}+n_{BU}).$$

**2.** The lithographic printing plate precursor according to claim 1, wherein the branched binder material is obtained by sequential addition of precursors in such a way that urethane or urea linkages are formed following a convergent mechanism comprising the following steps:

A) simultaneous or sequential reaction of one or more end group precursors of formula (I) with a branching unit precursor of formula (II) in a molar ratio of end group precursor to branching unit precursor of (n-1) : 1 to form the first intermediate with one of the n reactive groups $X^2$ of the branching unit precursor remaining unreacted, wherein n are the moles of $X^2$ per branching unit precursor molecule as defined in claim 1;
B) optional reaction of the first intermediate with another branching unit precursor of formula (II) in a molar ratio of first intermediate to other branching unit precursor of (n-1) : 1 to form the next intermediate with one of the n reactive groups $X^2$ of the other branching unit precursor remaining unreacted, and repetition of step (B) zero to five times to form a final intermediate;
C) reaction of the first or final intermediate with a precursor of formula (I), (II) or (III) in a molar ratio such that the number of equivalences of the isocyanate reactive groups is equal to or greater than the number of equivalences of the isocyanate groups,
D) and optionally before step (A) and/or between steps (A) and (B) and/or between steps (B) and (C) and/or between different steps (B) reaction with spacer unit precursors of formula (III) in a molar ratio of the respective intermediate/end group precursor to spacer unit precursor of 1 : 1 to form the next intermediate with one of the two reactive groups $X^3$ of the spacer unit precursor remaining unreacted,

with the proviso that in each reaction step (A) to (D) one reaction partner has isocyanate functionality and the other reaction partner has isocyanate-reactive functionality selected from -OH and -NHR, with R being $C_{1-20}$alkyl- or $C_{5-20}$aryl so that urethane or urea linkages are formed between the reaction partners.

**3.** The lithographic printing plate precursor according to any one of claims 1 to 2, wherein each $L^2$ is independently represented by a formula (II-1):

$$Z^1[-(Y^1-Y^2-Y^3)]_{nx} \qquad \text{(II-1)}$$

wherein $Z^1$ is selected from $(C(R^a)_p)_{ny}$; $(-O)_3P=Y^4$ (with $Y^4$ being O or S); N;

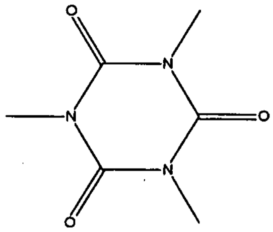 ; 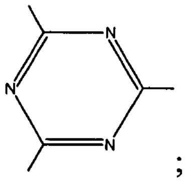 ; a 5 to 6 membered aromatic or saturated carbocyclic group; or a branched polyester moiety based on dimethylol propionic acid and a multivalent alcohol;

$Y^1$ and $Y^2$ are independently selected from single bond; -O-; -NR- with R being H, $C_{1-20}$ alkyl- or $C_{5-20}$ aryl; $-((CH_2)_q-CR^aH-O)_{ny}-$ ; divalent aromatic, heteroaromatic, heterocyclic or cyclic group or alkylene group, each being optionally substituted; $-C((-CR^aH)_{nz}-*)_2$, or $-CR^a((-CR^aH)_{nz}-*)$;

each $Y^3$ is independently selected from -*; $-(CH_2-CR^aH-O)_{ny}-*$; -T-* with T being a divalent aromatic, heteroaromatic, heterocyclic or cyclic group each optionally substituted by one or more substituents selected from halogen atoms and $C_{1-20}$ alkyl, or alkylene group, optionally substituted by one or more halogen atoms; or $-Z^2((-CR^aH)_{ny}-*)_2$ with $Z^2$ being CH or N; or $-Z^3((-CR^aH)_{ny}-*)_3$ with $Z^3$ being C;

each $R^a$ is independently selected from H or $C_{1-5}$ alkyl;

with each nz being an integer independently selected from 0 to 10; each ny being an integer independently selected from 1 to 10; each nx being an integer of at least 3 depending on the valency of $Z^1$;

p is 0 or 1 or 2; q is 0 or an integer from 1 to 5;

and * denotes the binding site of $X^2$;

with the proviso that $Z^1$, $Y^1$, $Y^2$ and $Y^3$ are selected such that $L^2$ of formula (II-1) does not contain

(1) an oxygen atom directly bonded to a nitrogen atom or another oxygen atom and
(2) a nitrogen atom directly bonded to another nitrogen atom.

**4.** The lithographic printing plate precursor according to any one of claims 1 to 3, wherein $L^1$ is represented by a formula (I-1)

$$(\Delta-Y^5-Y^6-Y^7)_{na}-Z^4-Y^8-Y^9-Y^{10} \qquad \text{(I-1)}$$

wherein $Z^4$ is selected from

C; $(C(R^p)_p)_{ny}$; $(-O)_3P=Y^4$ (with $Y^4$ being O or S); N;

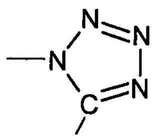 ; 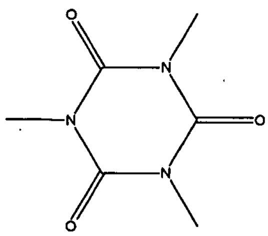 ; 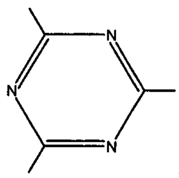 ;

a 5-6 membered saturated heterocyclic group containing 2 oxygen atoms; and a 5-6 membered aromatic or saturated carbocyclic group;

$Y^5$ to $Y^9$ are independently selected from single bond; -O-; -NR- with R being H, $C_{1-20}$ alkyl- or $C_{5-20}$ aryl; $-SO_2-$; $-((CH_2)_q-CR^aH-O)_{nb}-$ ; $-(O-C(=O)-(CH_2)_{nc})_{nb}-$; divalent aromatic, heteroaromatic, heterocyclic or cyclic group each optionally substituted by one or more substituents selected from halogen atoms and $C_{1-20}$ alkyl, or alkylene group, optionally substituted by one or more halogen atoms;

each $Y^{10}$ is independently selected from -*, $-(CH_2-CR^aH-O)_{ny}-*$ ; -T-* with T being a divalent aromatic, heteroaromatic, heterocyclic or cyclic group each optionally substituted by one or more substituents selected from halogen atoms and $C_{1-20}$ alkyl, or alkylene group, optionally substituted by one or more halogen atoms;

each $R^p$ is independently selected from H, $C_{1-5}$ alkyl and $-(CH_2)_e-\Delta$;

each $R^a$ is independently selected from H or $C_{1-5}$ alkyl;

with each na being an integer independently selected from 1 to 10; each nb being an integer independently selected from 1 to 10; each nc being an integer of at least 2;

each ny is independently an integer from 1 to 20;
e is 0 or an integer from 1 to 10;
p is 0 or 1 or 2; q is 0 or an integer from 1 to 5;
* denotes the binding site of $X^1$;
and $\Delta$ denotes the binding site of functional group $R^{EG}$ or H with $R^{EG}$ being selected from

(i) radical reactive groups having an ethylenically unsaturated double bond;
(ii) acidic groups selected from -COOH, $-SO_3H$, $-PO_3H_2$, and $-PO_4H_2$, and
(iii) hydrophilic or hydrophobic non-radical reactive and non-acidic groups which are different from isocyanate groups, -OH and -NHR groups;

with the proviso that $Z^4$ and $Y^5$ to $Y^{10}$ are selected such that $L^1$ of formula (I-1) does not contain

(1) an oxygen atom directly bonded to a nitrogen atom or another oxygen atom,
(2) a nitrogen atom directly bonded to another nitrogen atom, and
(3) a sulphur atom directly bonded to another sulphur atom.

**5.** The lithographic printing plate precursor according to any one of claims 1 to 4, wherein each $L^2$ is independently represented by a formula selected from (II-1') to (II-7'):

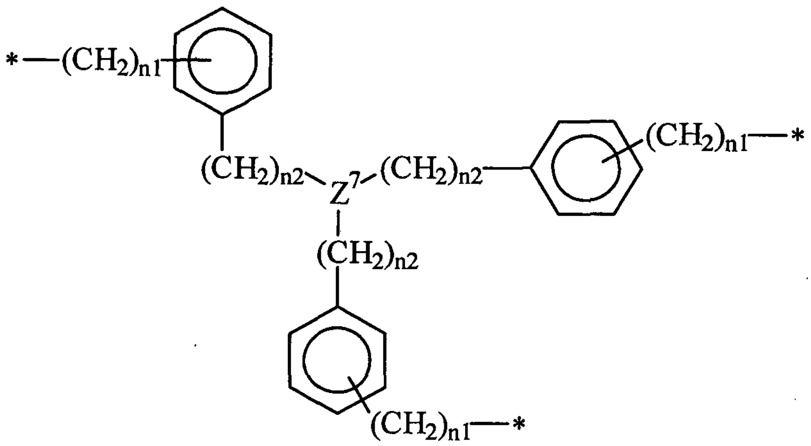

(II-1')

wherein $Z^7$ is $CR^4$,

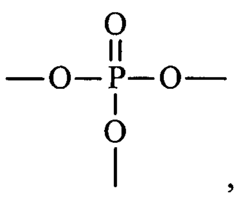

,

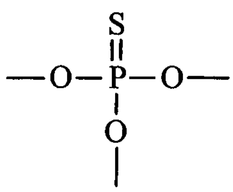

or N,

$R^4$ is H or $C_1$-$C_5$alkyl; each n1 is independently 0 or an integer of 1 to 10; each n2 is independently 0 or an integer of 1 to 10,
and * denotes the binding site of $X^2$;

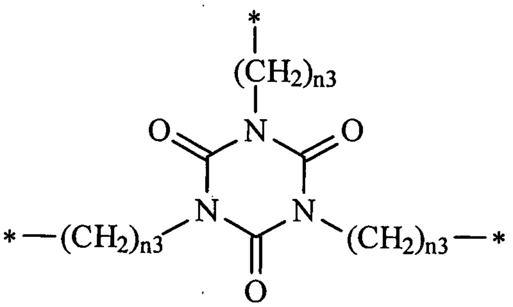

(II-2')

wherein each n3 is independently an integer of 2 to 10; and * denotes the binding site of $X^2$;

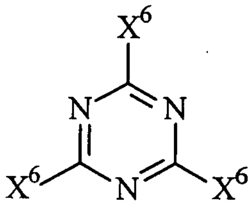

(II-3')

wherein each $X^6$ is independently * or

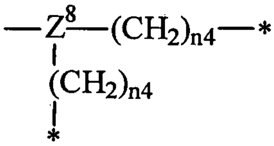

;

$Z^8$ is CH or N; n4 is an integer of 1 to 10; and * denotes the binding site of $X^2$;

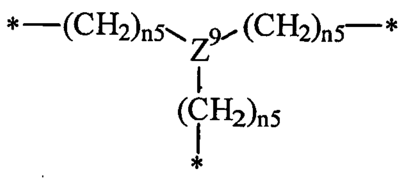

(II-4')

;

wherein $Z^9$ is $CR^4$ or N; $R^4$ is H or $C_1$-$C_5$alkyl; each n5 is independently 0 or an integer of 1 to 10; and * denotes the binding site of $X^2$;

$$(^*Y^{11})_3C[Y^{11}\text{-O-}Y^{11}\text{-}C(Y^{11})2]_{n11}Y^{11}{}^* \qquad \text{(II-5')}$$

wherein each $Y^{11}$ is independently selected from $-(CH_2)_{n6}-$ and $-(O-CH_2-CH_2)_{n7}-$ wherein the O atom is bonded to the central C atom in formula (II-5'); n6 and n7 are independently 0 or an integer of 1 to 10; n11 is 0, 1 or 2; and * denotes the binding site of $X^2$;

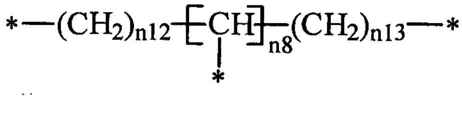

(II-6')

wherein n8 is an integer of 2 to 10; and * denotes the binding site of $X^2$; n12 and n13 are integers of 1 to 10;

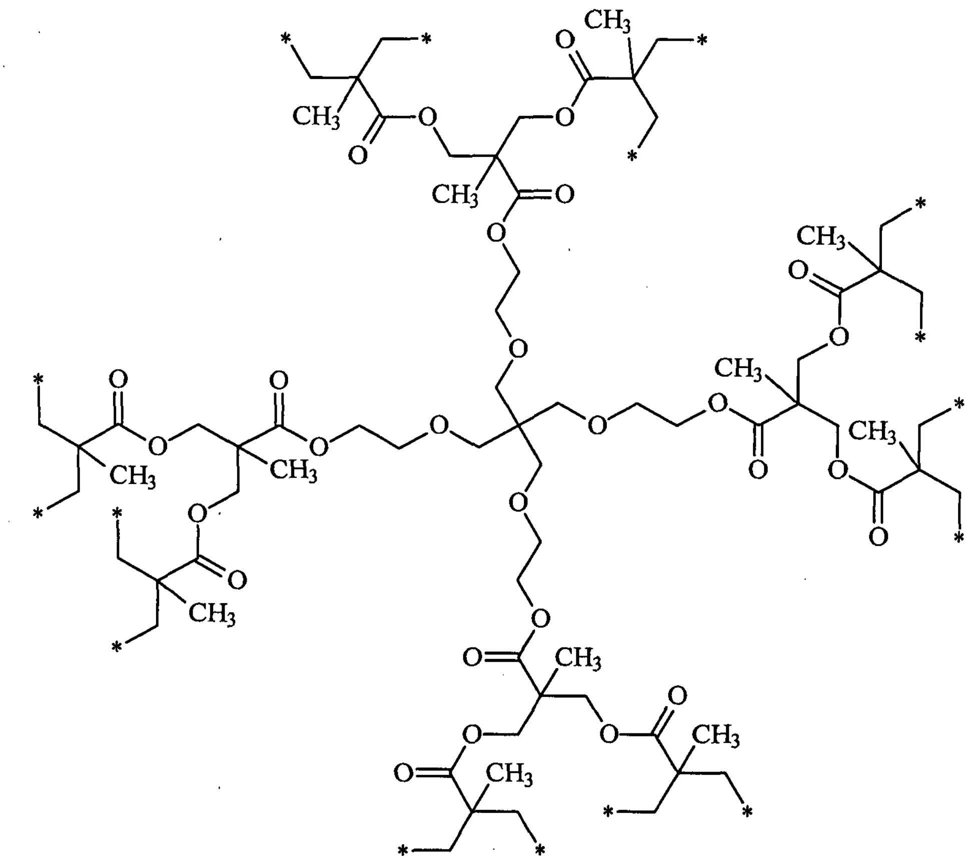

(II-7')

wherein * denotes the binding site of $X^2$.

**6.** The lithographic printing plate precursor according to any one of claims 1 to 5, wherein $L^1$ is represented by a formula selected from (I-1') to (I-8'):

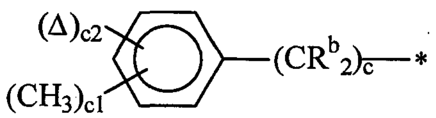

(I-1')

wherein c is 0 or 1; each $R^b$ is independently H or $CH_3$; c1 is 0 or 1; c2 is an integer of 1 to 3;
* denotes the binding site of $X^1$;
Δ denotes the binding site of a functional group $R^{EG}$ or H;

$$\Delta\text{-}(CR^c_2)_d\text{-}* \qquad \text{(I-2')}$$

wherein d is an integer of 1 to 20; each $R^c$ is independently H or $CH_3$; * denotes the binding site of $X^1$; Δ denotes the binding site of functional group $R^{EG}$ or H;

$$\Delta\text{-}(CH_2)_e\text{-}\underset{\substack{|\\ *}}{CR^d}\text{-}(CH_2)_e\text{-}\Delta \qquad \text{(I-3')}$$

wherein each e is independently an integer of 1 to 10;
$R^d$ is H or $-(CH_2)_e-$ Δ;
* denotes the binding site of $X^1$;
Δ denotes the binding site of functional groups $R^{EG}$ or H;

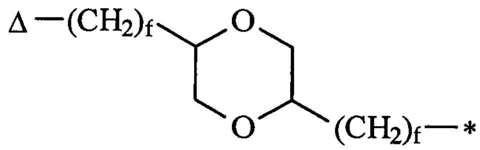

(I-4')

wherein each f is independently an integer of 1 to 10;
* denotes the binding site of $X^1$; $\Delta$ denotes the binding site of functional group $R^{EG}$ or H;

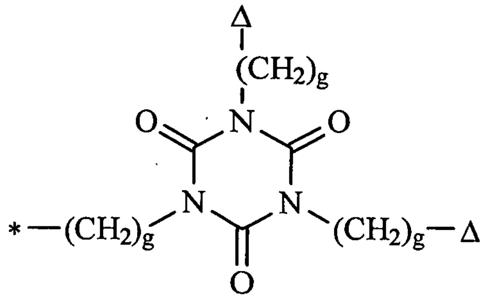

(I-5')

wherein each g is independently an integer of 1 to 10; * denotes the binding site of $X^1$; $\Delta$ denotes the binding site of functional groups $R^{EG}$ or H;

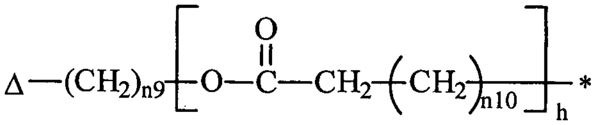

(I-6')

wherein h is an integer of 1 to 10; n9 is an integer of 1 to 10; n10 is an integer of 1 to 20;
* denotes the binding site of $X^1$; $\Delta$ denotes the binding site of functional group $R^{EG}$ or H;

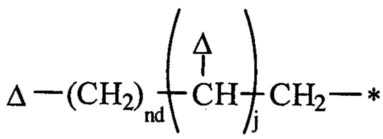

(I-7')

wherein j is an integer of 2 to 20; nd is an integer of 1 to 10; * denotes the binding site of $X^1$; $\Delta$ denotes the binding site of functional groups $R^{EG}$ or H;

$$R^e(CR^e_2\text{-}CH_2\text{-}O)_{a1}CH_2CR^e_2\text{-}CH_2\text{-}* \qquad (I\text{-}8')$$

wherein a1 is an integer of 1 to 20; each $R^e$ is independently H, $CH_3$ or $-(CH_2)_{a7}-\Delta$; a7 is 0 or an integer of 1 to 10;
$\Delta$ denotes the binding site of functional group $R^{EG}$ or H;
* denotes the binding site of $X^1$;
wherein in formulae (I-1') to (I-8') $R^{EG}$ is as defined in claim 4.

7. The lithographic printing plate precursor according to any one of claims 1 to 6, wherein functional groups $R^{EG}$ in the end group precursors of formula (I) are selected from -COOH, $-Y-C(O)CR^x=CH_2$, $-(Y)_b-(CH_2)_a-CR^xCH_2$, tetrazolyl and

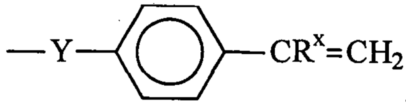

,

wherein Y is -O- or $-NR^y-$; $R^x$ is H or $CH_3$; $R^y$ is H, $C_{1-20}$alkyl or $C_{5-20}$aryl; a is 0 or 1; and b is 0 or 1.

**8.** The lithographic printing plate precursor according to any one of claims 1 to 7, wherein the branched binder comprises structural moieties derived from

(a) at least one end group precursor of formula (I) comprising at least one functional group $R^{EG}$ containing an ethylenically unsaturated double bond and
(b) at least one end group precursor of formula (I) comprising at least one functional group $R^{EG}$ which is selected from -COOH, $-SO_3H$, $-PO_3H_2$ and $-PO_4H_2$, preferably is -COOH.

**9.** The lithographic printing plate precursor according to any one of claims 1 to 8, wherein the branching unit precursor of formula (II) is a triisocyanate.

**10.** The lithographic printing plate precursor according to any of claims 1 to 9, wherein at least one end group precursors of formula (I) is selected from Aryl-OH, Aryl-$CH_2$-OH, Alkyl-OH, Aryl-$NH_2$, Aryl-$CH_2$-$NH_2$, Alkyl-$NH_2$, Alkyl-NCO, Aryl-NCO, Aryl-$CH_2$-NCO, R-O-$(CH_2CH_2\text{-}O)_yH$, R-O-$(CH(CH_3)CH_2\text{-}O)_zH$,

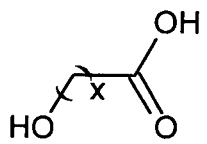
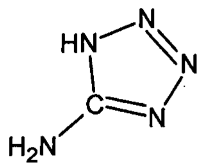
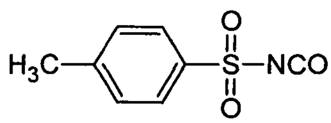
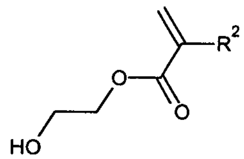

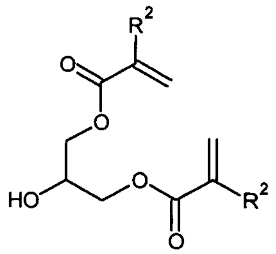
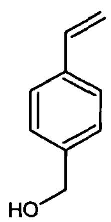
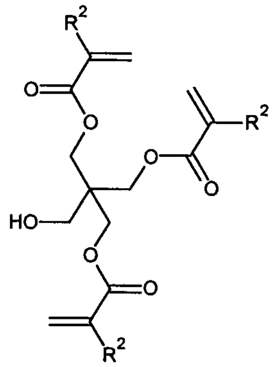
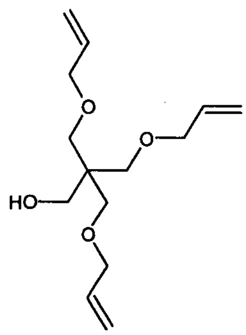

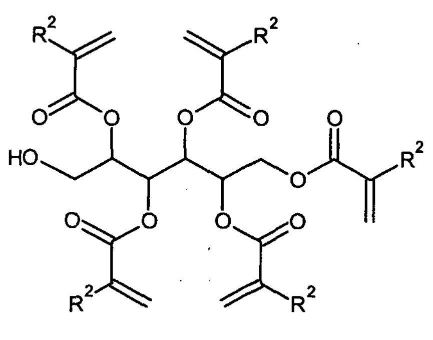
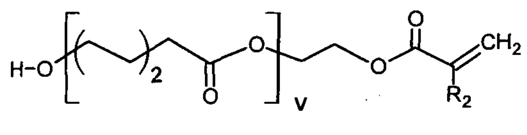

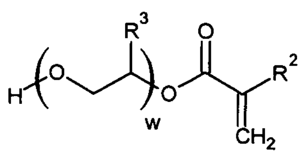
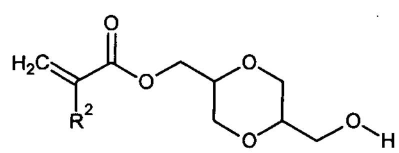

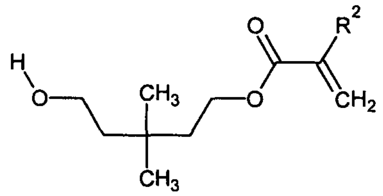 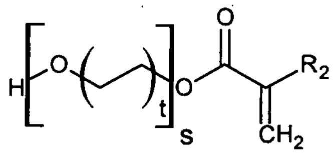

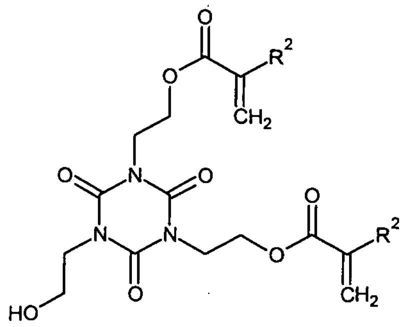 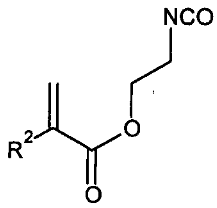 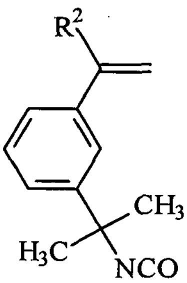

wherein each $R^2$ and $R^3$ is independently H or $CH_3$;
R is $C_{5-20}$aryl or $C_{1-20}$alkyl;
each of x, y, z, t, s and w is independently an integer of 1 to 20;
v is an integer of 1 to 10;
Aryl is phenyl or naphthyl which may be optionally substituted with 1 to 5 substituents independently selected from $C_{1-50}$alkyl; ar($C_{1-50}$)alkyl; halogen; and -Si($R^z$)$_3$ with $R^z$ being $C_{1-10}$alkyl or $C_{1-10}$alkoxy;
and
"Alkyl" means straight-chain or branched chain $C_1$-$C_{50}$ alkyl which may be optionally substituted by one or more groups selected from aryl; halogen; and -Si($R^z$)$_3$ with $R^z$ being $C_{1-10}$alkyl or $C_{1-10}$alkoxy.

**11.** The lithographic printing plate precursor according to any one of claims 1 to 10, wherein at least one branching unit precursor of formula (II) is selected from

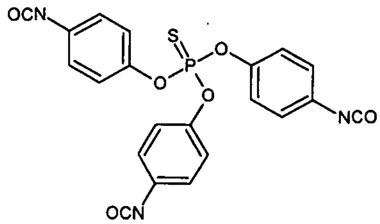 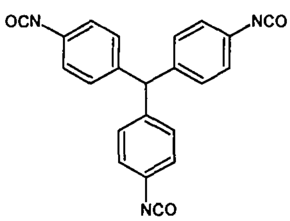 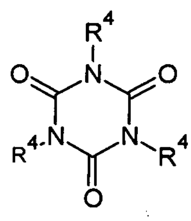 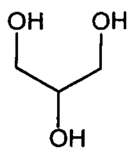

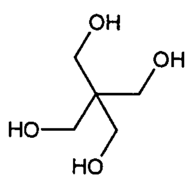 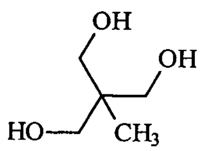 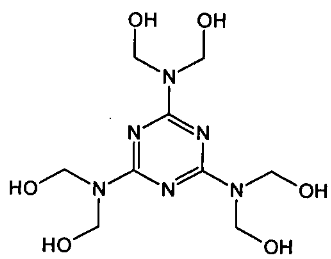

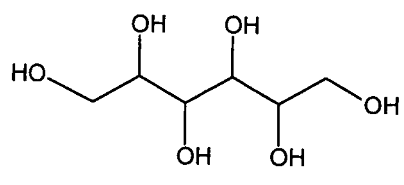 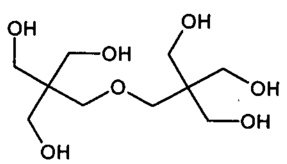

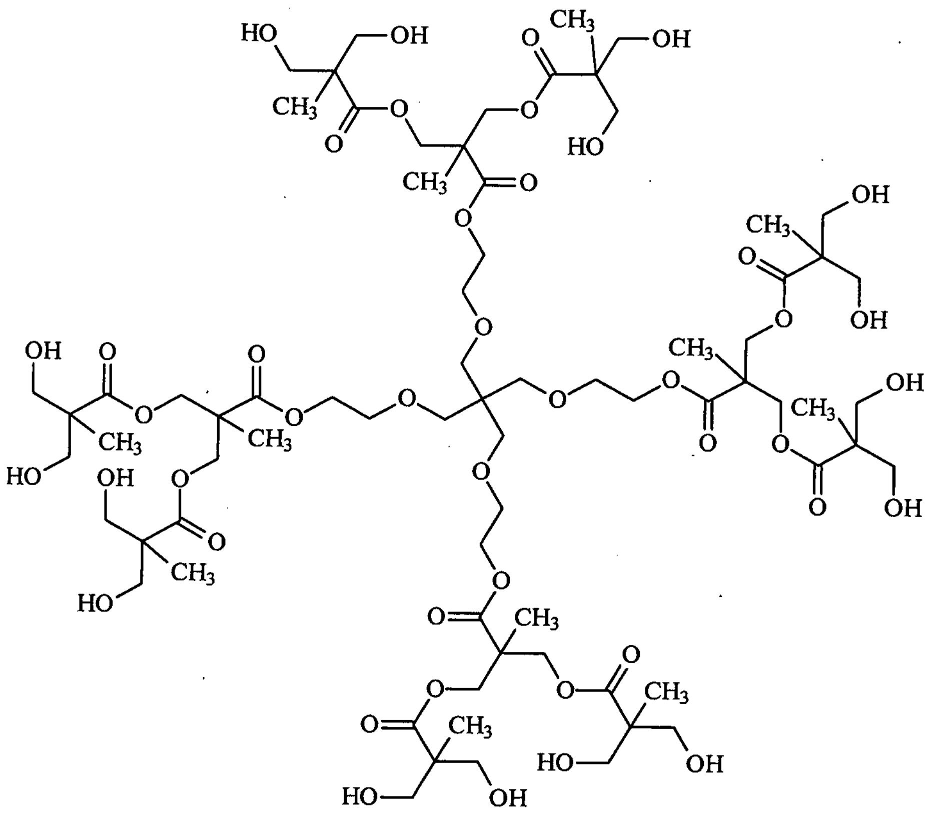

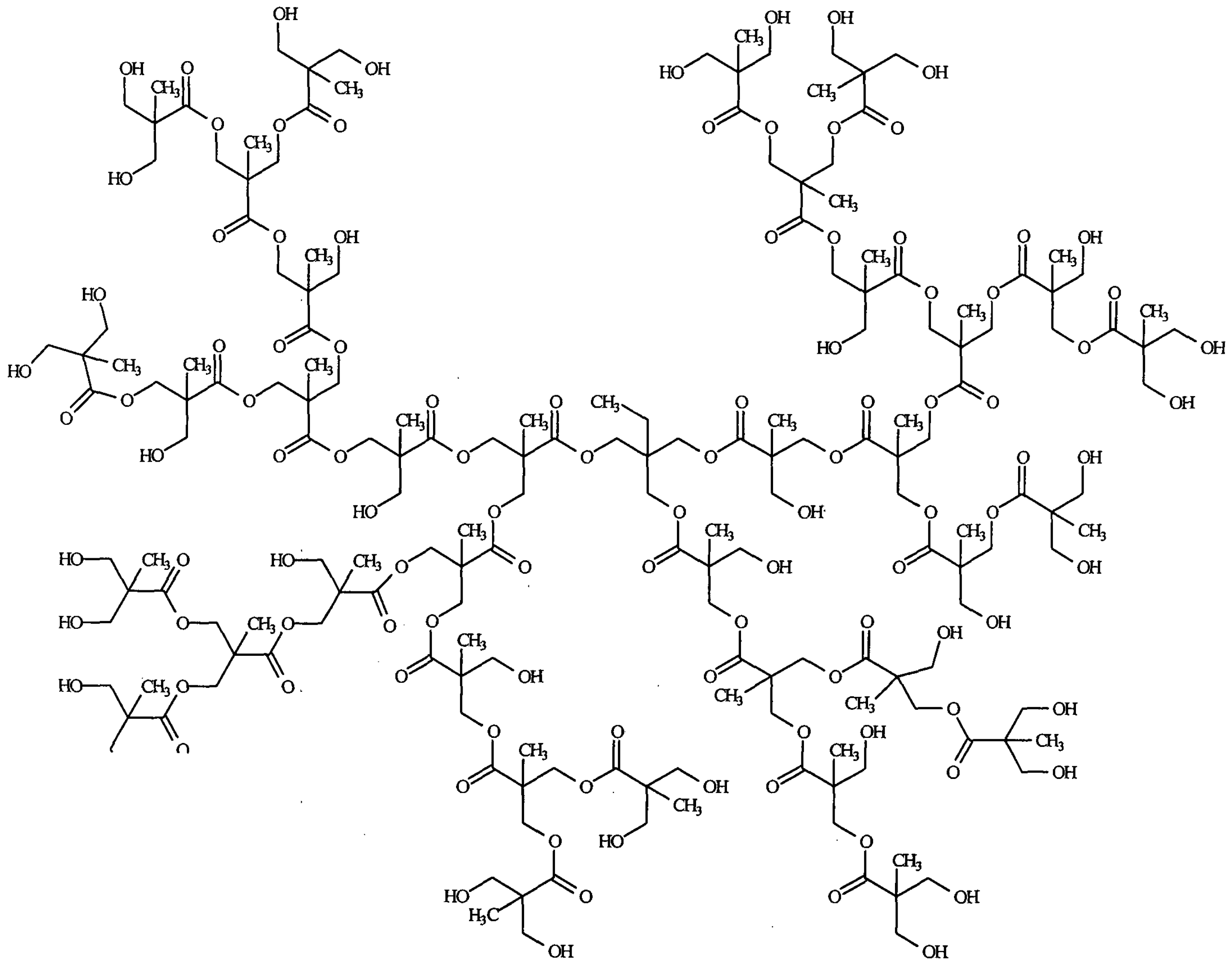

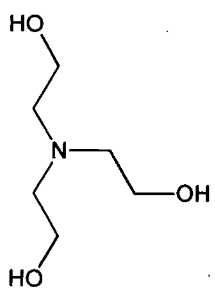

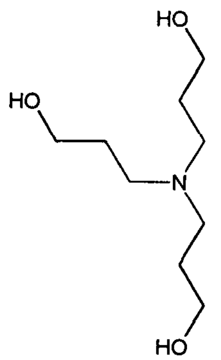

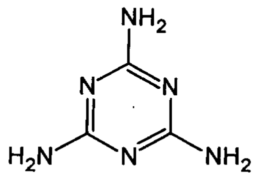

wherein each $R^4$ is $-(CH_2)_uNCO$ or $-(CH_2)_uOH$ with u being an integer of 2 to 10.

**12.** The lithographic printing plate precursor according to any one of claims 1 to 11, wherein at least one spacer unit precursor of formula (III) is used which is selected from

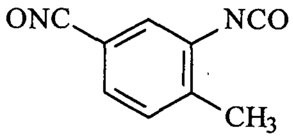 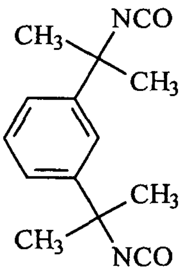 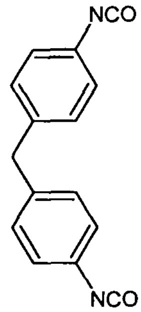 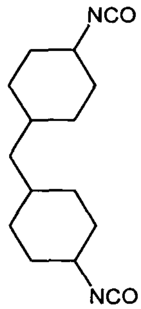

$OCN\text{-}(CH_2)_{a2}\text{-}NCO$; $OH\text{-}(CH_2)_{a3}\text{-}OH$; $OH\text{-}(CH_2CH_2\text{-}O)_{a4}\text{-}H$; $OH\text{-}(CH(CH_3)CH_2\text{-}O)_{a5}\text{-}H$; $OH\text{-}CH_2\text{-}C(CH_3)_2\text{-}CH_2\text{-}OH$

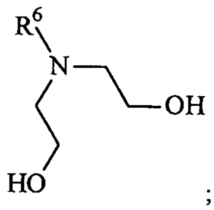
;

$H_2N\text{-}(CH_2)_{a6}\text{-}NH_2$; $H_2N\text{-}Aryl\text{-}NH_2$;

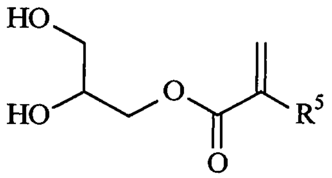

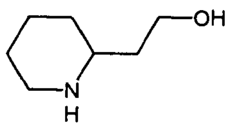

wherein a2 is an integer of 1 to 20; a3 is an integer of 1 to 20; a4 is an integer of 1 to 20; a5 is an integer of 1 to 20; a6 is an integer of 1 to 20; $R^5$ is H or $CH_3$; $R^6$ is $C_{1\text{-}20}$alkyl or $C_{5\text{-}20}$aryl,
"Aryl" is phenyl or naphthyl which may be optionally substituted with 1 to 5 substituents selected from $C_{1\text{-}50}$alkyl, ar$C_{1\text{-}50}$alkyl, halogen, and $\text{-}Si(R^z)_3$, with $R^z$ being $C_{1\text{-}10}$alkyl or $C_{1\text{-}10}$ alkoxy.

**13.** The lithographic printing plate precursor according to any one of claims 1 to 12 wherein the radical forming component absorbs wavelength in the range of 300 to 750 nm or wavelength in the range of above 750 to 1200 nm.

**14.** Process for preparing an imaged lithographic printing plate precursor, comprising

(a) imagewise exposing a lithographic printing plate precursor as defined in any one of claims 1 to 13
(b) removing the non-exposed areas of the coating of the lithographic printing plate precursor with an aqueous developer having a pH from 5 to 14, wherein the developer optionally comprises a film-forming hydrophilic polymer.

## Patentansprüche

**1.** Ein negativ arbeitender Lithographie-Druckplattenvorläufer, umfassend:

(a) einen Träger,

(b) eine negativ arbeitende strahlungsempfindliche Beschichtung, umfassend:

(i) 10 bis 90 Gew.-%, bezogen auf das Trockenschichtgewicht, eines verzweigten Bindemittelmaterials,
(ii) mindestens eine radikalbildende Komponente, ausgewählt aus Photoinitiatoren und Sensibilisator/Coinitiatorsystemen, die Wellenlängen im Bereich von 300 bis 1200 nm absorbiert und in der Lage ist, eine radikalische Polymerisation zu initiieren, und
(iii) mindestens eine Verbindung mit mindestens zwei radikalisch polymerisierbaren Gruppen pro Molekül und einer Tg < 30°C,

(c) und gegebenenfalls eine als Sauerstoffbarriere wirkende Deckschicht;

**dadurch gekennzeichnet, dass** das verzweigte Bindemittelmaterial radikalisch polymerisierbare Gruppen umfasst, ein Zahlenmittel des Molekulargewichts im Bereich von 500 bis 15000 und eine Tg > 30°C aufweist und aus Struktureinheiten besteht, die durch Urethan- und/oder Harnstoffverknüpfungen miteinander verbunden sind, wobei die Struktureinheiten von $n_{EG}$ Mol von Endgruppenvorläufern der Formel (I), $n_{BU}$ Mol von Verzweigungseinheitsvorläufern der Formel (II) und gegebenenfalls $n_{SU}$ Mol von Abstandshaltereinheitsvorläufern der Formel (III) abgeleitet sind

$L^1X^1$ (I)

$L^2(X^2)_n$ (II)

$L^3(X^3)_2$ (III)

wobei jedes $X^1$, $X^2$ und $X^3$ unabhängig eine Isocyanatgruppe, oder die gleiche oder unterschiedliche Isocyanat-reaktive Gruppe, ausgewählt aus der Gruppe bestehend aus -OH und -NHR, ist, wobei R gleich H, $C_{1-20}$-Alkyl- oder $C_{5-20}$-Aryl ist, jedes $L^1$ , $L^2$ und $L^3$ unabhängig eine gegebenenfalls substituierte aliphatische, aromatische, heterocyclische oder heteroaromatische Einheit mit einer Wertigkeit von 1, n bzw. 2 ist, wobei n eine ganze Zahl gleich oder größer als 3 ist; und wobei $L^1$, $L^2$ und $L^3$ keine Urethan- und Harnstoffverknüpfungen enthalten, abgesehen von Harnstoffverknüpfungen, die Teil von Cyanursäurederivaten sind, die die Struktureinheit

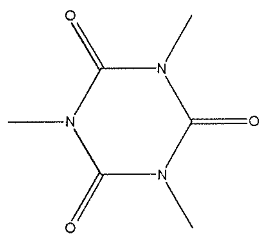

aufweisen; und wobei die molaren Mengen $n_{EG}$, $n_{BU}$ und $n_{SU}$ die folgenden Bedingungen erfüllen, $n_{EG} > n_{BU} > 0$ und $0 \leq n_{SU} < (n_{EG} + n_{BU})$.

**2.** Der Lithographie-Druckplattenvorläufer gemäß Anspruch 1, wobei das verzweigte Bindemittelmaterial durch sequentielle Zugabe von Vorläufern auf eine solche Weise erhalten wird, dass Urethan- oder Harnstoffverknüpfungen nach einem konvergenten Mechanismus gebildet werden, der die folgenden Schritte umfasst:

A) gleichzeitige oder aufeinanderfolgende Umsetzung eines oder mehrerer Endgruppenvorläufer der Formel (I) mit einem Verzweigungseinheitsvorläufer der Formel (II) in einem Molverhältnis von Endgruppenvorläufer zu Verzweigungseinheitsvorläufer von (n-1) : 1, um das erste Zwischenprodukt zu bilden, wobei eine der n reaktiven Gruppen $X^2$ des Verzweigungseinheitsvorläufers unreagiert bleibt, wobei n die Mole von $X^2$ pro Vorläufermolekül der Verzweigungseinheit sind, wie in Anspruch 1 definiert;
B) gegebenenfalls Umsetzung des ersten Zwischenprodukts mit einem anderen Verzweigungseinheitsvorläufer der Formel (II) in einem Molverhältnis des ersten Zwischenprodukts zu dem anderen Verzweigungseinheitsvorläufer von (n-1) : 1, um das nächste Zwischenprodukt zu bilden, wobei eine der n reaktiven Gruppen $X^2$ des anderen Verzweigungseinheitsvorläufers unreagiert bleibt, und Wiederholung von Schritt (B) null bis fünfmal, um ein letztes Zwischenprodukt zu bilden;
C) Umsetzung des ersten oder letzten Zwischenprodukts mit einem Vorläufer der Formel (I), (II) oder (III) in einem molaren Verhältnis derart, dass die Anzahl der Äquivalente der Isocyanat-reaktiven Gruppen gleich oder

größer als die Anzahl der Äquivalente der Isocyanatgruppen ist,
D) und gegebenenfalls vor Schritt (A) und/oder zwischen Schritten (A) und (B) und/oder zwischen Schritten (B) und (C) und/oder zwischen verschiedenen Schritten (B) Umsetzung mit Abstandshaltereinheitsvorläufer der Formel (III) in einem Molverhältnis des jeweiligen Zwischenprodukts/Endgruppenvorläufers zu Abstandshaltereinheitsvorläufer von 1: 1, um das nächste Zwischenprodukt zu bilden, wobei eine der beiden reaktiven Gruppen $X^3$ des Abstandshaltereinheitsvorläufers unreagiert bleibt,

mit der Maßgabe, dass in jedem Umsetzungsschritt (A) bis (D) ein Umsetzungspartner eine Isocyanatfunktionalität aufweist und der andere Umsetzungspartner eine isocyanatreaktive Funktionalität, die aus -OH und -NHR ausgewählt ist, aufweist, wobei R gleich $C_{1-20}$-Alkyl- oder $C_{5-20}$-Aryl ist, so dass zwischen den Umsetzungspartnern Urethan- oder Harnstoffverknüpfungen gebildet werden.

3. Der Lithographie-Druckplattenvorläufer gemäß einem der Ansprüche 1 bis 2, wobei jedes $L^2$ unabhängig durch die Formel (II-1) dargestellt ist:

$$Z^1[-(Y^1-Y^2)]_{nx} \qquad \text{(II-1)}$$

wobei $Z^1$ ausgewählt ist aus $(C(R^a)_p)_{ny}$; $(-O)_3P=Y^4$ (wobei $Y^4$ gleich O oder S ist); N;

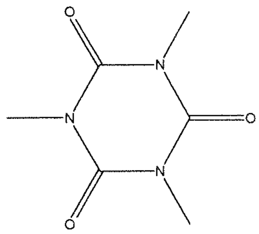

;

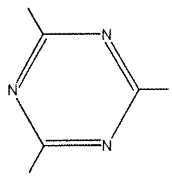

;

einer 5- bis 6-gliedrigen aromatischen oder gesättigten carbocyclischen Gruppe; oder einer verzweigten Polyestereinheit, basierend auf Dimethylolpropionsäure und einem mehrwertigen Alkohol;
$Y^1$ und $Y^2$ unabhängig ausgewählt sind aus einer Einfachbindung; -O-; -NR-, wobei R für H, $C_{1-20}$-Alkyl oder $C_{5-20}$-Aryl steht; $-((CH_2)_q-CR^aH-O)_{ny}-$, einer zweiwertigen aromatischen, heteroaromatischen, heterocyclischen oder cyclischen Gruppe oder einer Alkylengruppe, die jeweils gegebenenfalls substituiert sind; $-C((-CR^aH)_{nz}-*)_2$, oder $-CR^a((-CR^aH)_{nz}-*)$;
jedes $Y^3$ unabhängig ausgewählt ist aus -*; $-(CH_2-CR^aH-O)_{ny}-*$; -T-*, wobei T eine zweiwertige aromatische, heteroaromatische, heterocyclische oder cyclische Gruppe ist, die jeweils gegebenenfalls substituiert ist mit einem oder mehreren Substituenten, ausgewählt aus Halogenatomen und $C_{1-20}$-Alkyl, oder eine Alkylengruppe ist, die gegebenenfalls substituiert ist mit einem oder mehreren Halogenatomen; oder $-Z^2((-CR^aH)_{ny}-*)_2$, wobei $Z^2$ gleich CH oder N ist; oder $-Z^3((-CR^aH)_{ny}-*)_3$, wobei $Z^3$ gleich C ist;
jedes $R^a$ unabhängig ausgewählt ist aus H oder $C_{1-5}$-Alkyl,
wobei jedes nz eine ganze Zahl, unabhängig ausgewählt aus 0 bis 10, ist; jedes ny eine ganze Zahl, unabhängig ausgewählt aus 1 bis 10, ist; jedes nx eine ganze Zahl von mindestens 3 ist, abhängig von der Wertigkeit von $Z^1$; p gleich 0 oder 1 oder 2 ist; q gleich 0 oder eine ganze Zahl von 1 bis 5 ist;
und * die Bindungsstelle von $X^2$ bezeichnet;
mit der Maßgabe, dass $Z^1$, $Y^1$, $Y^2$ und $Y^3$ so gewählt werden, dass $L^2$ der Formel (II-1) nicht enthält:

(1) ein direkt an ein Stickstoffatom oder ein anderes Sauerstoffatom gebundenes Sauerstoffatom und
(2) ein direkt an ein anderes Stickstoffatom gebundenes Stickstoffatom.

4. Der Lithographie-Druckplattenvorläufer gemäß einem der Ansprüche 1 bis 3, wobei $L^1$ durch eine Formel (I-1) dargestellt ist:

$$(\Delta\text{-}Y^5\text{-}Y^6\text{-}Y^7)_{na}\text{-}Z^4\text{-}Y^8\text{-}Y^9\text{-}Y^{10} \qquad \text{(I-1)}$$

wobei $Z^4$ ausgewählt ist aus
C; $(C(R^p)_p)_{ny}$; $(-O)_3P=Y^4$ (wobei $Y^4$ gleich O oder S ist); N;

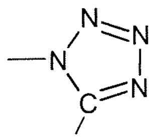 ; 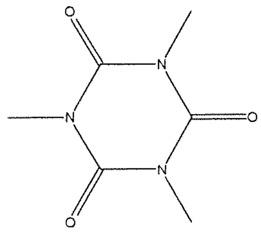 ; 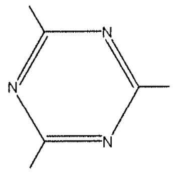 ;

einer 5-6-gliedrigen gesättigten heterocyclischen Gruppe mit 2 Sauerstoffatomen; und einer 5-6-gliedrigen aromatischen oder gesättigten carbocyclischen Gruppe;
$Y^3$ bis $Y^9$ unabhängig ausgewählt sind aus einer Einfachbindung; -O-; -NR-, wobei R gleich H, $C_{1-20}$-Alkyl- oder $C_{5-20}$-Aryl ist; $-SO_2-$; $-((CH_2)_q-CR^aH-O)_{nb}-$; $-(O-C(=O)-(CH_2)_{nc})_{nb}-$; einer zweiwertigen aromatischen, heteroaromatischen, heterocyclischen oder cyclischen Gruppe, die jeweils gegebenenfalls substituiert sind mit einem oder mehreren Substituenten, ausgewählt aus Halogenatomen und $C_{1-20}$-Alkyl, oder einer Alkylengruppe, die gegebenenfalls substituiert ist mit einem oder mehreren Halogenatom(en);
jedes $Y^{10}$ unabhängig ausgewählt ist aus -*, $-(CH_2-CR^aH-O)_{ny}-*$; -T-*, wobei T eine zweiwertige aromatische, heteroaromatische, heterocyclische oder cyclische Gruppe ist, die jeweils gegebenenfalls substituiert ist mit einem oder mehreren Substituenten ausgewählt aus Halogenatomen und $C_{1-20}$-Alkyl, oder einer Alkylengruppe, die gegebenenfalls substituiert ist mit einem oder mehreren Halogenatom(en);
jedes $R^p$ unabhängig ausgewählt ist aus H, $C_{1-5}$-Alkyl und $-(CH_2)_e-\Delta$;
jedes $R^a$ unabhängig ausgewählt ist aus H oder $C_{1-5}$-Alkyl;
wobei jedes na eine ganze Zahl, unabhängig ausgewählt aus 1 bis 10, ist; jedes nb eine ganze Zahl, unabhängig ausgewählt aus 1 bis 10, ist; jedes nc eine ganze Zahl von mindestens 2 ist; jedes ny unabhängig eine ganze Zahl von 1 bis 20 ist;
e gleich 0 oder eine ganze Zahl von 1 bis 10 ist;
p gleich 0 oder 1 oder 2 ist;
q gleich 0 oder eine ganze Zahl von 1 bis 5 ist;
* die Bindungsstelle von $X^1$ bezeichnet;
und Δ die Bindungsstelle der funktionellen Gruppe $R^{EG}$ oder H bezeichnet, wobei $R^{EG}$ ausgewählt ist aus

(i) radikalisch reaktiven Gruppen mit einer ethylenisch ungesättigten Doppelbindung;
(ii) sauren Gruppen ausgewählt aus -COOH, $-SO_3H$, $-PO_3H_2$ und $-PO_4H_2$ und
(iii) hydrophilen oder hydrophoben nicht-radikalisch reaktiven und nicht sauren Gruppen, die sich von Isocyanatgruppen, -OH und NHR-Gruppen unterscheiden;

mit der Maßgabe, dass $Z^4$ und $Y^5$ bis $Y^{10}$ so gewählt werden, dass $L^1$ der Formel (I-1) nicht enthält:

(1) ein direkt an ein Stickstoffatom oder ein anderes Sauerstoffatom gebundenes Sauerstoffatom
(2) ein direkt an ein anderes Stickstoffatom gebundenes Stickstoffatom und
(3) ein direkt an ein anderes Schwefelatom gebundenes Schwefelatom.

**5.** Der Lithographie-Druckplattenvorläufer gemäß einem der Ansprüche 1 bis 4, wobei jedes $L^2$ unabhängig durch eine Formel dargestellt ist, die aus (II-1') bis (11-7') ausgewählt ist:

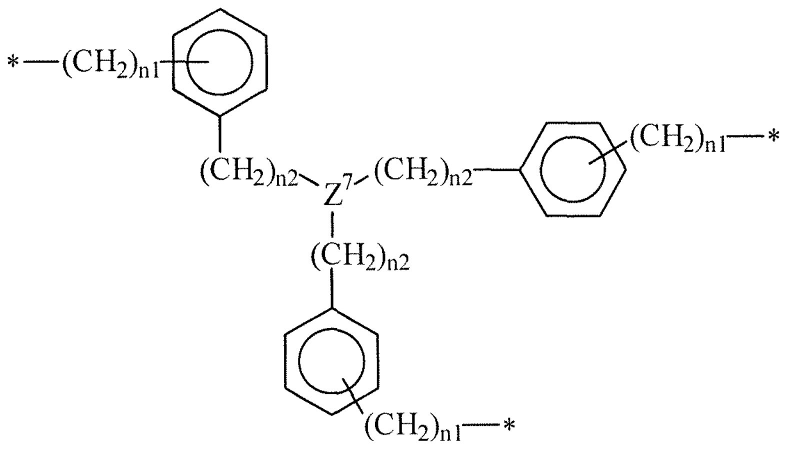

(II-1')

wobei $Z^7$ gleich $CR^4$,

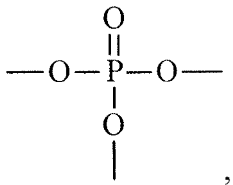

,

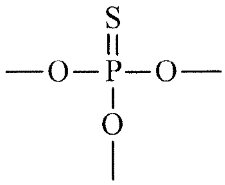

oder N ist,
$R^4$ gleich H oder $C_1$-$C_5$-Alkyl ist; jedes n1 unabhängig 0 oder eine ganze Zahl von 1 bis 10 ist; jedes n2 unabhängig 0 oder eine ganze Zahl von 1 bis 10 ist,
und * die Bindungsstelle von $X^2$ bezeichnet;

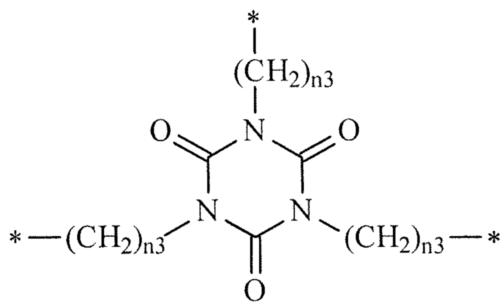

(II-2')

wobei jedes n3 unabhängig eine ganze Zahl von 2 bis 10 ist;
und * die Bindungsstelle von $X^2$ bezeichnet;

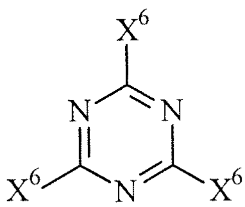

(II-3')

wobei jedes $X^6$ unabhängig * oder

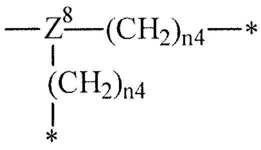

ist;
$Z^8$ gleich CH oder N ist; n4 eine ganze Zahl von 1 bis 10 ist; und * die Bindungsstelle von $X^2$ bezeichnet;

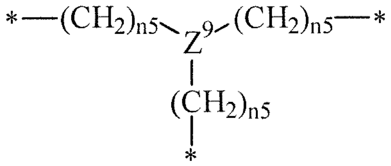

(II-4')

;

wobei $Z^9$ gleich $CR^4$ oder N ist; $R^4$ gleich H oder $C_1$-$C_5$-Alkyl ist; jedes n5 unabhängig 0 oder eine ganze Zahl von 1 bis 10 ist; und * die Bindungsstelle von $X^2$ bezeichnet;

$$(^*Y^{11})_3C[Y^{11}\text{-}O\text{-}Y^{11}\text{-}C(Y^{11*})2]_{n11}Y^{11*} \qquad \text{(II-5')}$$

wobei jedes $Y^{11}$ unabhängig ausgewählt ist aus $-(CH_2)_{n6}-$ und $-(O\text{-}CH_2\text{-}CH_2)_{n7}-$ wobei das O-Atom an das zentrale C-Atom in Formel (II-5') gebunden ist; n6 und n7 unabhängig 0 oder eine ganze Zahl von 1 bis 10 sind; n11 gleich 0, 1 oder 2 ist; und * die Bindungsstelle von $X^2$ bezeichnet;

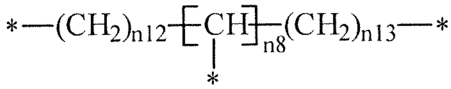

(II-6')

wobei n8 eine ganze Zahl von 2 bis 10 ist; und * die Bindungsstelle von $X^2$ bezeichnet; n12 und n13 ganze Zahlen von 1 bis 10 sind;

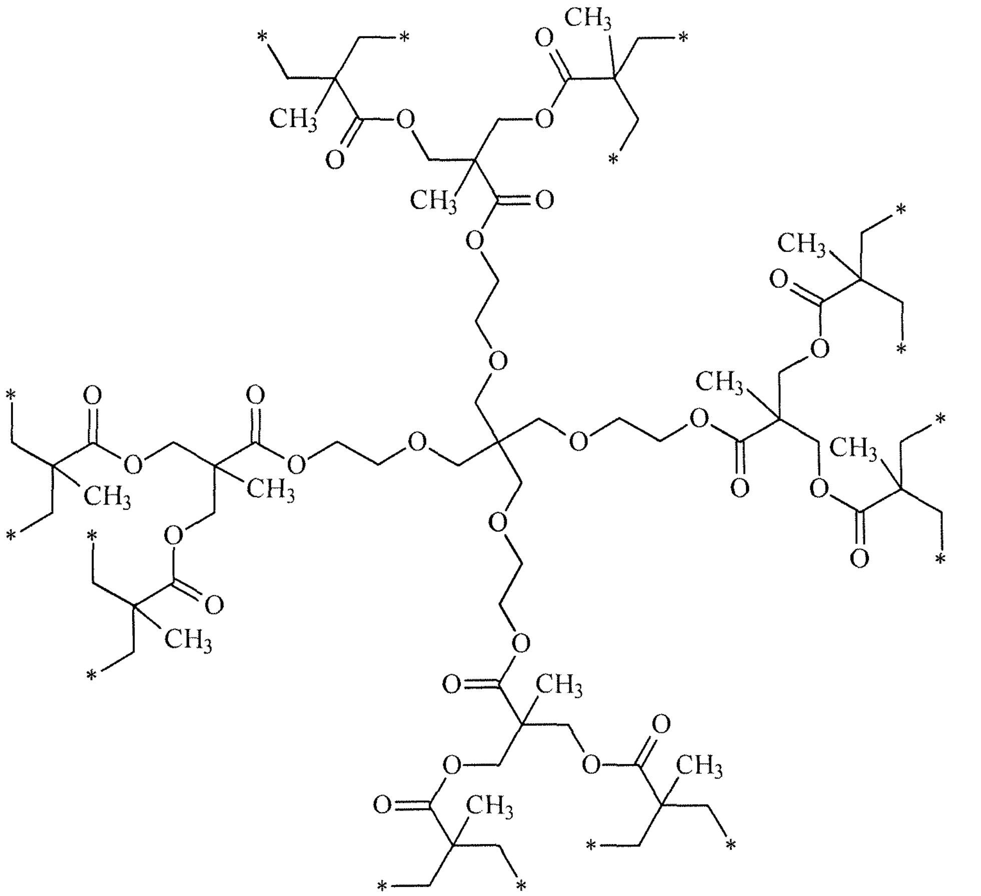

(II-7')

wobei * die Bindungsstelle von $X^2$ bezeichnet.

**6.** Der Lithographie-Druckplattenvorläufer gemäß einem der Ansprüche 1 bis 5, wobei $L^1$ durch eine Formel dargestellt wird, die aus (I-1') bis (I-8') ausgewählt ist:

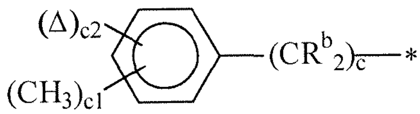

(I-1')

wobei c gleich 0 oder 1 ist; jedes $R^b$ unabhängig H oder $CH_3$ ist; c1 gleich 0 oder 1 ist; c2 eine ganze Zahl von 1 bis 3 ist;
* die Bindungsstelle von $X^1$ bezeichnet;
Δ die Bindungsstelle einer funktionellen Gruppe $R^{EG}$ oder H bezeichnet;

$\Delta\text{-}(CR^c_2)_d\text{-}*$ (I-2')

wobei d eine ganze Zahl von 1 bis 20 ist; jedes $R^c$ unabhängig H oder $CH_3$ ist; * die Bindungsstelle von $X^1$ bezeichnet; Δ die Bindungsstelle der funktionellen Gruppe $R^{EG}$ oder H bezeichnet;

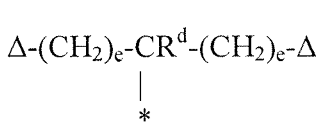

(I-3')

wobei jedes e unabhängig eine ganze Zahl von 1 bis 10 ist;
$R^d$ gleich H oder $-(CH_2)_e\text{-}\Delta$ ist;
* die Bindungsstelle von $X^1$ bezeichnet;

Δ die Bindungsstelle der funktionellen Gruppen $R^{EG}$ oder H bezeichnet;

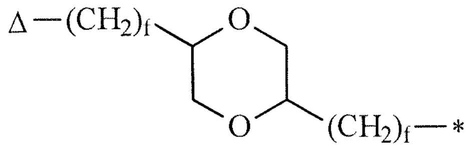

(I-4')

wobei jedes f unabhängig eine ganze Zahl von 1 bis 10 ist;
* die Bindungsstelle von $X^1$ bezeichnet; Δ die Bindungsstelle der funktionellen Gruppe $R^{EG}$ oder H bezeichnet;

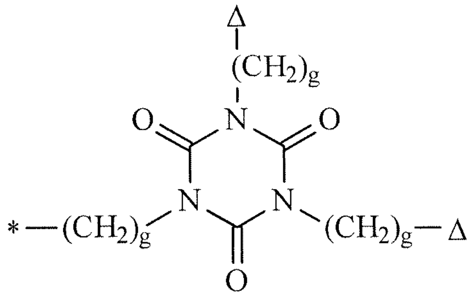

(I-5')

wobei jedes g unabhängig eine ganze Zahl von 1 bis 10 ist; * die Bindungsstelle von $X^1$ bezeichnet; Δ die Bindungsstelle der funktionellen Gruppen $R^{EG}$ oder H bezeichnet;

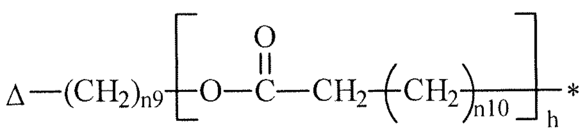

(I-6')

wobei h eine ganze Zahl von 1 bis 10 ist; n9 eine ganze Zahl von 1 bis 10 ist; n10 eine ganze Zahl von 1 bis 20 ist; * die Bindungsstelle von $X^1$ bezeichnet; Δ die Bindungsstelle der funktionellen Gruppe $R^{EG}$ oder H bezeichnet;

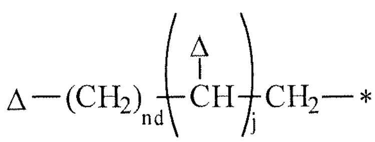

(I-7')

wobei j eine ganze Zahl von 2 bis 20 ist; nd eine ganze Zahl von 1 bis 10 ist; * die Bindungsstelle von $X^1$ bezeichnet; Δ die Bindungsstelle der funktionellen Gruppen $R^{EG}$ oder H bezeichnet;

$R^e(CR^e_2\text{-}CH_2\text{-}O)_{a1}CH_2CR^e_2\text{-}CH_2\text{-}*$ (I-8')

wobei a1 eine ganze Zahl von 1 bis 20 ist; jedes $R^e$ unabhängig H, $CH_3$ oder $-(CH_2)_{a7}-\Delta$ ist; a7 gleich 0 oder eine ganze Zahl von 1 bis 10 ist;
Δ die Bindungsstelle der funktionellen Gruppe $R^{EG}$ oder H bezeichnet;
* die Bindungsstelle von $X^1$ bezeichnet;
wobei in den Formeln (I-1') bis (I-8') $R^{EG}$ wie in Anspruch 4 definiert ist.

**7.** Der Lithographie-Druckplattenvorläufer gemäß einem der Ansprüche 1 bis 6, wobei die funktionellen Gruppen $R^{EG}$ in den Endgruppenvorläufern der Formel (I) ausgewählt sind aus -COOH, $-Y-C(O)CR^x=CH_2$, $-(Y)_b-(CH_2)_a-CR^xCH_2$, Tetrazolyl und

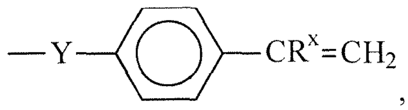

,

wobei Y gleich -O- oder -$NR^y$- ist; $R^x$ gleich H oder $CH_3$ ist; $R^y$ gleich H, $C_{1-20}$-Alkyl oder $C_{5-20}$-Aryl ist; a gleich 0 oder 1 ist; und b gleich 0 oder 1 ist.

**8.** Der Lithographie-Druckplattenvorläufer gemäß einem der Ansprüche 1 bis 7, wobei das verzweigte Bindemittel Struktureinheiten umfasst, die abgeleitet sind von

(a) mindestens einem Endgruppenvorläufer der Formel (I), der mindestens eine funktionelle Gruppe $R^{EG}$ umfasst, die eine ethylenisch ungesättigte Doppelbindung enthält und
(b) mindestens einem Endgruppenvorläufer der Formel (I), der mindestens eine funktionelle Gruppe $R^{EG}$ umfasst, die ausgewählt ist aus -COOH, -$SO_3H$, -$PO_3H_2$ und -$PO_4H_2$, und die vorzugsweise -COOH ist.

**9.** Der Lithographie-Druckplattenvorläufer gemäß einem der Ansprüche 1 bis 8, wobei der Verzweigungseinheitsvorläufer der Formel (II) ein Triisocyanat ist.

**10.** Der Lithographie-Druckplattenvorläufer gemäß einem der Ansprüche 1 bis 9, wobei mindestens ein Endgruppenvorläufer der Formel (I) ausgewählt ist aus Aryl-OH, Aryl-$CH_2$-OH, Alkyl-OH, Aryl-$NH_2$, Aryl-$CH_2$-$NH_2$, Alkyl-$NH_2$, Alkyl-NCO, Aryl-NCO, Aryl-$CH_2$-NCO, R-O-($CH_2CH_2$-O)$_y$H, R-O-(CH($CH_3$)$CH_2$-O)$_z$H,

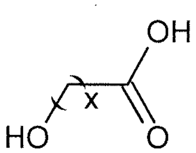

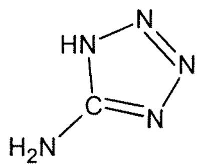

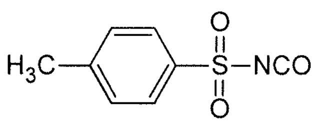

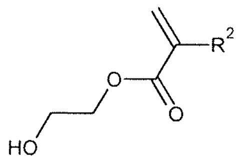

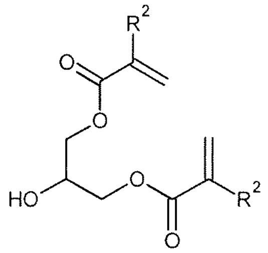

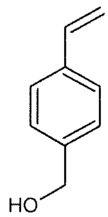

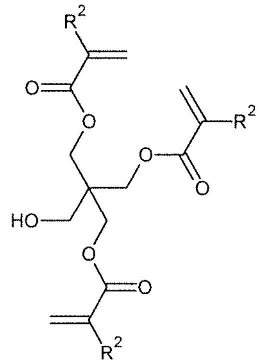

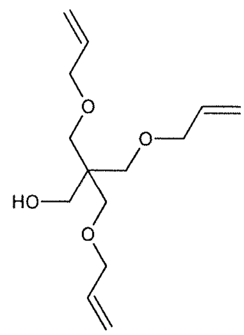

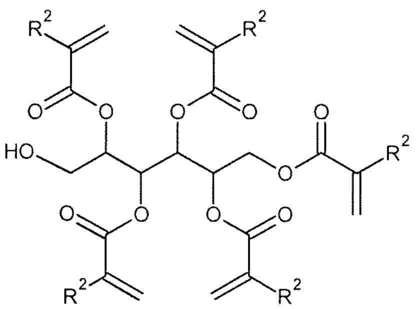

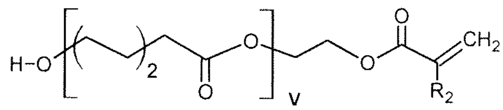

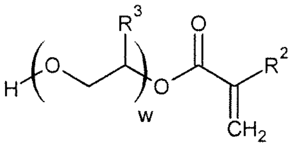 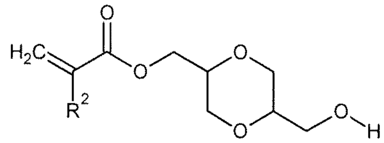

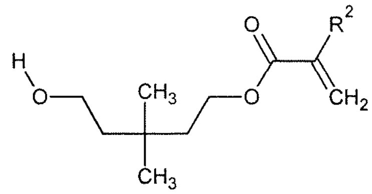 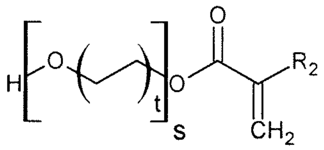

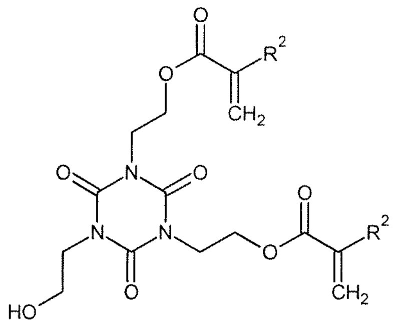 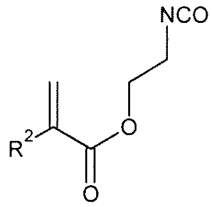 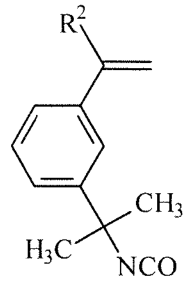

wobei jedes $R^2$ und $R^3$ unabhängig H oder $CH_3$ ist;
R gleich $C_{5-20}$-Aryl oder $C_{1-20}$-Alkyl ist;
jedes von x, y, z, t, s und w unabhängig eine ganze Zahl von 1 bis 20 sind;
v eine ganze Zahl von 1 bis 10 ist;
Aryl gleich Phenyl oder Naphthyl ist, das gegebenenfalls mit 1 bis 5 Substituenten substituiert sein kann, unabhängig ausgewählt aus $C_{1-50}$-Alkyl, Ar($C_{1-50}$)-Alkyl; Halogen; und -Si($R^z$)$_3$, wobei $R^z$ gleich $C_{1-10}$-Alkyl oder $C_{1-10}$-Alkoxy ist;
und
"Alkyl" geradkettiges oder verzweigtkettiges $C_1$-$C_{50}$-Alkyl bedeutet, das gegebenenfalls substituiert sein kann mit einer oder mehreren Gruppen, ausgewählt aus Aryl; Halogen; und -Si($R^z$)$_3$, wobei $R^z$ gleich $C_{1-10}$-Alkyl oder $C_{1-10}$-Alkoxy ist.

**11.** Der Lithographie-Druckplattenvorläufer gemäß einem der Ansprüche 1 bis 10, wobei mindestens ein Verzweigungseinheitsvorläufer der Formel (II) ausgewählt ist aus

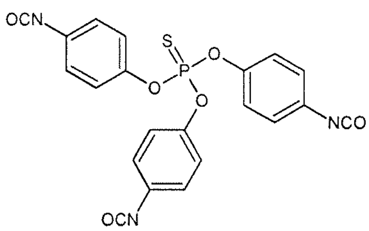 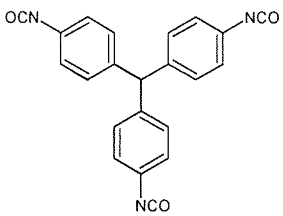 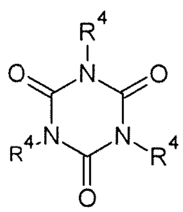 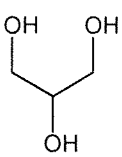

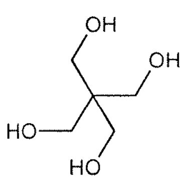 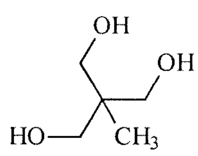 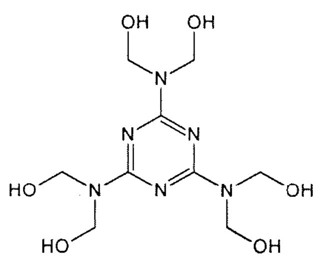

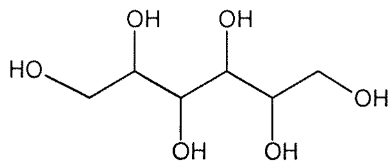

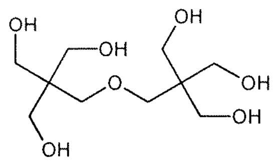

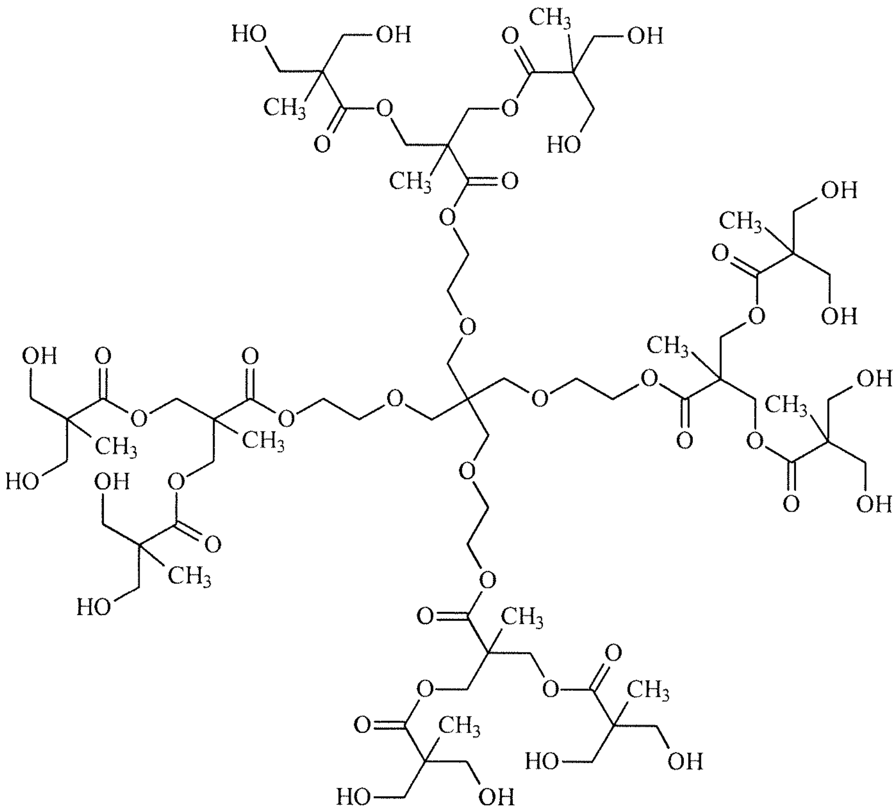

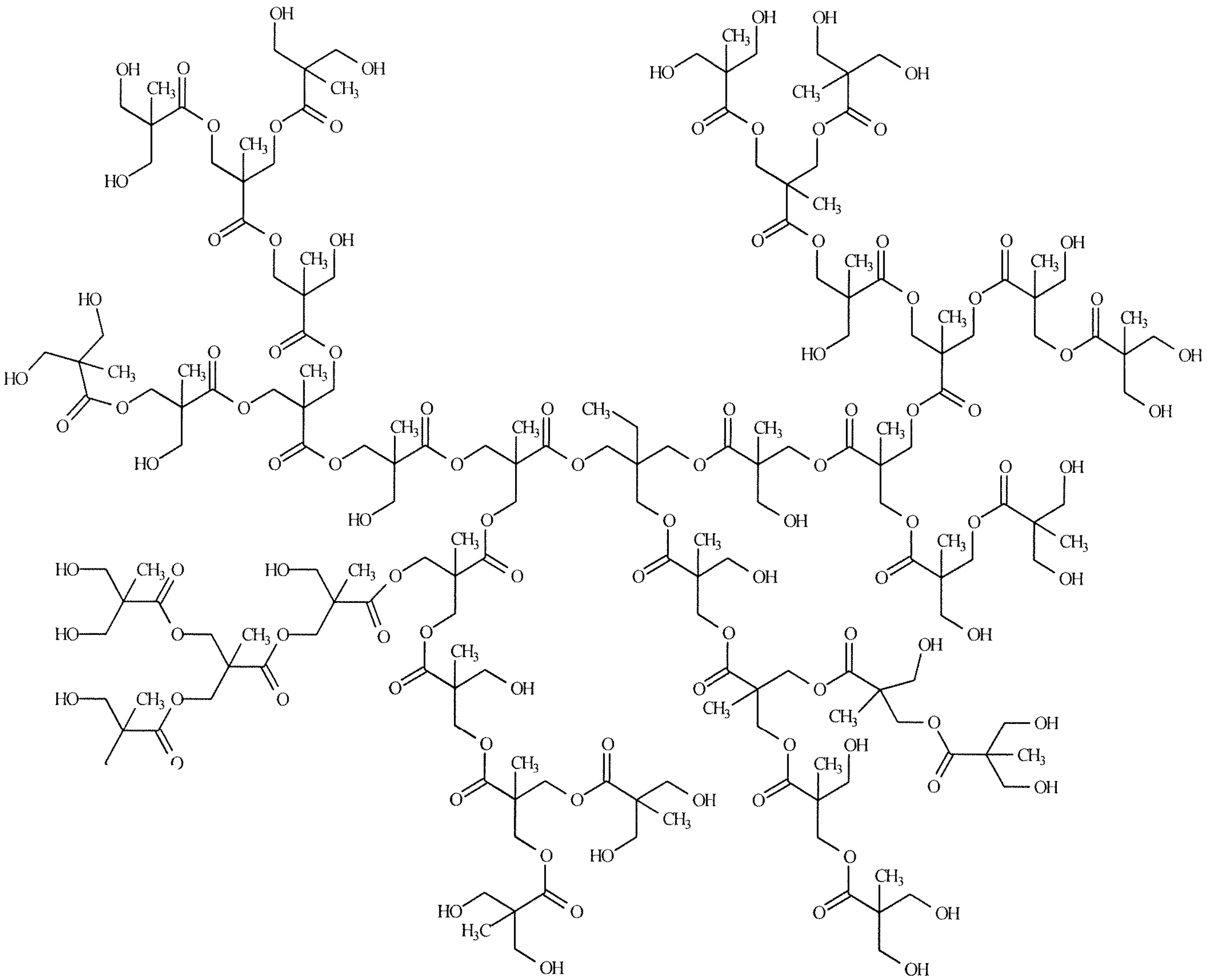

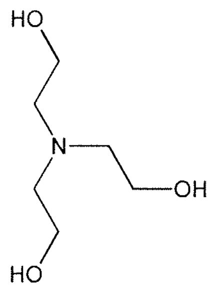

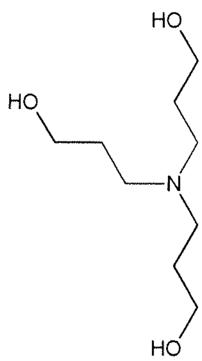

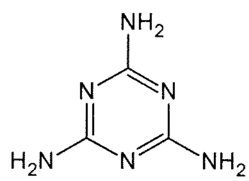

wobei jedes $R^4$ gleich $-(CH_2)_uNCO$ oder $-(CH_2)_uOH$ ist, wobei u eine ganze Zahl von 2 bis 10 ist.

**12.** Der Lithographie-Druckplattenvorläufer gemäß einem der Ansprüche 1 bis 11, wobei mindestens ein Abstandshaltereinheitsvorläufer der Formel (III) verwendet wird, der ausgewählt ist aus

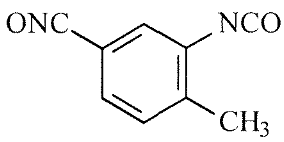 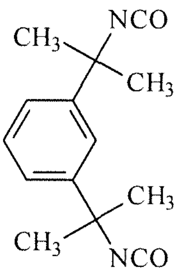 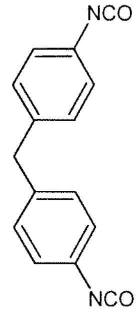 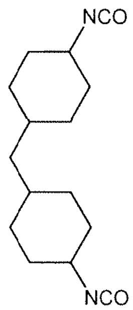

$OCN-(CH_2)_{a2}-NCO$; $OH-(CH_2)_{a3}-OH$; $OH-(CH_2CH_2-O)_{a4}-H$; $OH-(CH(CH_3)CH_2-O)_{a5}-H$; $OH-CH_2-C(CH_3)_2-CH_2-OH$

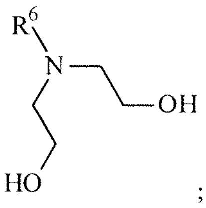 ;

$H_2N-(CH_2)_{a6}-NH_2$; $H_2N$-Aryl-$NH_2$;

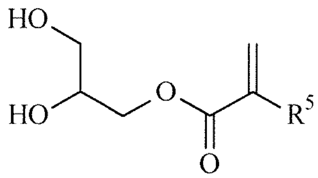

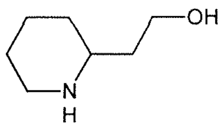

wobei a2 eine ganze Zahl von 1 bis 20 ist; a3 eine ganze Zahl von 1 bis 20 ist; a4 eine ganze Zahl von 1 bis 20 ist; a5 eine ganze Zahl von 1 bis 20 ist; a6 eine ganze Zahl von 1 bis 20 ist; $R^5$ gleich H oder $CH_3$ ist; $R^6$ gleich $C_{1-20}$-Alkyl oder $C_{5-20}$-Aryl ist,
"Aryl" Phenyl oder Naphthyl ist, das gegebenenfalls mit 1 bis 5 Substituenten, ausgewählt aus $C_{1-50}$-Alkyl, Ar$C_{1-50}$-Alkyl, Halogen und $-Si(R^z)_3$, substituiert sein kann, wobei $R^z$ gleich $C_{1-10}$-Alkyl oder $C_{1-10}$-Alkoxy ist.

**13.** Der Lithographie-Druckplattenvorläufer gemäß einem der Ansprüche 1 bis 12, wobei die radikalbildende Komponente eine Wellenlänge im Bereich von 300 bis 750 nm oder eine Wellenlänge im Bereich von über 750 bis 1200 nm absorbiert.

**14.** Ein Verfahren zur Herstellung eines bebilderten Lithographie-Druckplattenvorläufers, umfassend

(a) das bildweise Belichten eines Lithographie-Druckplattenvorläufers gemäß einem der Ansprüche 1 bis 13,
(b) Entfernen der nicht belichteten Bereiche der Beschichtung des Lithographie-Druckplattenvorläufers mit einem wässrigen Entwickler mit einem pH-Wert von 5 bis 14, wobei der Entwickler gegebenenfalls ein filmbildendes hydrophiles Polymer umfasst.

## Revendications

**1.** Précurseur de plaque d'impression lithographique à travail négatif, comprenant :

(a) un substrat,

(b) un revêtement à travail négatif sensible aux rayonnements, comprenant :

(i) 10 à 90 % en poids sur la base du poids sec du revêtement d'une matière liante ramifiée
(ii) au moins un composant formant des radicaux sélectionné parmi des photoinitiateurs et des systèmes sensibilisateurs/co-initiateurs qui absorbe une longueur d'onde dans la plage de 300 à 1200 nm et est capable d'initier une polymérisation radicalaire, et
(iii) au moins un composé ayant au moins deux groupes polymérisables par radicaux libres par molécule et un Tg < 30 °C,

(c) et éventuellement une surcouche faisant office de barrière d'oxygène ; **caractérisé en ce que** la matière liante ramifiée comprend des groupes polymérisables par radicaux, présente une masse moléculaire moyenne en nombre dans la plage de 500 à 15000, et un Tg > 30 °C, et est constituée de groupements de structure connectés entre eux par des liaisons uréthane et/ou urée, lesdits groupements de structure étant dérivés de $n_{EG}$ moles de précurseurs de groupes terminaux représentés par la formule (I), de $n_{BU}$ moles de précurseurs d'unités de ramification représentés par la formule (II), et éventuellement de $n_{SU}$ moles de précurseurs d'unités d'espacement représentés par la formule (III)

$L^1X^1$ (I)

$L^2(X^2)_n$ (II)

$L^3(X^3)_2$ (III)

où chacun de $X^1$, $X^2$ et $X^3$ est indépendamment un groupe isocyanate, ou le groupe réactif d'isocyanate identique ou différent sélectionné parmi le groupe constitué de -OH et -NHR, où R est H, alkyle en $C_{1-20}$ ou aryle en $C_{5-20}$, chacun de $L^1$, $L^2$ et $L^3$ est indépendamment un groupement aliphatique, aromatique, hétérocyclique ou hétéroaromatique éventuellement substitué avec une valence de 1, n et 2, respectivement, où n est un entier supérieur ou égal à 3 ;
et où $L^1$, $L^2$ et $L^3$ ne contiennent pas de liaisons uréthane et urée autres que des liaisons urée faisant partie de derivés d'acide cyanurique ayant le groupement de structure

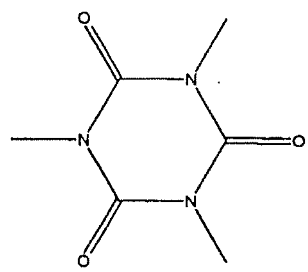

;

et où les quantités molaires $n_{EG}$, $n_{BU}$, et $n_{SU}$ répondent aux conditions suivantes,
$n_{EG} > n_{BU} > 0$ et $0 \leq n_{SU} < (n_{EG}+n_{BU})$.

**2.** Le précurseur de plaque d'impression lithographique selon la revendication 1, dans lequel la matière liante ramifiée est obtenue par l'ajout séquentiel de précurseurs de sorte que les liaisons uréthane ou urée soient formées suite un mécanisme convergent comprenant les étapes suivantes :

A) réaction simultanée ou séquentielle d'un ou de plusieurs précurseurs de groupes terminaux de formule (I) avec un précurseur d'unité de ramification de formule (II) dans un rapport molaire du précurseur de groupes terminaux au précurseur d'unités de ramification de (n-1):1 pour former le premier intermédiaire avec l'un des n groupes réactifs $X^2$ du précurseur d'unités de ramification n'ayant pas réagi, où n représente les moles de $X^2$ par molécule de précurseur d'unités de ramification selon la revendication 1 ;
B) réaction éventuelle du premier intermédiaire avec un autre précurseur d'unités de ramification de formule (II) dans un rapport molaire du premier intermédiaire à un autre précurseur d'unités de ramification (n-1):1 pour former l'intermédiaire suivant avec l'un des n groupes réactifs $X^2$ de l'autre précurseur d'unités de ramification n'ayant pas réagi, et la répétition de l'étape (B) de zéro à cinq fois afin de former un intermédiaire final ;

C) réaction du premier intermédiaire ou de l'intermédiaire final avec un précurseur de formule (I), (II) ou (III) dans un rapport molaire tel que le nombre d'équivalences des groupes réactifs d'isocyanate est supérieur ou égal au nombre d'équivalences des groupes isocyanate,

D) et éventuellement avant l'étape (A) et/ou entre les étapes (A) et (B) et/ou entre les étapes (B) et (C) et/ou entre différentes étapes (B), réaction avec des précurseurs d'unités d'espacement de formule (III) dans un rapport molaire de l'intermédiaire/du précurseur de groupes terminaux respectifs au précurseur d'unités d'espacement de 1:1 pour former l'intermédiaire suivant avec l'un des deux groupes réactifs $X^3$ du précurseur d'unités d'espacement n'ayant pas réagi, à la condition que dans chaque étape de réaction (A) à (D), un partenaire de réaction ait une fonctionnalité isocyanate et l'autre partenaire de réaction ait une fonctionnalité réactive isocyanate sélectionnée parmi -OH et -NHR, où R est alkyle en $C_{1-20}$ ou aryle en $C_{5-20}$ de sorte que des liaisons uréthane ou urée soient formées entre les partenaires de réaction.

**3.** Le précurseur de plaque d'impression lithographique selon la revendication 1 ou 2, dans lequel chacun de $L^2$ est indépendamment représenté par une formule (II-1) :

$$Z^1\text{-}[Y^1\text{-}Y^2\text{-}Y^3)]_{nx} \qquad \text{(II-1)}$$

où $Z^1$ est sélectionné parmi
$(C(R^a)_p)_{ny}$ ; $(\text{-}O)_3P{=}Y^4$ (où $Y^4$ est O ou S) ; N ;

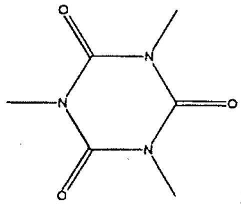 ; 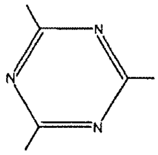

un groupe aromatique ou carbocyclique saturé de 5 à 6 chaînons ; ou un groupement polyester ramifié à base d'acide diméthylolpropionique et d'un alcool multivalent ;
$Y^1$ et $Y^2$ sont indépendamment sélectionnés parmi une liaison simple ; -O- ; -NR- où R est H, alkyle en $C_{1-20}$ ou aryle en $C_{5-20}$ ; $\text{-}((CH_2)_q\text{-}CR^aH\text{-}O)_{ny}\text{-}$ ; un groupe divalent aromatique, hétéroaromatique, hétérocyclique ou cyclique ou un groupe alkylène, chacun étant éventuellement substitué ; $\text{-}C((\text{-}CR^aH)_{nz}\text{-}^*)_2$, ou $\text{-}CR^a((\text{-}CR^aH)_{nz}\text{-}^*)$ ;
chaque $Y^3$ est indépendamment sélectionné parmi -* ; $\text{-}(CH_2\text{-}CR^aH\text{-}O)_{ny}\text{-}^*$ ; -T-* où T est un groupe divalent aromatique, hétéroaromatique, hétérocyclique ou cyclique chacun éventuellement substitué par un ou plusieurs substituants sélectionnés parmi des atomes d'halogène et alkyle en $C_{1-20}$, ou un groupe alkylène, éventuellement substitué par un ou plusieurs atomes d'halogène ; ou $\text{-}Z^2((\text{-}CR^aH)_{ny}\text{-}^*)_2$ où $Z^2$ est CH ou N ; ou $\text{-}Z^3((\text{-}CR^aH)_{ny}\text{-}^*)_3$ où $Z^3$ est C ;
chaque $R^a$ est indépendamment sélectionné parmi H ou alkyle en $C_{1-5}$ ;
où chaque nz est un entier indépendamment sélectionné de 0 à 10 ; chaque ny est un entier indépendamment sélectionné de 1 à 10 ; chaque nx est un entier d'au moins 3 qui dépend de la valence de $Z^1$ ;
p est 0 ou 1 ou 2 ; q est 0 ou un entier de 1 à 5 ;
et * désigne le site de liaison de $X^2$ ;
à la condition que $Z^1$, $Y^1$, $Y^2$ et $Y^3$ soient sélectionnés de sorte que $L^2$ de formule (II-1) ne contienne pas

(1) un atome d'oxygène directement lié à un atome d'azote ou à un autre atome d'oxygène et
(2) un atome d'azote directement lié à un autre atome d'azote.

**4.** Le précurseur de plaque d'impression lithographique selon l'une quelconque des revendications 1 à 3, dans lequel $L^1$ est représenté par une formule (I-1)

$$(\Delta\text{-}Y^5\text{-}Y^6\text{-}Y^7)_{na}\text{-}Z^4\text{-}Y^8\text{-}Y^9\text{-}Y^{10} \qquad \text{(I-1)}$$

où $Z^4$ est sélectionné parmi
C ; $(C(R^p)_p)_{ny}$ ; $(\text{-}O)_3P{=}Y^4$ (où $Y^4$ est O ou S) ; N ;

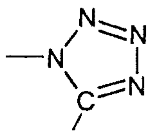 ; 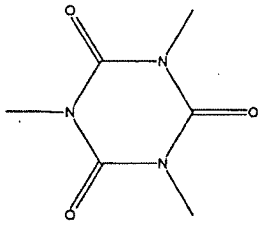 ; 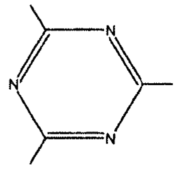 ;

un groupe hétérocyclique saturé ayant de 5 à 6 chaînons contenant 2 atomes d'oxygène ; et un groupe aromatique ou carbocyclique saturé ayant de 5 à 6 chaînons ;
$Y^5$ à $Y^9$ sont indépendamment sélectionnés parmi une liaison simple ; -O- ; -NR- où R est H, alkyle en $C_{1-20}$ ou aryle en $C_{5-20}$ ; $-SO_2-$ ; $-((CH_2)_q -CR^aH-O)_{nb}-$ ; $-(O-C(=O)-(CH2)_{nc})_{nb}-$ ; groupe divalent aromatique, hétéroaromatique, hétérocyclique ou cyclique chacun éventuellement substitué par un ou plusieurs substituants sélectionnés parmi des atomes d'halogène et alkyle en $C_{1-20}$, ou un groupe alkylène, éventuellement substitué par un ou plusieurs atomes d'halogène ;
chaque $Y^{10}$ est indépendamment sélectionné parmi -*, $-(CH_2-CR^aH-O)_{ny}-*$ ; -T-* où T est un groupe divalent aromatique, hétéroaromatique, hétérocyclique ou cyclique chacun éventuellement substitué par un ou plusieurs substituants sélectionnés parmi des atomes d'halogène et alkyle en $C_{1-20}$, ou un groupe alkylène, éventuellement substitué par un ou plusieurs atomes d'halogène ;
chaque $R^p$ est indépendamment sélectionné parmi H, alkyle en $C_{1-5}$ et $-(CH_2)_e-\Delta$ ; chaque $R^a$ est indépendamment sélectionné parmi H ou alkyle en $C_{1-5}$ ;
où chaque na est un entier indépendamment sélectionné de 1 à 10 ; chaque nb est un entier indépendamment sélectionné de 1 à 10 ; chaque nc est un entier d'au moins 2 ; chaque ny est indépendamment un entier de 1 à 20 ; e est 0 ou un entier de 1 à 10 ;
p est 0 ou 1 ou 2 ; q est 0 ou un entier de 1 à 5 ;
* désigne le site de liaison de $X^1$ ;
et $\Delta$ désigne le site de liaison du groupe fonctionnel $R^{EG}$ ou H, où $R^{EG}$ est sélectionné parmi

(i) des groupes réactifs radicalaires ayant une double liaison éthyléniquement insaturée ;
(ii) des groupes acides sélectionnés parmi -COOH, $-SO_3H$, $-PO_3H_2$, et $-PO_4H_2$, et
(iii) des groupes hydrophiles ou hydrophobes réactifs non-radicalaires et non-acides qui sont différents des groupes isocyanate, -OH et -NHR ;

à la condition que $Z^4$ et $Y^5$ à $Y^{10}$ soient sélectionnés de sorte que $L^1$ de formule (I-1) ne contienne pas

(1) un atome d'oxygène directement lié à un atome d'azote ou à un autre atome d'oxygène,
(2) un atome d'azote directement lié à un autre atome d'azote, et
(3) un atome de soufre directement lié à un autre atome de soufre.

**5.** Le précurseur de plaque d'impression lithographique selon l'une quelconque des revendications 1 à 4, dans lequel chaque $L^2$ est indépendamment représenté par une formule sélectionnée de (II-1') à (II-7') :

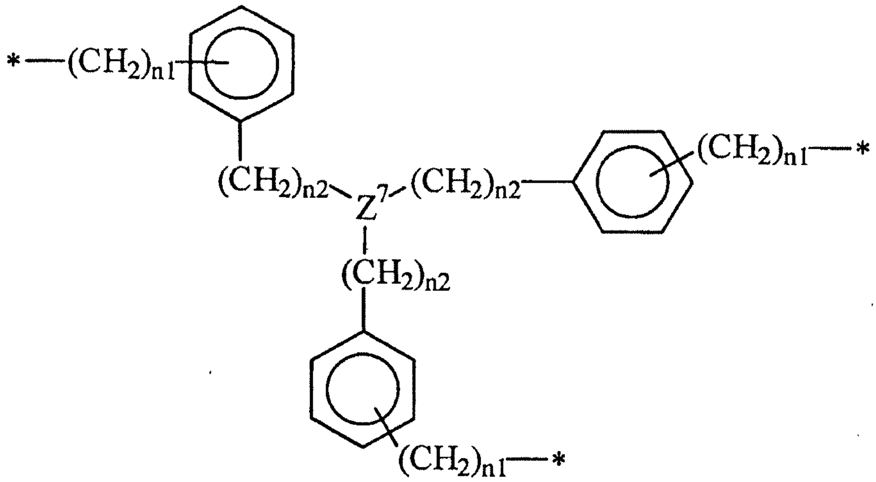

(II-1')

où $Z^7$ est $CR^4$,

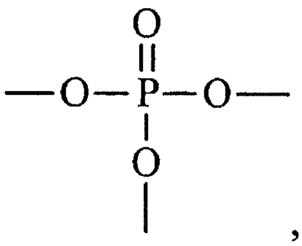

,

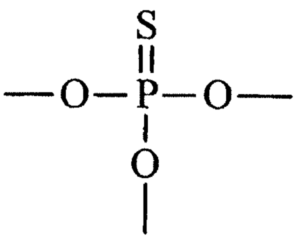

ou N,

$R^4$ est H ou alkyle en $C_1$-$C_5$; chaque n1 est indépendamment 0 ou un entier de 1 à 10 ; chaque n2 est indépendamment 0 ou un entier de 1 à 10,

et * désigne le site de liaison de $X^2$ ;

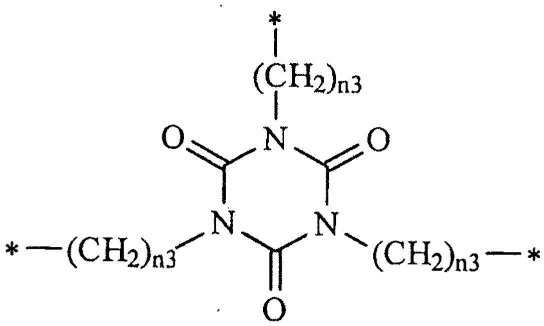

(II-2')

où chaque n3 est indépendamment un entier de 2 à 10 ;

et * désigne le site de liaison de $X^2$ ;

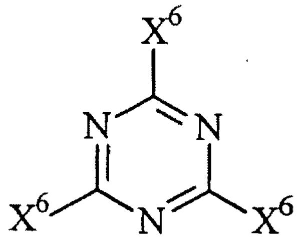

(II-3')

où chaque $X^6$ est indépendamment * ou

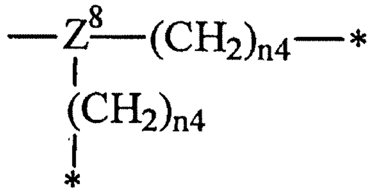

;

$Z^8$ est CH ou N ; n4 est un entier de 1 à 10 ; et * désigne le site de liaison de $X^2$ ;

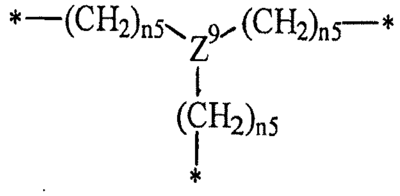

(II-4')

;

où $Z^9$ est $CR^4$ ou N ; $R^4$ est H ou alkyle en $C_1$-$C_5$ ; chaque n5 est indépendamment 0 ou un entier de 1 à 10 ; et * désigne le site de liaison de $X^2$ ;

$$(^*Y^{11})_3C[Y^{11}\text{-}O\text{-}Y^{11}\text{-}C(Y^{11*})2]_{n11}Y^{11*} \qquad \text{(II-5')}$$

où chaque $Y^{11}$ et indépendamment sélectionné parmi $-(CH_2)_{n6}-$ et $-(O\text{-}CH_2\text{-}CH_2)_{n7}$ où l'atome O est lié à l'atome C central dans la formule (II-5') ; n6 et n7 sont indépendamment 0 ou un entier de 1 à 10 ; n11 est 0, 1 ou 2 ; et * désigne le site de liaison de $X^2$ ;

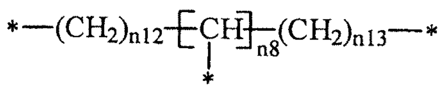

(II-6')

où n8 est un entier de 2 à 10 ; et * désigne le site de liaison de $X^2$; n12 et n13 sont des entiers de 1 à 10 ;

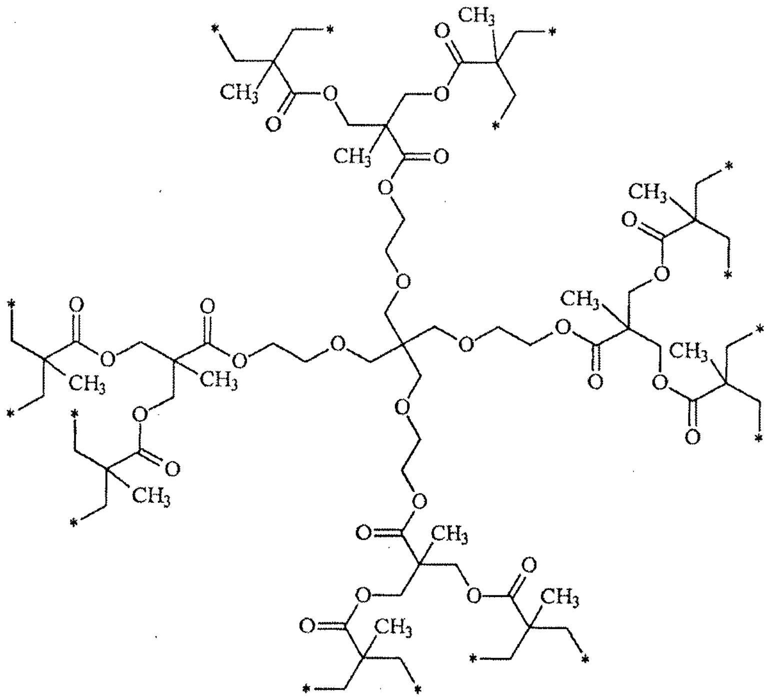

(II-7')

où * désigne le site de liaison de $X^2$.

6. Le précurseur de plaque d'impression lithographique selon l'une quelconque des revendications 1 à 5, dans lequel $L^1$ est représenté par une formule sélectionnée de (I-1') à (I-8') :

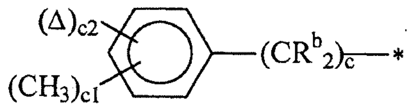

(I-1')

où c est 0 ou 1 ; chaque $R^b$ est indépendamment H ou $CH_3$ ; cl est 0 ou 1 ; c2 est un entier de 1 à 3 ;
* désigne le site de liaison de $X^1$ ;
$\Delta$ désigne le site de liaison d'un groupe fonctionnel $R^{EG}$ ou H ;

$\Delta$-$(CR^c_2)_d$-* (I-2')

où d est un entier de 1 à 20 ; chaque $R^c$ est indépendamment H ou $CH_3$ ; * désigne le site de liaison de $X^1$ ; $\Delta$ désigne le site de liaison du groupe fonctionnel $R^{EG}$ ou H ;

$\Delta$-$(CH_2)_e$-$CR^d$-$(CH_2)_e$-$\Delta$ (I-3')
|
*

où chaque e est indépendamment un entier de 1 à 10 ;
$R^d$ est H ou -$(CH_2)_e$- $\Delta$ ;
* désigne le site de liaison de $X^1$ ;
$\Delta$ désigne le site de liaison des groupes fonctionnels $R^{EG}$ ou H ;

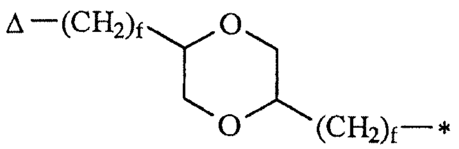

(I-4')

où chaque f est indépendamment un entier de 1 à 10 ;
* désigne le site de liaison de $X^1$ ; Δ désigne le site de liaison du groupe fonctionnel $R^{EG}$ ou H ;

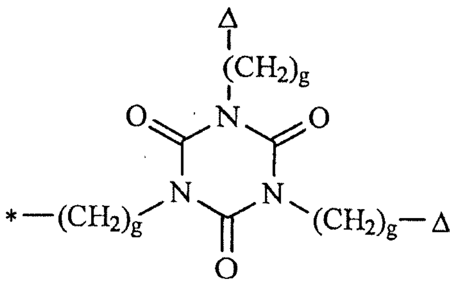

(I-5')

où chaque g est indépendamment un entier de 1 à 10 ; * désigne le site de liaison de $X^1$ ; Δ désigne le site de liaison des groupes fonctionnels $R^{EG}$ ou H ;

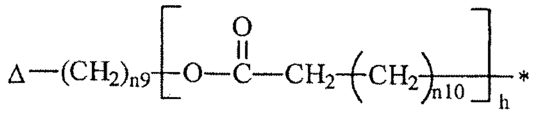

(I-6')

où h est un entier de 1 à 10 ; n9 est un entier de 1 à 10 ; n10 est un entier de 1 à 20;
* désigne le site de liaison de $X^1$ ; Δ désigne le site de liaison du groupe fonctionnel $R^{EG}$ ou H ;

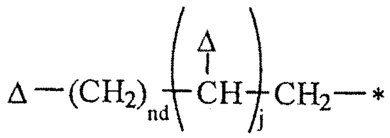

(I-7')

où j est un entier de 2 à 20 ; nd est un entier de 1 à 10 ; * désigne le site de liaison de $X^1$ ; Δ désigne le site de liaison des groupes fonctionnels $R^{EG}$ ou H ;

$R^eCR^e_2-CH_2-O)_{a1}CH_2CR^e_2-CH_2-*$ (I-8')

où a1 est un entier de 1 à 20 ; chaque $R^e$ est indépendamment H, $CH_3$ ou $-(CH_2)_{a7}-\Delta$; a7 est 0 ou un entier de 1 à 10 ;
Δ désigne le site de liaison du groupe fonctionnel $R^{EG}$ ou H ;
* désigne le site de liaison de $X^1$ ;
où dans les formules (I-1') à (I-8'), $R^{EG}$ est tel que défini selon la revendication 4.

**7.** Le précurseur de plaque d'impression lithographique selon l'une quelconque des revendications 1 à 6, dans lequel les groupes fonctionnels $R^{EG}$ dans les précurseurs de groupes terminaux de formule (I) sont sélectionnés parmi -COOH, $-Y-C(O)CR^x=CH_2$, $-(Y)_b-(CH_2)_a-CR^xCH_2$, tétrazolyle et

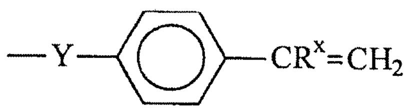

,

où Y est -O- ou $-NR^y-$ ; $R^x$ est H ou $CH_3$ ; $R^y$ est H, alkyle en $C_{1-20}$ ou aryle en $C_{5-20}$ ; a est 0 ou 1 ; et b est 0 ou 1.

**8.** Le précurseur de plaque d'impression lithographique selon l'une quelconque des revendications 1 à 7, dans lequel le liant ramifié comprend des groupements de structure dérivés de

(a) au moins un précurseur de groupes terminaux de formule (I) comprenant au moins un groupe fonctionnel $R^{EG}$ contenant une double liaison éthyléniquement insaturée et

(b) au moins un précurseur de groupes terminaux de formule (I) comprenant au moins un groupe fonctionnel $R^{EG}$ qui est sélectionné parmi -COOH, $-SO_3H$, $-PO_3H_2$ et $-PO_4H_2$, de préférence est -COOH.

**9.** Le précurseur de plaque d'impression lithographique selon l'une quelconque des revendications 1 à 8, dans lequel le précurseur d'unités de ramification de formule (II) est un triisocyanate.

**10.** Le précurseur de plaque d'impression lithographique selon l'une quelconque des revendications 1 à 9, dans lequel au moins un précurseur de groupes terminaux de formule (I) est sélectionné parmi Aryl-OH, Aryl-$CH_2$-OH, Alkyl-OH, Aryl-$NH_2$, Aryl-$CH_2$-$NH_2$, Alkyl-$NH_2$, Alkyl-NCO, Aryl-NCO, Aryl-$CH_2$-NCO, R-O-$(CH_2CH_2\text{-}O)_yH$, R-O-$(CH(CH_3)CH_2\text{-}O)_zH$,

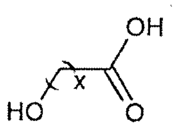
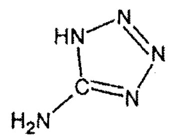
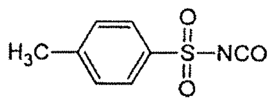
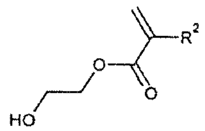

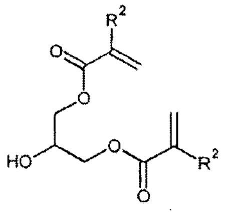
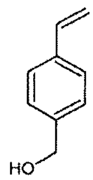
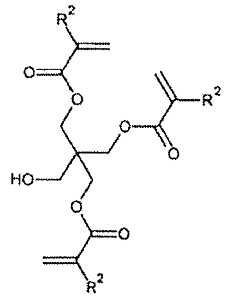
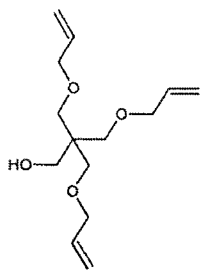

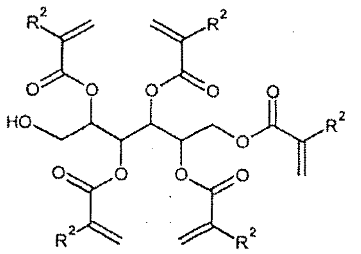
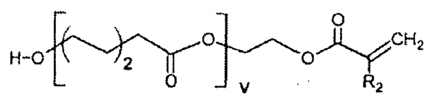

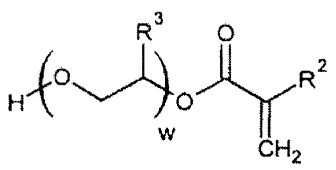
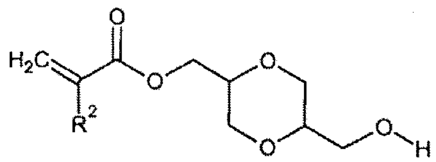

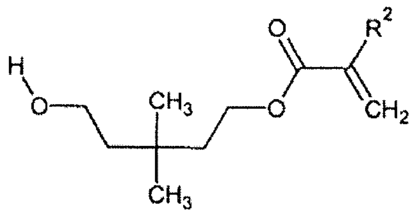
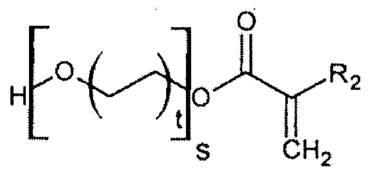

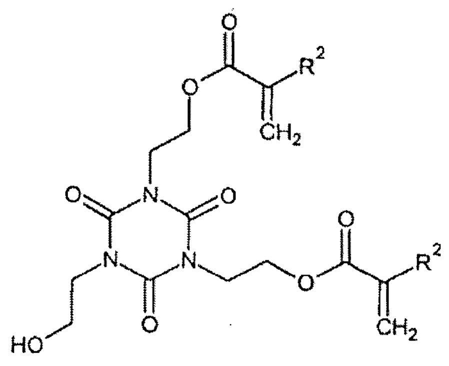 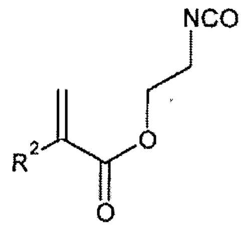 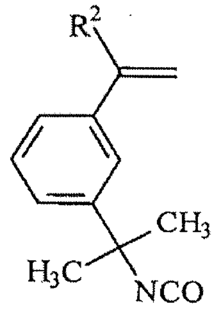

où chaque $R^2$ et $R^3$ est indépendamment H ou $CH_3$ ;
R est aryle en $C_{5-20}$ ou alkyle en $C_{1-20}$ ;
chacun de x, y, z, t, s et w est indépendamment un entier de 1 à 20 ;
v est un entier de 1 à 10 ;
Aryle est phényle ou naphtyle qui peut être éventuellement substitué avec 1 à 5 substituants indépendamment sélectionnés parmi alkyle en $C_{1-50}$ ; ar($C_{1-50}$)alkyle ; halogène ; et -Si($R^z$)$_3$ où $R^z$ est alkyle en $C_{1-10}$ ou alkoxy en $C_{1-10}$ ;
et
« Alkyle » désigne un alkyle en $C_1$-$C_{50}$ à chaîne linéaire ou ramifiée qui peut être éventuellement substitué par un ou plusieurs groupes sélectionnés parmi aryle ; halogène ; et -Si($R^z$)$_3$ où $R^z$ est alkyle en $C_{1-10}$ ou alkoxy en $C_{1-10}$.

**11.** Le précurseur de plaque d'impression lithographique selon l'une quelconque des revendications 1 à 10, dans lequel au moins un précurseur d'unités de ramification de formule (II) est sélectionné parmi

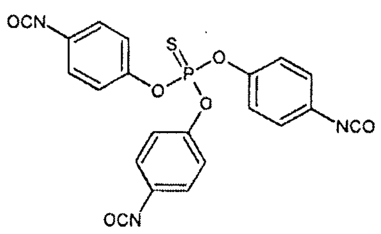 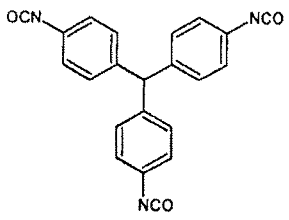 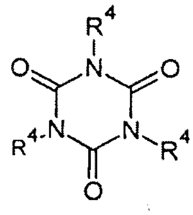 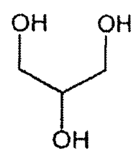

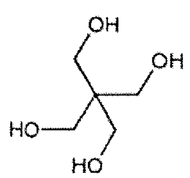 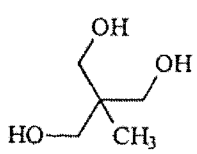 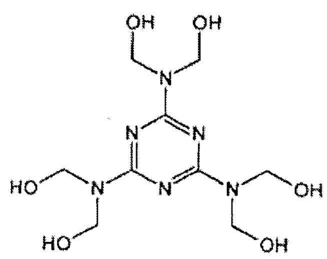

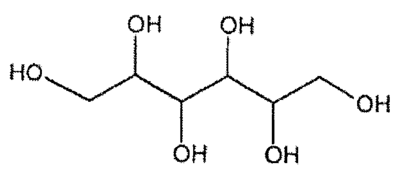 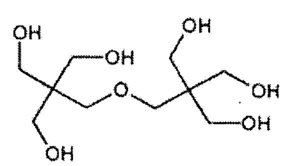

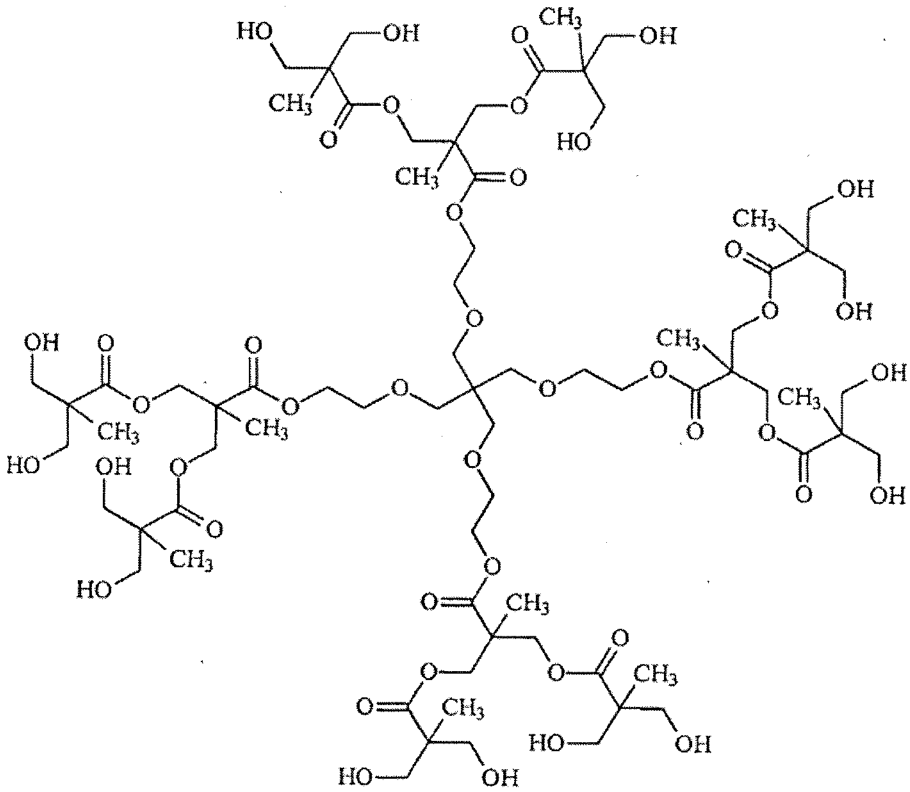

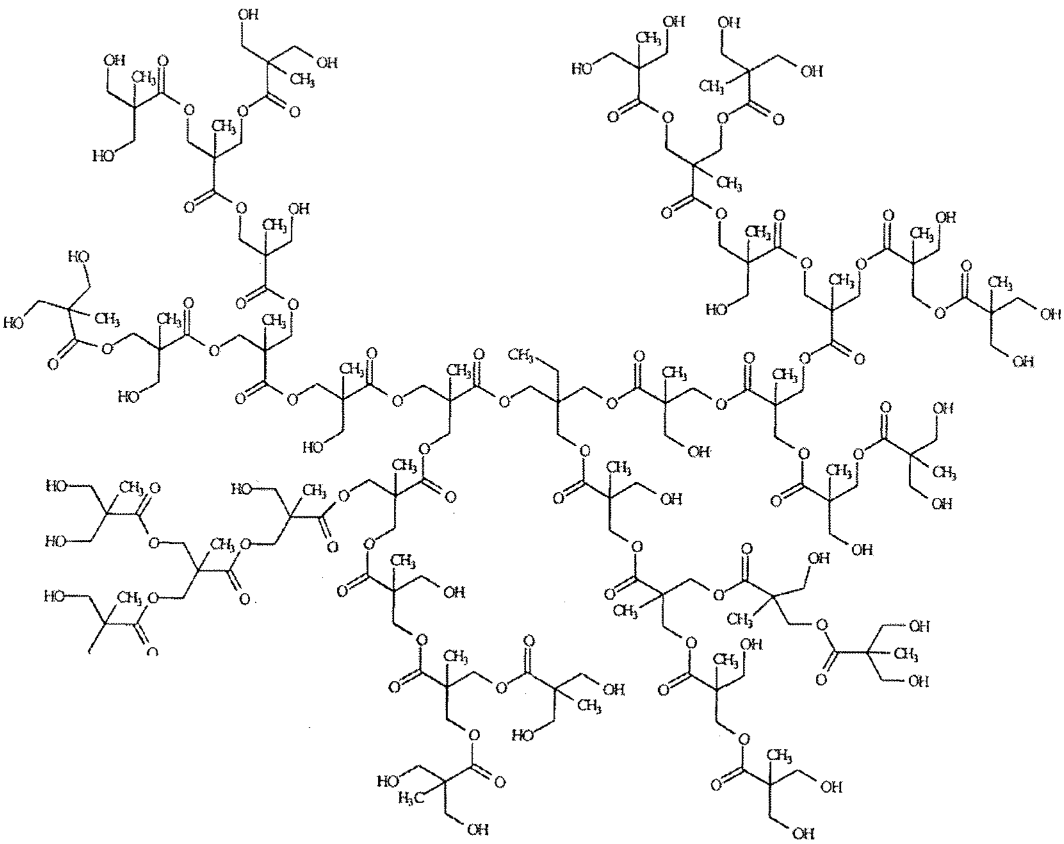

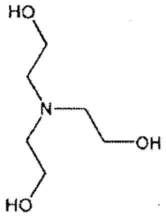 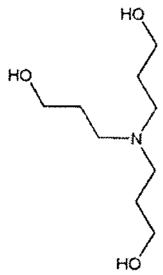 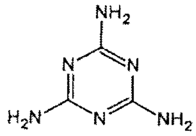

où chaque $R^4$ est $-(CH_2)_uNCO$ ou $-(CH_2)_uOH$, où u est un entier de 2 à 10.

**12.** Le précurseur de plaque d'impression lithographique selon l'une quelconque des revendications 1 à 11, dans lequel au moins un précurseur d'unités d'espacement de formule (III) est utilisé, et est sélectionné parmi

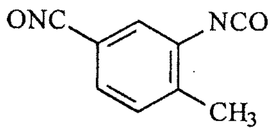 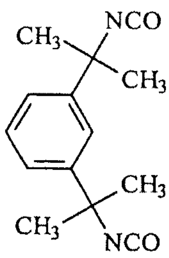 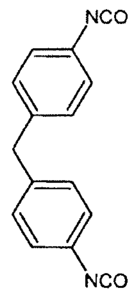 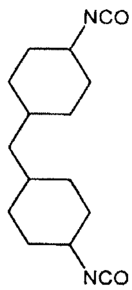

$OCN-(CH_2)_{a2}-NCO$ ; $OH-(CH_2)_{a3}-OH$; $OH-(CH_2CH_2-O)_{a4}-H$ ; $OH-(CH(CH_3)CH_2-O)_{a5}-H$ ; $OH-CH_2-C(CH_3)_2-CH_2-OH$

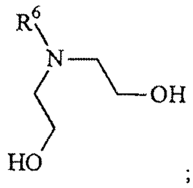

;

$H_2N-(CH_2)_{a6}$-NH2; $H_2N$-Aryl-$NH_2$;

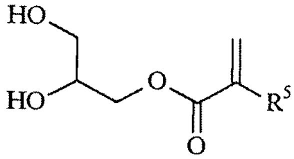

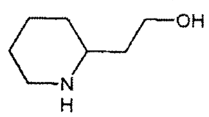

où a2 est un entier de 1 à 20 ; a3 est un entier de 1 à 20 ; a4 est un entier de 1 à 20 ; a5 est un entier de 1 à 20 ; a6 est un entier de 1 à 20 ; $R^5$ est H ou $CH_3$ ; $R^6$ est alkyle en $C_{1-20}$ ou aryle en $C_{5-20}$,
« Aryle » est phényle ou naphtyle qui peut être éventuellement substitué avec 1 à 5 substituants sélectionnés parmi alkyle en $C_{1-50}$, ar$C_{1-50}$alkyle, halogène, et $-Si(R^z)_3$, où $R^z$ est alkyle en $C_{1-10}$ ou alkoxy en $C_{1-10}$.

**13.** Le précurseur de plaque d'impression lithographique selon l'une quelconque des revendications 1 à 12, dans lequel le composant formant des radicaux absorbe des longueurs d'onde dans la plage de 300 à 750 nm ou des longueurs

d'onde dans la plage de plus de 750 à 1200 nm.

**14.** Procédé de préparation d'un précurseur de plaque d'impression lithographique contenant une image, comprenant

(a) exposer selon une image un précurseur de plaque d'impression lithographique selon l'une quelconque des revendications 1 à 13

(b) enlever les régions non-exposées du revêtement du précurseur de plaque d'impression lithographique à l'aide d'un révélateur aqueux ayant un pH de 5 à 14, dans lequel le révélateur comprend optionnellement un polymère filmogène hydrophile.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 0077070 A2
- WO 0064975 A1
- US 5418301 A
- EP 2441783 A1
- EP 1522557 A1
- US 4228232 A
- US 6187897 B1
- US 7153632 B1
- JP 2001117229 A
- JP 2005134893 A
- EP 924570 A1, Fujimaki
- EP 1063103 A1, Uesugi
- EP 1449650 A1, Goto
- US 4511645 A, Koike
- US 6027857 A, Li
- US 6309792 B, Hauck
- US 6569603 B, Furukawa
- US 6899994 B, Huang
- US 7045271 B, Tao
- US 7261998 B, Hayashi
- US 7279255 B, Tao
- US 7285372 B, Baumann
- US 7291438 B, Sakurai
- US 7326521 B, Tao
- US 7332253 B, Tao
- US 7442486 B, Baumann
- US 7452638 B, Yu
- US 7524614 B, Tao
- US 7560221 B, Timpe
- US 7574959 B, Baumann
- US 7615323 B, Strehmel
- US 20030064318 A, Huang
- US 20040265736 A, Aoshima
- US 20050266349 A, Van Damme
- US 6232038 B, Takasaki
- US 6514657 B, Sakurai
- US 20090092923 A, Hayashi
- WO 2004049068 A1
- WO 2004074929 A2
- WO 2004074930 A2
- US 6326122 B
- US 4327169 A
- US 4756993 A
- US 5156938 A
- WO 0029214 A
- US 6410207 B
- EP 1176007 A1
- US 5629354 A
- WO 2010066820 A1
- US 3445232 A
- WO 2004041544 A
- WO 200048836 A
- DE 102004003143
- EP 1969426 A
- EP 355387 A
- DE 19936331
- US 20080280229 A, Tao
- EP 1182033 A1, Fujimaki
- US 4874686 A, Urabe
- US 6916595 B, Fujimaki
- US 7041416 B, Wakata
- US 20090142695 A, Baumann
- EP 1182033 A
- US 6352812 B, Shimazu
- US 6893797 B, Munnelly
- US 7175949 B, Tao
- EP 2310909 A
- EP 2260351 A
- JP 2009086514 B
- US 7928166 B
- EP 2275258 A
- WO 9906890 A
- US 3458311 A
- US 4072527 A
- US 4072528 A
- EP 275147 A1
- EP 403096 A1
- EP 354475 A1
- EP 465034 A1
- EP 352630 A1
- EP 1172699 A
- EP 1722275 A
- EP 1344783 A
- EP 1522557 A
- EP 1969426 B1


### Non-patent literature cited in the description


- **T. HIGASHIHARA et al.** Synthesis of hyperbranched polymers with controlled degree of branching. *Polymer Journal,* 2012, vol. 44, 14-19